# EUROPEAN PATENT APPLICATION

(11) **EP 4 780 191 A1**
(43) Date of publication of application: **22.07.2026**
(21) Application number: 26152441.7
(22) Date of filing: 16.01.2026
(51) Int. Cl.: H10W 20/40, H10D 30/00, H10D 62/10, H10D 64/23, H10D 84/01, H10D 84/83, H10W 10/00, H10W 10/17

(54) **INTEGRATED CIRCUIT DEVICE**

(30) Priority: 20.01.2025 KR 20250008178
(71) Applicant: Samsung Electronics Co., Ltd., Suwon-si, Gyeonggi-do 16677 (KR)
(72) Inventor: PARK, Jaeyoung, 16677 Suwon-si (KR); JUNG, Jaebong, 16677 Suwon-si (KR); QIAN, Yubo, 16677 Suwon-si (KR)
(74) Representative: Marks & Clerk LLP

(57) **Abstract**

An integrated circuit device includes an upper sheet separation wall, a pair of nanosheet stack structures having the upper sheet separation wall therebetween, disposed spaced apart from each other, and each comprising a plurality of nanosheets, a pair of gate electrodes on the pair of nanosheet stack structures, source/drain regions connected to ends of the plurality of nanosheets included in the pair of nanosheet stack structures, a pair of backside via contacts and connected to the pair of source/drain regions, a pair of backside wiring lines connected to ends of the pair of backside via contacts, and a lower sheet separation wall between the pair of backside via contacts and the pair of backside wiring lines, and contacting the upper sheet separation wall.

## Description

### BACKGROUND

As the degree of integration of integrated circuit devices increases, the size of the device is reduced to an extreme state and the scaling of the device has reached its limit. Accordingly, in order to improve the performance of the device, a new method through structural changes of the device is needed, and integrated circuit devices including a new structure of a transistor such as a multi-gate MOSFET are proposed.

### SUMMARY

In general, the present disclosure is directed toward an integrated circuit device that includes a transistor including a multi-gate metal-oxide-semiconductor field-effect transistor (MOSFET) with improved operational reliability.

According to some implementations, the present disclosure is directed to an integrated circuit device that includes an upper sheet separation wall extending in each of a first horizontal direction and a vertical direction, a pair of nanosheet stack structures having the upper sheet separation wall therebetween, disposed to be spaced apart from each other in a second horizontal direction that is different from the first horizontal direction, and each including a plurality of nanosheets, a pair of gate electrodes extending in the second horizontal direction on the pair of nanosheet stack structures, source/drain regions connected to both ends of the plurality of nanosheets included in the pair of nanosheet stack structures in the first horizontal direction, a pair of backside via contacts adjacent to each other in the second horizontal direction and connected to the pair of source/drain regions, a pair of backside wiring lines connected to ends of the pair of backside via contacts, and a lower sheet separation wall disposed between the pair of backside via contacts adjacent to the second horizontal direction and the pair of backside wiring lines, extending in each of the first horizontal direction and the vertical direction, and contacting the upper sheet separation wall.

According to some implementations, the present disclosure is directed to an integrated circuit device that includes a plurality of nanosheet stack structures disposed in rows and columns in a first horizontal direction and a second horizontal direction that is different from the first horizontal direction, and each including a plurality of nanosheets, a plurality of source/drain regions connected to both ends of the plurality of nanosheets included in each of the plurality of nanosheet stack structures in the first horizontal direction, a plurality of gate electrodes extending in the second horizontal direction and spaced apart from each other in the first horizontal direction on the plurality of nanosheet stack structures, a plurality of upper sheet separation walls extending in each of the first horizontal direction and a vertical direction between the nanosheet stack structures adjacent in the second horizontal direction among the plurality of nanosheet stack structures and between the source/drain regions adjacent in the second horizontal direction among the plurality of source/drain regions, and spaced apart from each other in the second horizontal direction, backside via contacts connected to some of the plurality of source/drain regions, backside wiring lines connected to ends of the backside via contacts, and a plurality of lower sheet separation walls extending in each of the first horizontal direction and the vertical direction between a pair of backside via contacts adjacent in the second horizontal direction among the backside via contacts and a pair of backside wiring lines adjacent in the second horizontal direction among the backside wiring lines, overlapping the plurality of upper sheet separation walls corresponding thereto in the vertical direction, and contacting each other with their ends facing each other.

According to some implementations, the present disclosure is directed to an integrated circuit device that includes a plurality of nanosheet stack structures disposed in rows and columns in a first horizontal direction and a second horizontal direction that is different from the first horizontal direction, and each including a plurality of nanosheets, a plurality of source/drain regions connected to both ends of the plurality of nanosheets included in the plurality of nanosheet stack structures in the first horizontal direction, a plurality of gate electrodes extending in the second horizontal direction and spaced apart from each other in the first horizontal direction on the plurality of nanosheet stack structures, an interlayer insulating layer surrounding the plurality of nanosheet stack structures, the plurality of source/drain regions, and the plurality of gate electrodes, a plurality of upper sheet separation walls extending in each of the first horizontal direction and a vertical direction between the nanosheet stack structures adjacent in the second horizontal direction among the plurality of nanosheet stack structures, between the source/drain regions adjacent in the second horizontal direction among the plurality of source/drain regions, and between the gate electrodes adjacent in the second horizontal direction among the plurality of gate electrodes, and spaced apart from each other in the second horizontal direction, backside via contacts connected to some of the plurality of source/drain regions, backside wiring lines connected to ends of the backside via contacts, a plurality of lower sheet separation walls extending in each of the first horizontal direction and the vertical direction between a pair of backside via contacts adjacent in the second horizontal direction among the backside via contacts and a pair of backside wiring lines adjacent in the second horizontal direction among the backside wiring lines, overlapping the plurality of upper sheet separation walls corresponding thereto in the vertical direction, and contacting each other with their ends facing each other, a backside insulating layer surrounding the plurality of lower sheet separation walls, and a device separation layer surrounding the backside insulating layer, wherein each of the plurality of upper sheet separation walls and the plurality of lower sheet separation walls has a tapered shape with a horizontal width narrowing in the second horizontal direction from the other ends opposite to each other to ends facing each other.

According to some implementations, the present disclosure is directed to a method of operating an integrated circuit device that includes forming a plurality of nanosheet stack structures disposed in rows and columns in a first horizontal direction and a second horizontal direction that is different from the first horizontal direction on a base substrate layer having a trench filled with a device separation layer, each including a plurality of nanosheets, and a plurality of sacrificial layers respectively disposed below the plurality of nanosheets, forming a plurality of upper sheet separation walls penetrating the plurality of nanosheet stack structures and the plurality of sacrificial layers, spaced apart from each other in the second horizontal direction, extending in each of the first horizontal direction and the vertical direction, and separating each of the plurality of nanosheet stack structures into two to be spaced apart from each other in the second horizontal direction, forming a plurality of place holder structures by removing parts of the base substrate layer, forming a plurality of source/drain regions contacting the plurality of place holder structures by epitaxially growing from side surfaces of the plurality of nanosheets included in each of the plurality of nanosheets stack structures, removing the plurality of sacrificial layers, forming a plurality of gate electrodes filling space from which the plurality of sacrificial layers are removed, extending in the second horizontal direction on the plurality of nanosheet stack structures and spaced apart from each other in the first horizontal direction, forming a plurality of lower sheet separation walls penetrating the base substrate layer to be spaced apart from each other in the second horizontal direction, extending in each of the first horizontal direction and the vertical direction, overlapping the plurality of upper sheet separation walls corresponding thereto in the vertical direction, and contacting each other with their ends facing each other, removing some of the plurality of place holder structures, forming a backside insulating layer filling space from which the base substrate layer and some of the plurality of place holder structures are removed, removing a part of the backside insulating layer and the others of the plurality of place holder structures, and filling space from which the part of the backside insulating layer and the others of the plurality of place holder structures are removed, and forming backside via contacts connected to some of the plurality of source/drain regions and backside wiring lines connected to the backside via contacts.

In some implementations, the forming of the plurality of upper sheet separation walls may include forming each of the plurality of upper sheet separation walls to have a tapered shape with a horizontal width narrowing in the second horizontal direction to the base substrate layer.

In some implementations, the forming of the plurality of lower sheet separation walls may include forming each of the plurality of lower sheet separation walls to have a tapered shape with a horizontal width narrowing in the second horizontal direction to each of the plurality of upper sheet separation walls.

In some implementations, the forming of the plurality of upper sheet separation walls may include forming the plurality of upper sheet separation walls to extend into the base substrate layer.

In some implementations, the forming of the backside via contacts and the backside wiring lines may include allowing the other ends opposite to ends of the backside wiring lines facing the plurality of upper sheet separation walls to be located at the same levels as the other ends opposite to ends of the plurality of lower sheet separation walls.

In some implementations, the forming of the backside via contacts and the backside wiring lines may include forming the backside via contacts and the backside wiring lines connected to each other to be integrated.

In some implementations, heights of the plurality of lower sheet separation walls may be greater than heights of the plurality of upper sheet separation walls in the vertical direction.

In some implementations, the forming of the backside via contacts and the backside wiring lines may include forming some of the plurality of lower sheet separation walls to be disposed between a pair of backside via contacts adjacent in the second horizontal direction among the backside via contacts and between a pair of backside wiring lines adjacent in the second horizontal direction among the backside wiring lines.

In some implementations, the forming of the backside via contacts and the backside wiring lines may include forming the backside via contacts so that a part of the upper sheet separation wall and a part of the lower sheet separation wall are disposed between the backside via contacts adjacent in the second horizontal direction among the backside via contacts.

In some implementations, the forming of the plurality of gate electrodes may include allowing the other ends opposite to ends of the plurality of upper sheet separation walls to be located at the same levels as the other ends opposite to ends of the plurality of gate electrodes facing the base substrate layer.

At least some of the above and other features of the invention are set out in the claims.

### BRIEF DESCRIPTION OF THE DRAWINGS

Example implementations will be more clearly understood from the following detailed explanation, taken in conjunction with the accompanying drawings.
FIG. 1 is a layout of an example of an integrated circuit device according to some implementations.

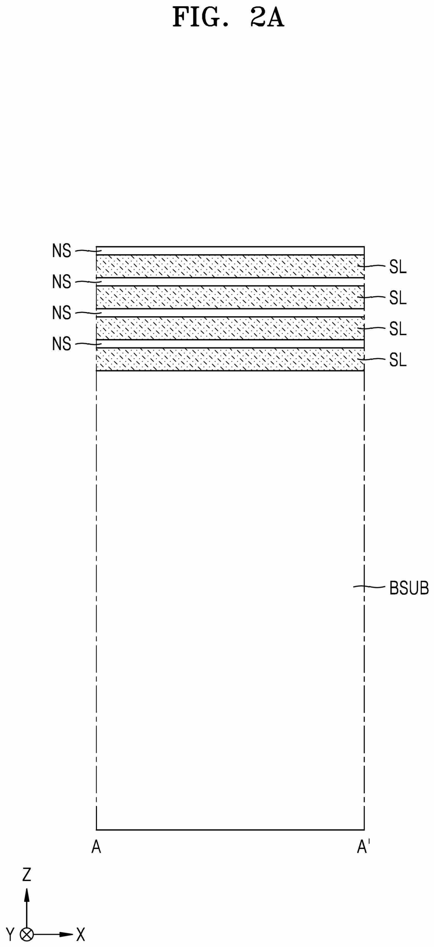

FIGS. 2A, 2B, 2C, 2D, 2E, 2F,3A, 3B, 3C, 3D, 3E, 3F,4A, 4B, 4C, 4D, 4E, 4F,5A, 5B, 5C, 5D, 5E, 5F, 6A, 6B, 6C, 6D, 6E, 6F, 7A, 7B, 7C, 7D, 7E, 7F, 8A, 8B, 8C, 8D, 8E, 8F, 9A, 9B, 9C, 9D, 9E, 9F, 10A, 10B, 10C, 10D, 10E, 10F, 11A, 11B, 11C, 11D, 11E, 11F, 12A, 12B, 12C, 12D, 12E, 12F, 13A, 13B, 13C, 13D, 13E, 13F, 14A, 14B, 14C, 14D, 14E, 14F, 15A, 15B, 15C, 15D, 15E, 15F, 16A, 16B, 16C, 16D, 16E, 16F, 17A, 17B, 17C, 17D, 17E, 17F, 18A, 18B, 18C, 18D, 18E, 18F, 19A, 19B, 19C, 19D, 19E, 19F, 20A, 20B, 20C, 20D, 20E, 20F, 21A, 21B, 21C, 21D, 21E, 21F, 22A, 22B, 22C, 22D, 22E, 22F, 23A, 23B, 23C, 23D, 23E, 23F, 24A, 24B, 24C, 24D, 24E, 24F, 25A, 25B, 25C, 25D, 25E, 25F, 26A, 26B, 26C, 26D, 26E, 26F, 27A, 27B, 27C, 27D, 27E, 27F, 28A, 28B, 28C, 28D, 28E, 28F, 29A, 29B, 29C, 29D, 29E, and 29F are vertical cross-sectional views illustrating an example of a method of manufacturing an integrated circuit device according to some implementations.
FIGS. 30A, 30B, 30C, 30D, 30E, and 30F are vertical cross-sectional views illustrating an example of an integrated circuit device according to some implementations.
FIGS. 31A and 31B are vertical cross-sectional views illustrating an example of a sheet separation wall included in integrated circuit devices according to some implementations.
FIGS. 32A and 32B are vertical cross-sectional views illustrating an example of a sheet separation wall included in integrated circuit devices according to some implementations.
FIGS. 33A, 33B, and 33C are vertical cross-sectional views illustrating an example of a sheet separation wall included in integrated circuit devices according to some implementations.

### DETAILED DESCRIPTION

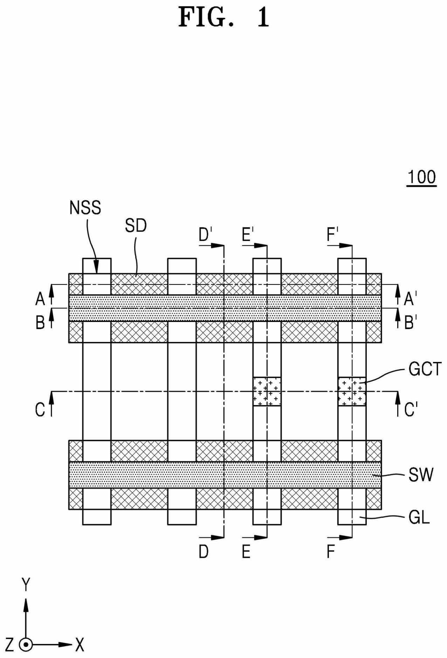

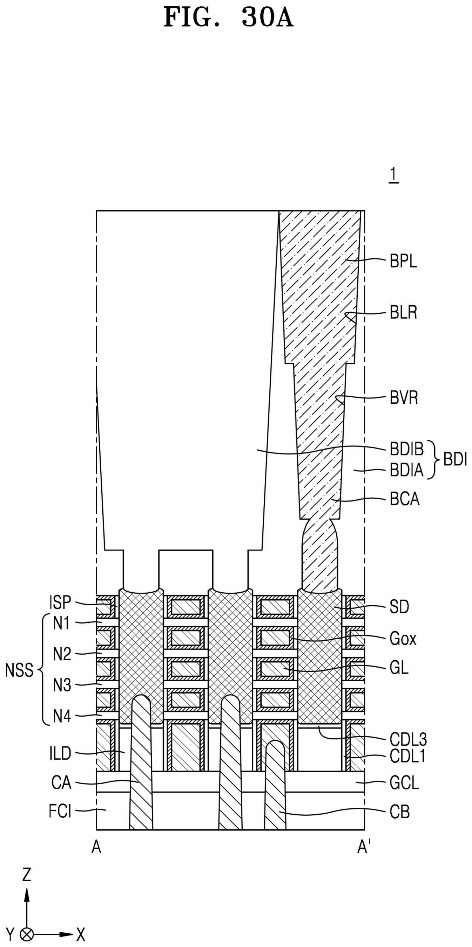

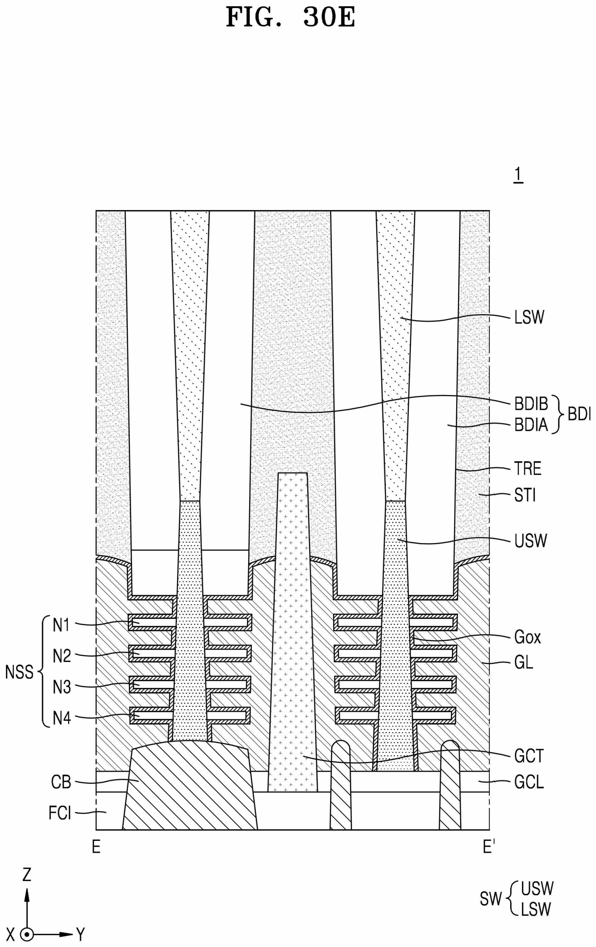

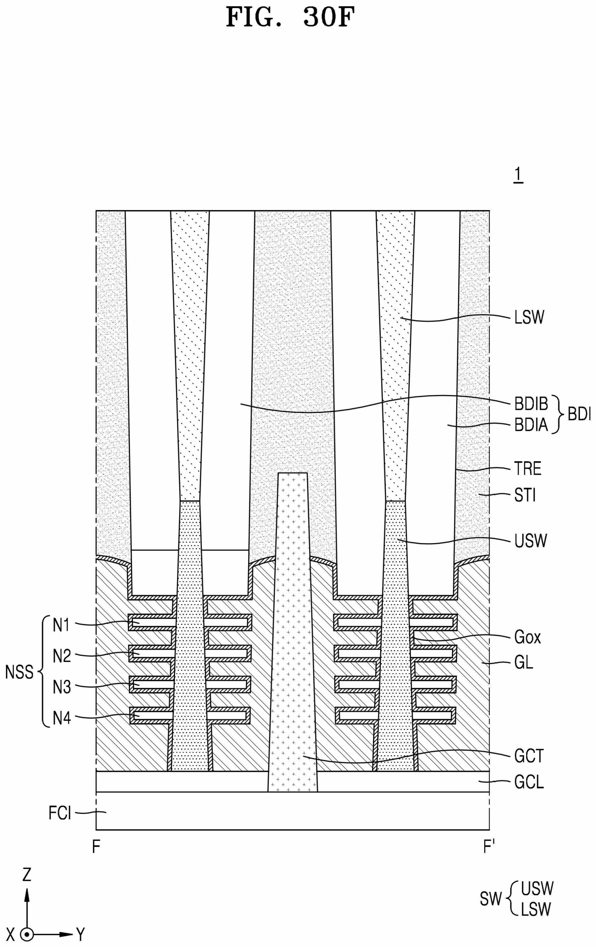

FIG. 1 is a layout of an example of an integrated circuit device 100 according to some implementations. In FIG. 1, the integrated circuit device 100 includes a plurality of sheet separation walls SW extending in a first horizontal direction (X direction), a plurality of nanosheet stack structures NSS, a plurality of gate electrodes GL extending in a second horizontal direction (Y direction), and at least one gate cut structure GCT cutting at least some of the plurality of gate electrodes GL. The first horizontal direction (X direction) and the second horizontal direction (Y direction) may be orthogonal to each other. The plurality of nanosheet stack structures NSS may include a plurality of nanosheets N1, N2, N3, and N4 (of FIGS. 30A, 30E, and 30F) stacked to be spaced apart from each other in a vertical direction (Z direction).

The integrated circuit device 100 may include a plurality of logic cells. The logic cell may include a plurality of circuit elements, such as a transistor, a resistor, etc., and may be configured in various ways. The logic cell may include, for example, an AND, a NAND, an OR, NOR, an exclusive OR (XOR), an exclusive NOR (XNOR), an inverter (INV), an adder (ADD), a buffer (BUF), a delay (DLY), a filter (FIL), a multiplexer (MXT/MXIT), an OR/AND/INVERTER (OAI), an AND/OR (AO), AND/OR/INVERTER (AOI), a D flip-flop, a reset flip-flop, a master-slave flip-flop, a latch, etc. The logic cell may include standard cells that perform logical functions.

The plurality of nanosheet stack structures NSS may be disposed in rows and columns in the first horizontal direction (X direction) and the second horizontal direction (Y direction). The plurality of nanosheet stack structures NSS may be adjacent to the plurality of sheet separation walls SW and disposed in columns in the first horizontal direction (X direction). Among the plurality of nanosheet stack structures NSS, a pair of nanosheet stack structures NSS corresponding to each other may have the sheet separation wall SW disposed therebetween and be disposed to be spaced apart from each other in the second horizontal direction (Y direction). The plurality of nanosheet stack structures NSS may overlap the plurality of gate electrodes GL in the vertical direction (Z direction).

The gate electrodes GL are separated into two by the gate cut structure GCT and may have the gate cut structure GCT disposed therebetween and be spaced apart from each other in the second horizontal direction (Y direction).

FIGS. 2A, 2B, 2C, 2D, 2E, 2F,3A, 3B, 3C, 3D, 3E, 3F, 4A, 4B, 4C, 4D, 4E, 4F, 5A, 5B, *5C**,* 5D, 5E, 5F, 6A, 6B, 6C, 6D, 6E, 6F, 7A, 7B, 7C, 7D, 7E, 7F, 8A, 8B, 8C, 8D, 8E, 8F, 9A, 9B, 9C, 9D, 9E, 9F, 10A, 10B, 10C, 10D, 10E, 10F, 11A, 11B, 11C, 11D, 11E, 11F, 12A, 12B, 12C, 12D, 12E, 12F, 13A, 13B, 13C, 13D, 13E, 13F, 14A, 14B, 14C, 14D, 14E, 14F, 15A, 15B, 15C, 15D, 15E, 15F, 16A, 16B, 16C, 16D, 16E, 16F, 17A, 17B, 17C, 17D, 17E, 17F, 18A, 18B, 18C, 18D, 18E, 18F, 19A, 19B, 19C, 19D, 19E, 19F, 20A, 20B, 20C, 20D, 20E, 20F, 21A, 21B, 21C, 21D, 21E, 21F, 22A, 22B, 22C, 22D, 22E, 22F, 23A, 23B, 23C, 23D, 23E, 23F, 24A, 24B, 24C, 24D, 24E, 24F, 25A, 25B, 25C, 25D, 25E, 25F, 26A, 26B, 26C, 26D, 26E, 26F, 27A, 27B, 27C, 27D, 27E, 27F, 28A, 28B, 28C, 28D, 28E, 28F, 29A, 29B, 29C, 29D, 29E, and 29F are vertical cross-sectional views illustrating an example of a method of manufacturing an integrated circuit device, according to some implementations.

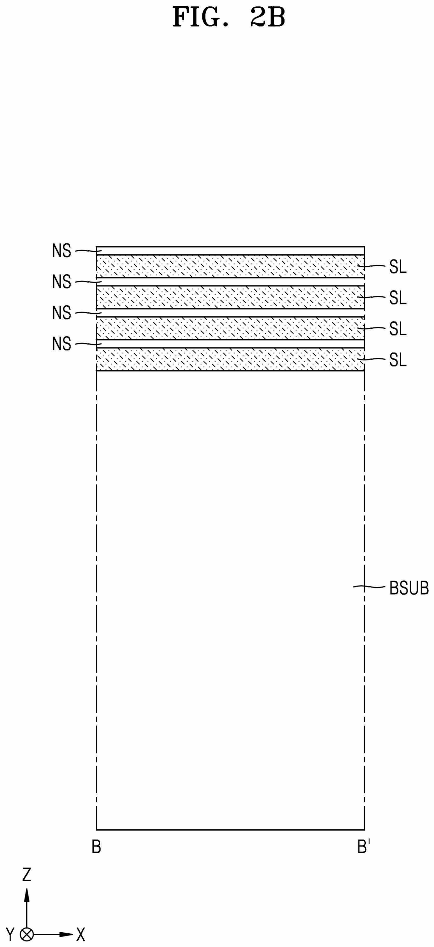

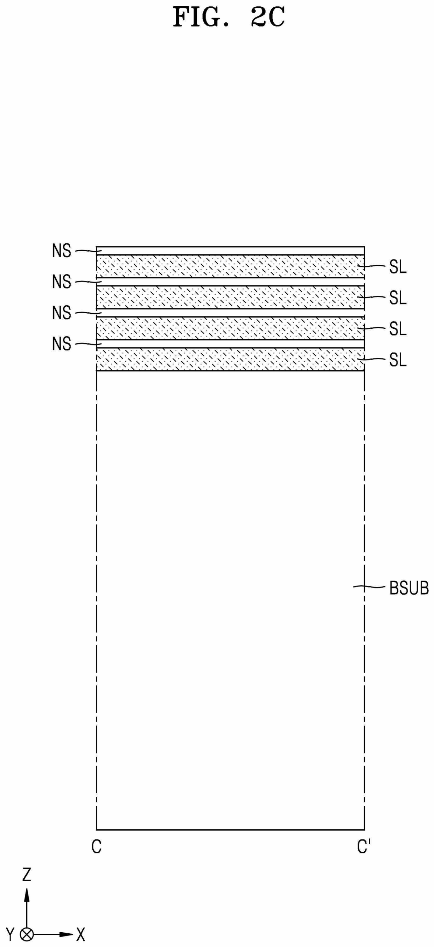

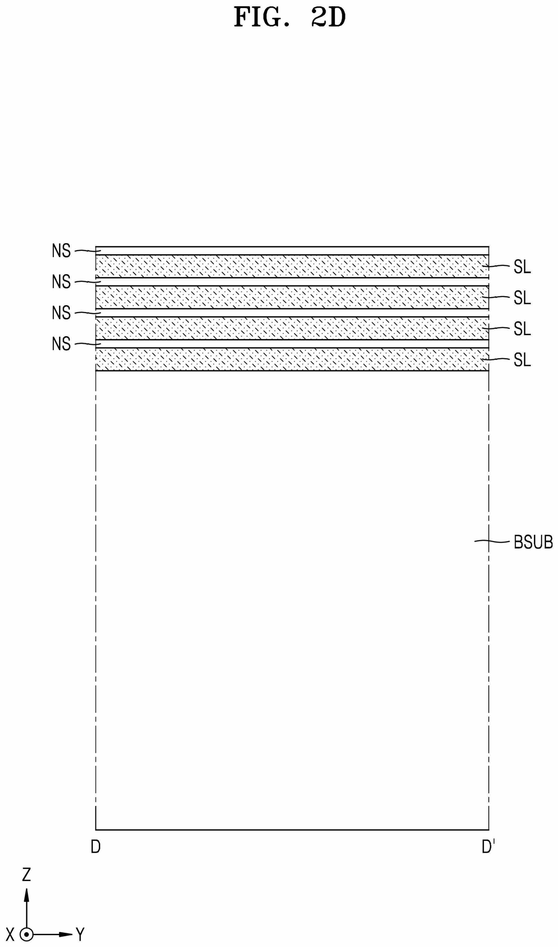

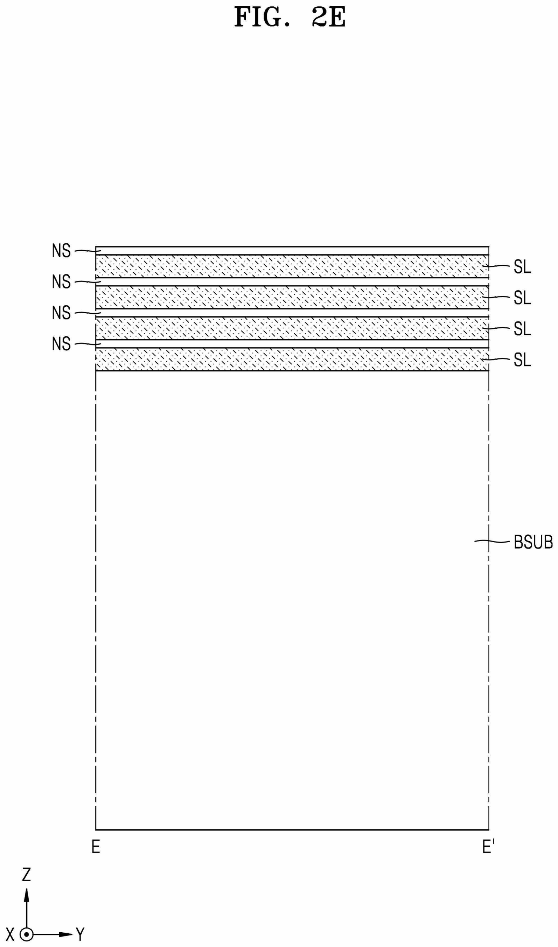

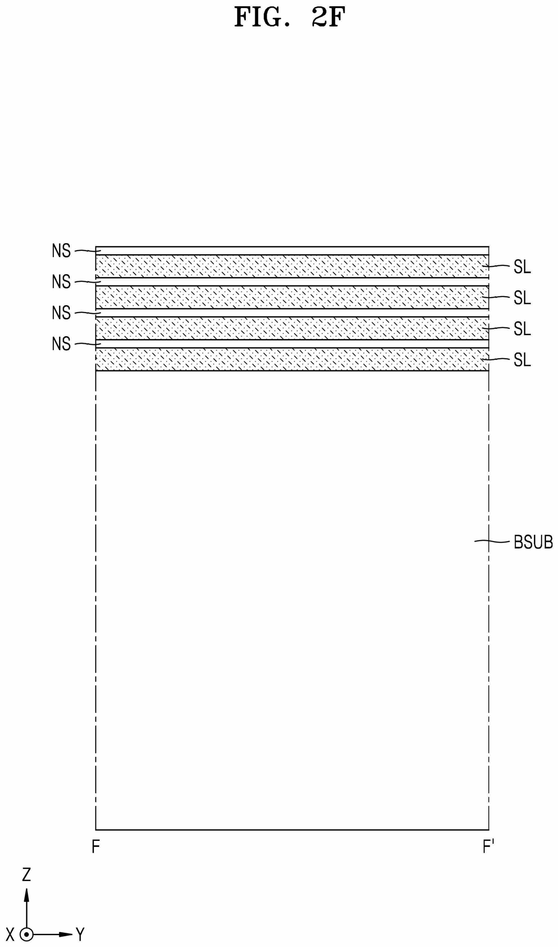

In FIGS. 2A, 2B, 2C, 2D, 2E, and 2F, a plurality of sacrificial layers SL and a plurality of nanosheet semiconductor layers NS are alternately stacked layer by layer on a base substrate layer BSUB. Each of the plurality of sacrificial layers SL and the plurality of nanosheet semiconductor layers NS may extend parallel to an upper surface of the base substrate layer BSUB. In FIGS. 2A, 2B, 2C, 2D, 2E, and 2F, four nanosheet semiconductor layers NS are stacked on the base substrate layer BSUB, but the present disclosure is not limited thereto. For example, two nanosheet semiconductor layers NS, three nanosheet semiconductor layers NS, or five or more nanosheet semiconductor layers NS may be stacked on the base substrate layer BSUB. In FIGS. 2A, 2B, 2C, 2D, 2E, and 2F, the number of nanosheet semiconductor layers NS is the same as the number of sacrificial layers SL that are stacked on the base substrate layer BSUB, but the present disclosure is not limited thereto. For example, the number of sacrificial layers SL stacked on the base substrate layer BSUB may be one less or one more than the number of nanosheet semiconductor layers NS stacked on the base substrate layer BSUB.

In some implementations, the lowermost nanosheet semiconductor layer NS among the plurality of nanosheet semiconductor layers NS may be formed thinner or thicker than each of the remaining nanosheet semiconductor layers NS. The base substrate layer BSUB may include a semiconductor material, such as silicon (Si) or germanium (Ge), or a compound semiconductor material, such as silicon germanium (SiGe), silicon carbide (SiC), gallium arsenide (GaAs), indium arsenide (InAs), or indium phosphide (InP). In some implementations, the base substrate layer BSUB may include at least one of a group III-V material or a group IV material. The group III-V material may be a binary, ternary, or quaternary compound semiconductor material including at least one group III element and at least one group V element. The base substrate layer BSUB may include a conductive region, for example, an impurity-doped well or an impurity-doped structure.

In some implementations, the plurality of nanosheet semiconductor layers NS may include materials having the same or similar etching characteristics as or to that of the material of the base substrate layer BSUB. The plurality of sacrificial layers SL may include a material having etch selectivity with each of the base substrate layer BSUB and the plurality of nanosheet semiconductor layers NS. In some implementations, each of the base substrate layer BSUB and the plurality of nanosheet semiconductor layers NS may include a semiconductor material such as Si or Ge. In some implementations, the plurality of sacrificial layers SL may include a compound semiconductor such as SiGe.

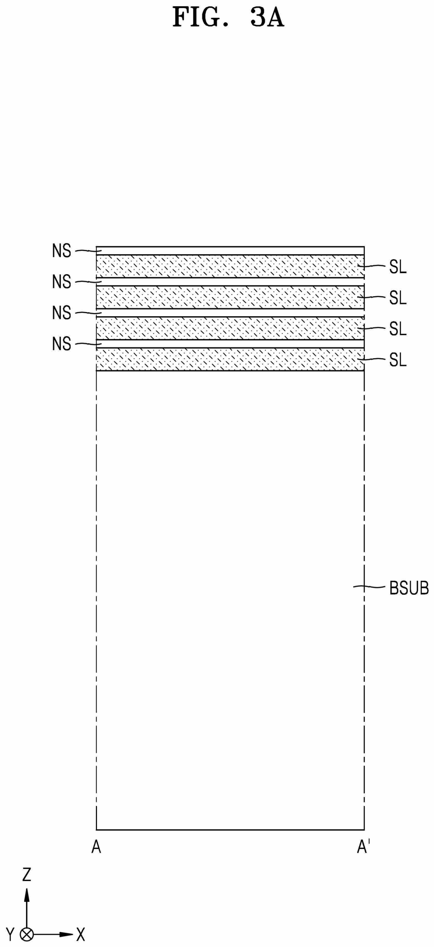

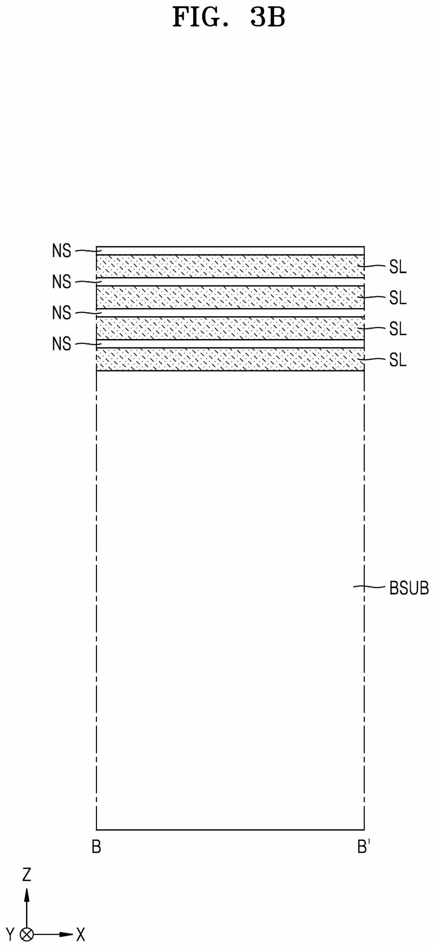

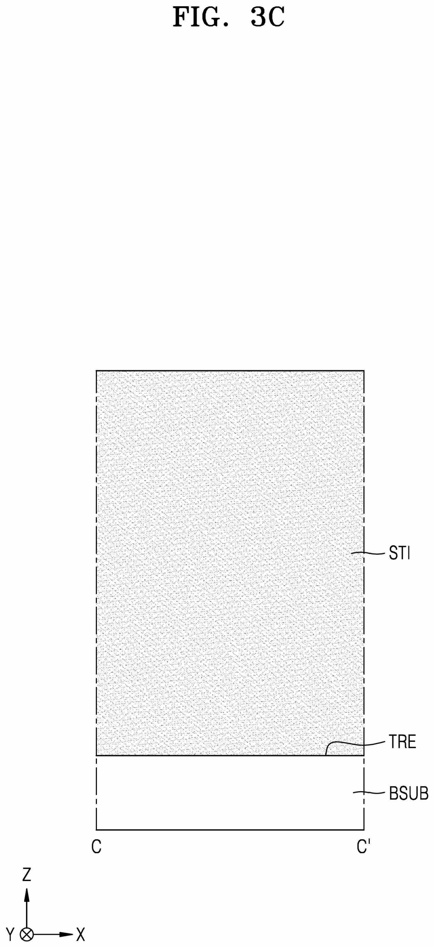

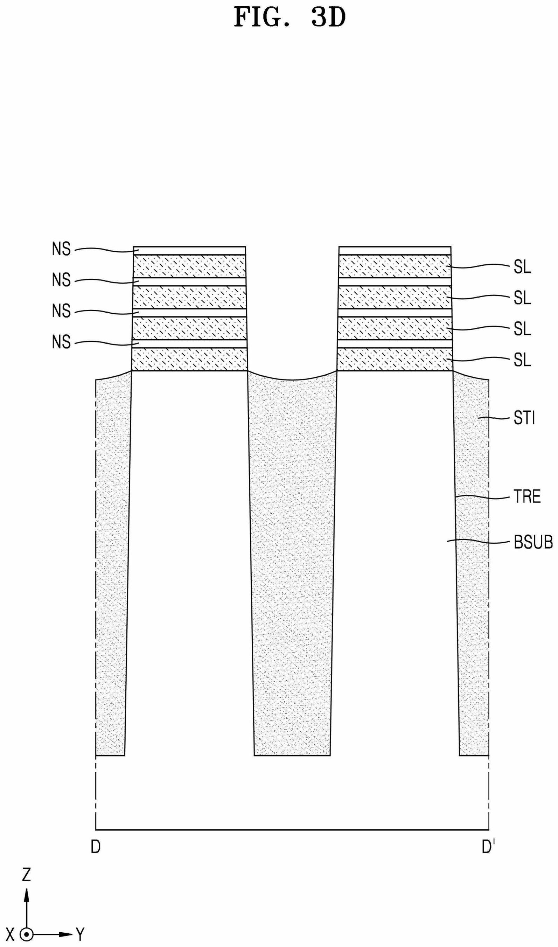

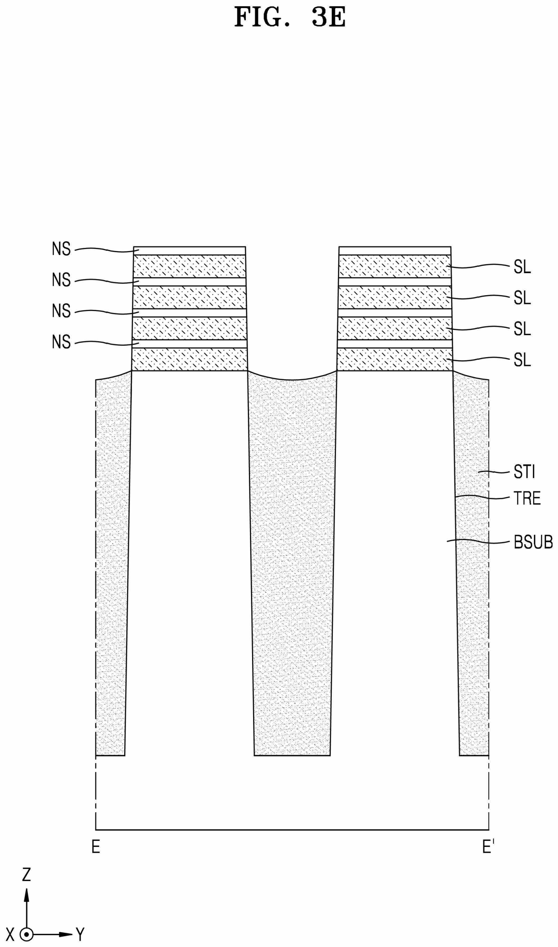

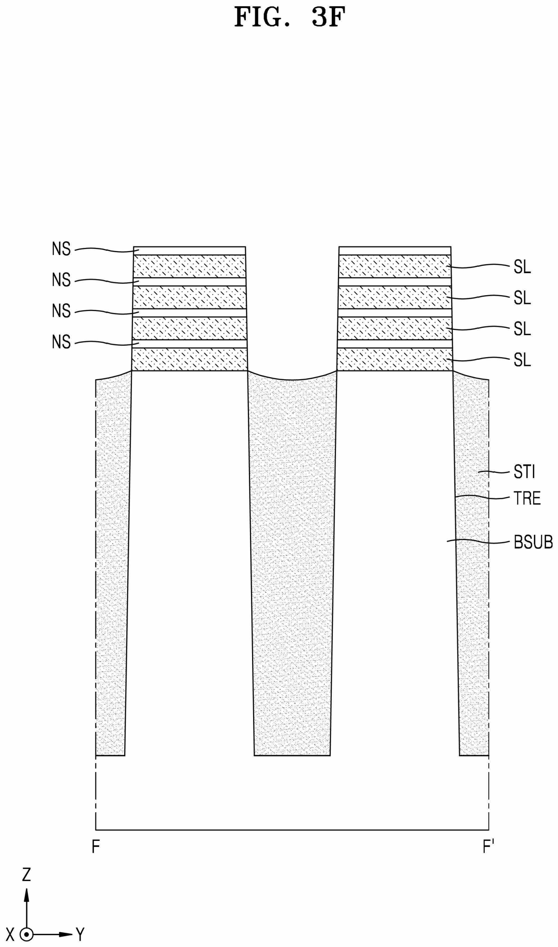

In FIGS. 3A, 3B, 3C, 3D, 3E, and 3F, a plurality of trenches TRE are formed by patterning the plurality of nanosheet semiconductor layers NS and the plurality of sacrificial layers SL, and removing a part of the base substrate layer BSUB exposed between patterned results. The plurality of patterned nanosheet semiconductor layers NS and the plurality of patterned sacrificial layers SL may extend in the first horizontal direction (X direction) and may be spaced apart from each other in the second horizontal direction (Y direction).

A plurality of device separation layers STI filling the plurality of trenches TRE are formed. In some implementations, the device separation layer STI may be formed such that an upper surface of the device separation layer STI is at a vertical level equal to or higher than an upper surface of the base substrate layer BSUB, but is at a vertical level lower than an upper surface of the lowermost nanosheet semiconductor layer NS among the plurality of nanosheet semiconductor layers NS. The device separation layer STI may be formed by forming a preliminary device separation layer filling the trench TRE and then performing a recess process for removing the preliminary device separation layer from an upper part thereof by a partial thickness. For example, the device separation layer STI may include silicon oxide, silicon nitride, silicon oxynitride, or a combination thereof. For example, the device separation layer STI may include a material including at least one of silicon oxide, silicon nitride, or silicon oxynitride. The device separation layer STI may be configured as a single layer including one type of insulating layer, a double layer including two types of insulating layers, or a multilayer including a combination of at least three types of insulating layers. For example, the device separation layer STI may include two different types of insulating layers. For example, the device separation layer STI may include a silicon oxide layer and a silicon nitride layer. For example, the device separation layer STI may include a triple layer including a silicon oxide layer, a silicon nitride layer, and a silicon oxide layer.

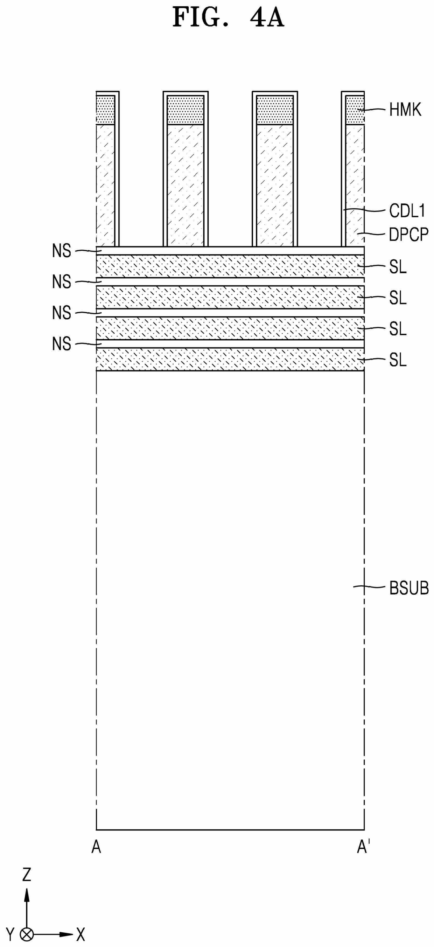

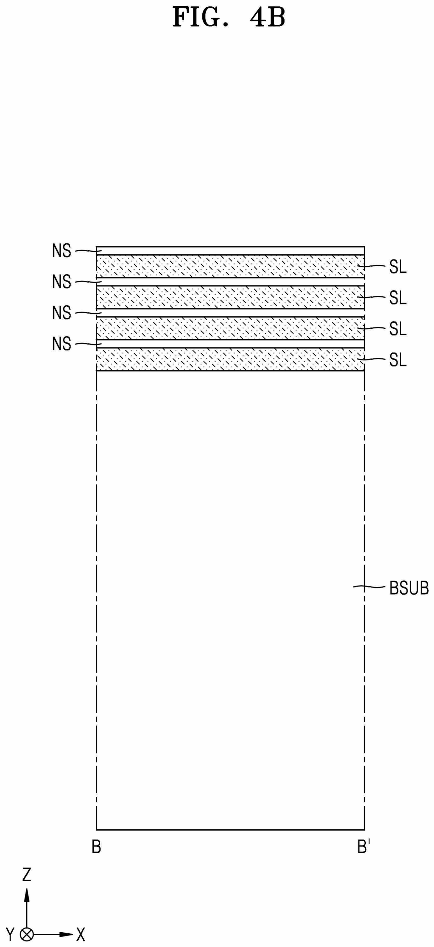

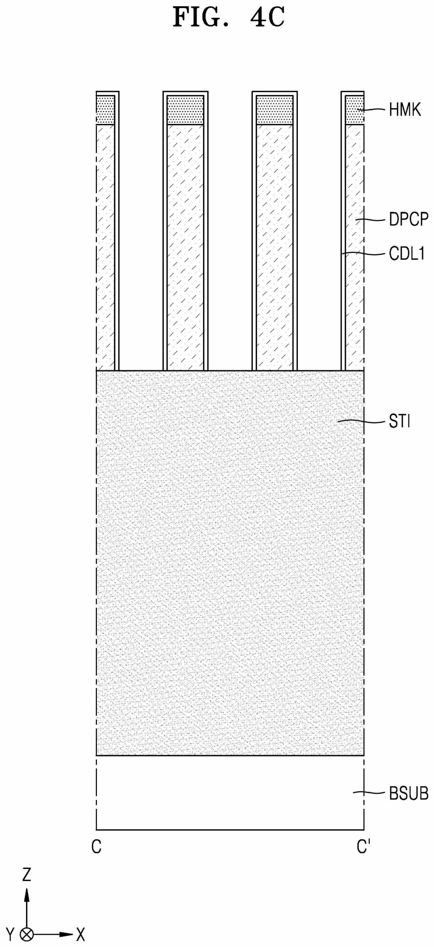

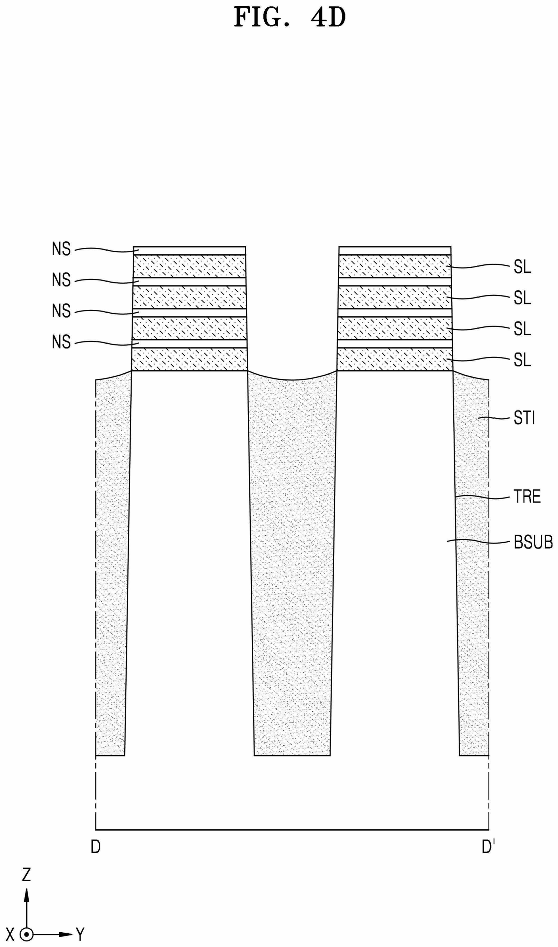

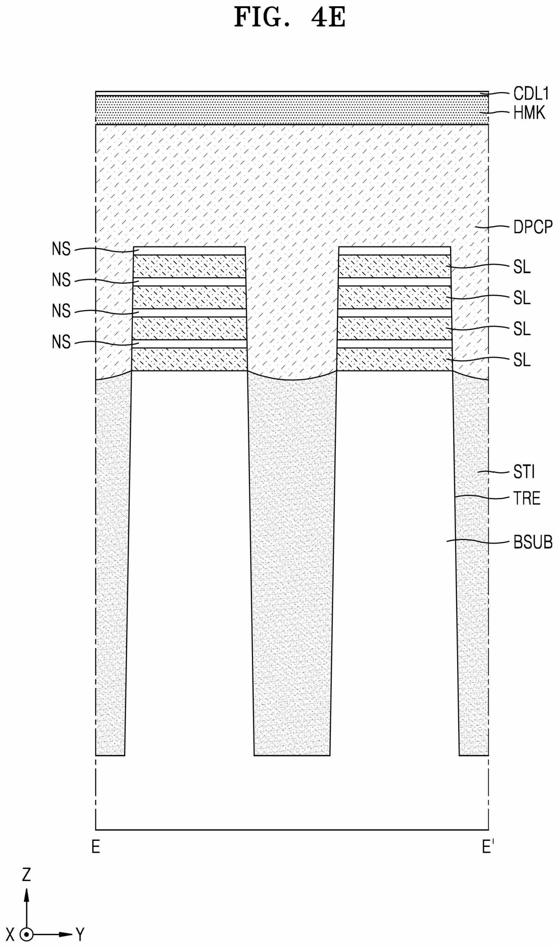

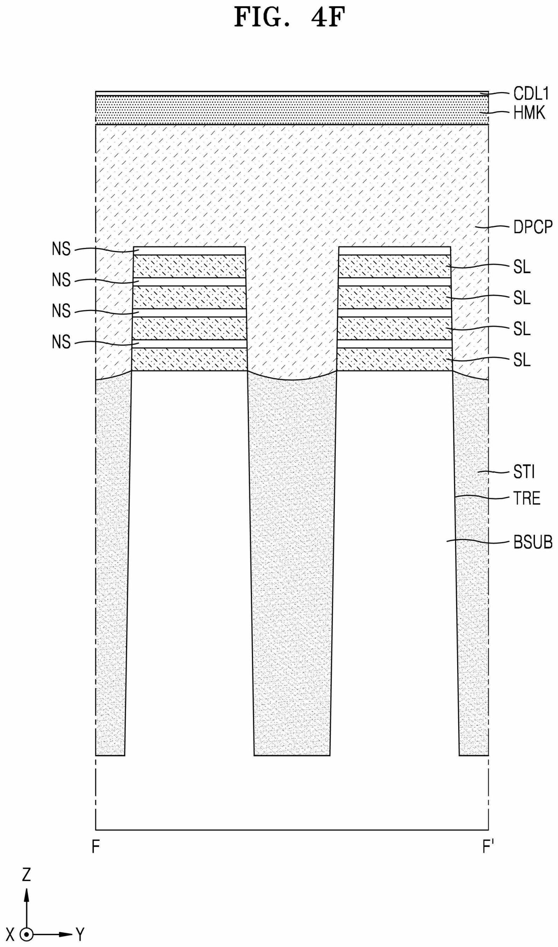

In FIGS. 4A, 4B, 4C, 4D, 4E, and 4F, a plurality of dummy gate electrodes DPCP and a plurality of hard mask patterns HMK are formed on the plurality of nanosheet semiconductor layers NS, the plurality of sacrificial layers SL, and the plurality of device separation layers STI. Each of the dummy gate electrode DPCP and the hard mask pattern HMK may be formed by an atomic layer deposition (ALD) process, a chemical vapor deposition (CVD) process, a physical vapor deposition (PVD) process, a metal organic ALD (MOALD) process, or a metal organic CVD (MOCVD) process. For example, the dummy gate electrode DPCP may include polysilicon, but is not limited thereto. Each of the plurality of hardmask patterns HMK may include nitride. For example, each of the plurality of hard mask patterns HMK may include silicon nitride. The plurality of dummy gate electrodes DPCP may extend in the second horizontal direction (Y direction) and be formed to be spaced apart from each other in the first horizontal direction (X direction). The plurality of hardmask patterns HMK may be formed to cover the plurality of dummy gate electrodes DPCP. The plurality of hardmask patterns HMK may extend in the second horizontal direction (Y direction) on the plurality of dummy gate electrodes DPCP and be formed to be spaced apart from each other in the first horizontal direction (X direction). The dummy gate electrode DPCP may be formed by forming a dummy gate material layer on the plurality of nanosheet semiconductor layers NS, the plurality of sacrificial layers SL, and the plurality of device separation layers STI, forming the plurality of hardmask patterns HMK on the dummy gate material layer, and then patterning the dummy gate material layer by using the plurality of hardmask patterns HMK as an etching mask.

After the plurality of dummy gate electrodes DPCP and the plurality of hardmask patterns HMK are formed, a first insulating layer CDL1 covering the plurality of dummy gate electrodes DPCP and the plurality of hardmask patterns HMK may be formed. For example, the first insulating layer CDL1 may include silicon nitride (SiN), silicon oxynitride (SiON), silicon carbonitride (SiCN), silicon oxycarbonitride (SiOCN), or a combination thereof. The first insulating layer CDL1 may be formed to conformally cover side surfaces of a stack structure of the plurality of dummy gate electrodes DPCP and the plurality of hardmask patterns HMK. In FIGS. 4A, 4C, 4E, and 4F, the first insulating layer CDL1 covers upper surfaces of the plurality of hardmask patterns HMK, but the present disclosure is not limited thereto. For example, the first insulating layer CDL1 may be formed to conformally cover the side surfaces of the stack structure of the plurality of dummy gate electrodes DPCP and the plurality of hardmask patterns HMK, but not to cover the upper surfaces of the plurality of hardmask patterns HMK.

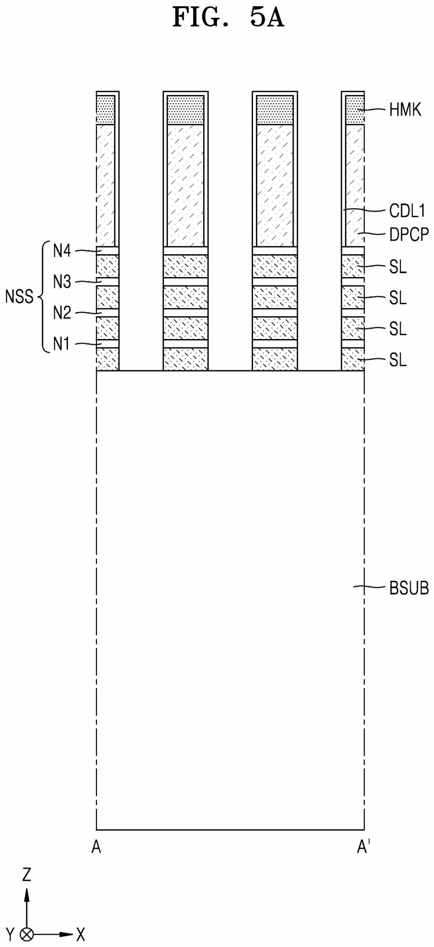

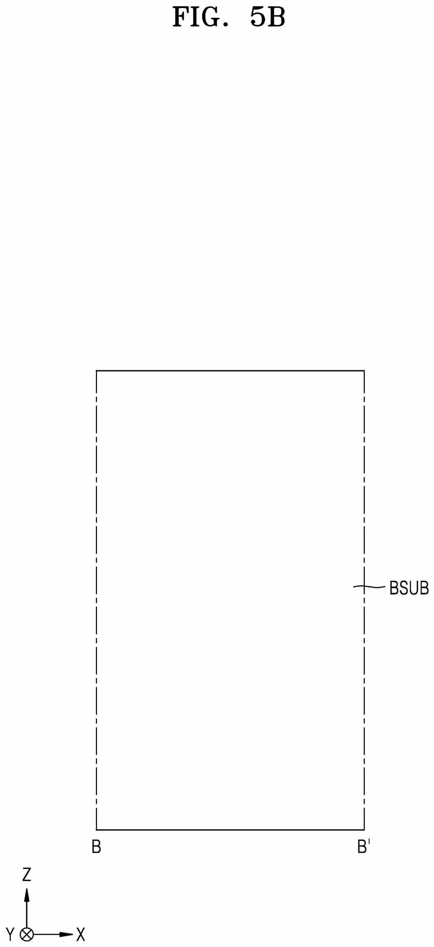

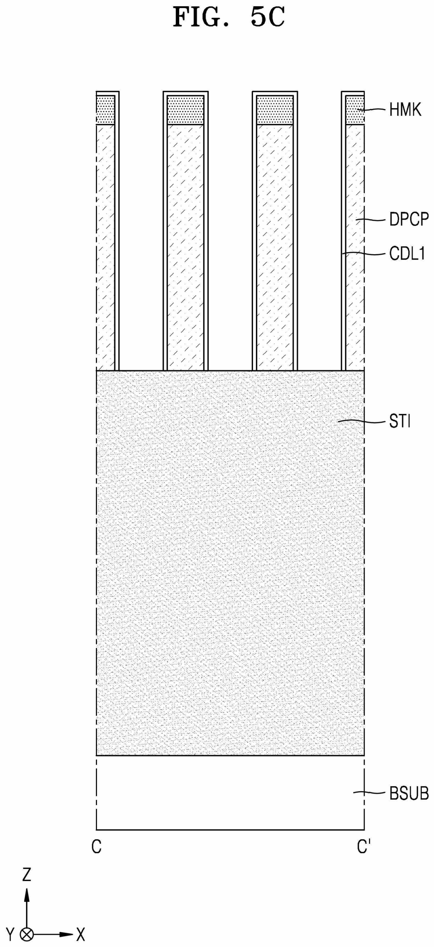

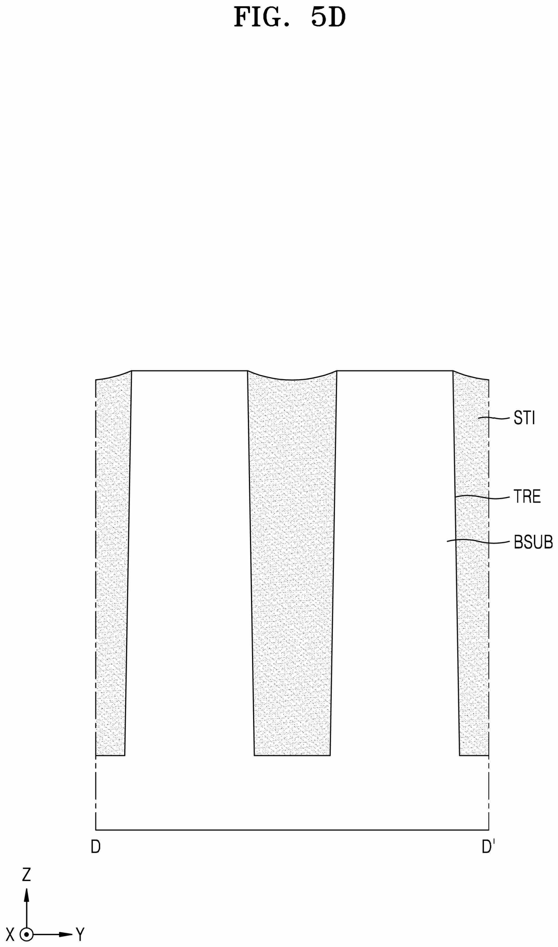

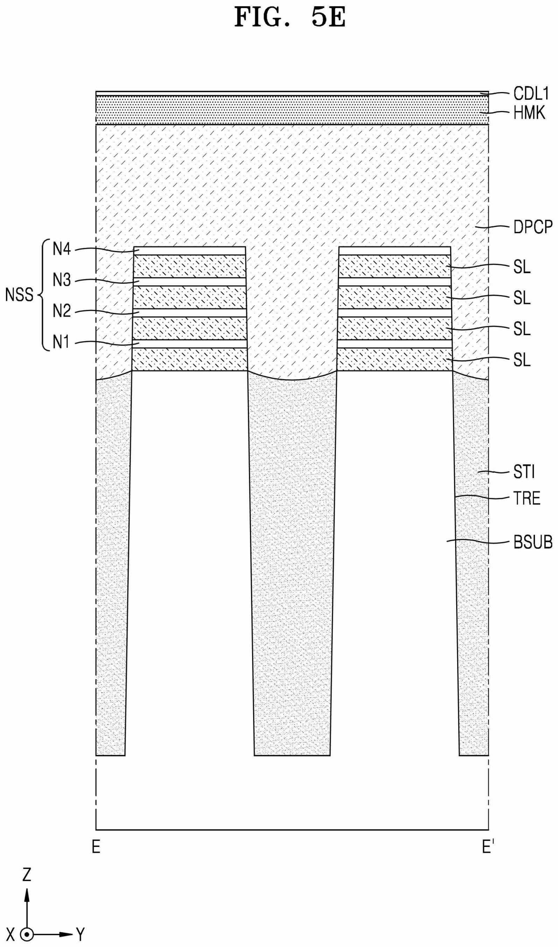

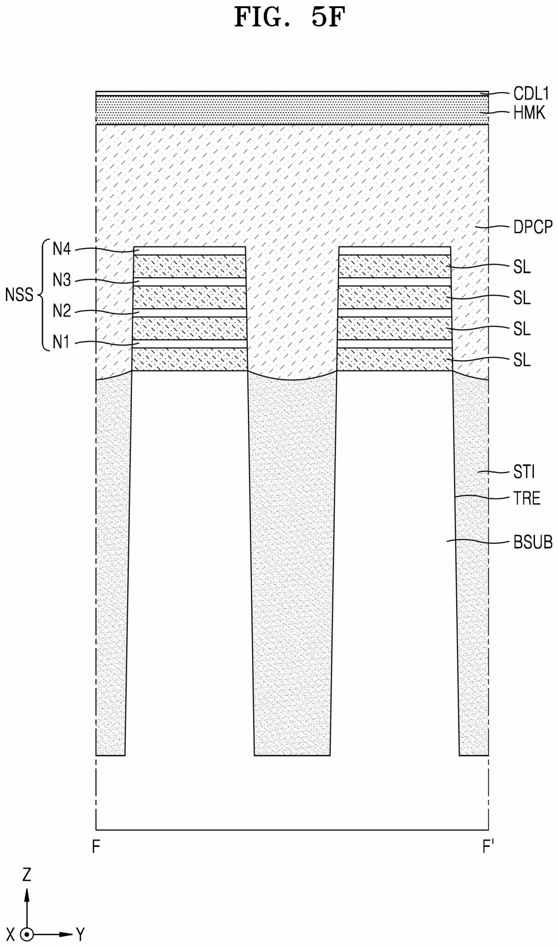

In FIGS. 5A, 5B, 5C, 5D, 5E, and 5F, the plurality of nanosheet stack structures NSS each including a plurality of nanosheets N1, N2, N3, and N4 are formed by removing parts of a stack structure of the plurality of sacrificial layers SL and the plurality of nanosheet semiconductor layers NS located below a space between the first insulating layer CDL1, and the stack structure of the plurality of dummy gate electrodes DPCP and the plurality of hard mask patterns HMK. The plurality of nanosheets N1, N2, N3, and N4 may include a first nanosheet N1, a second nanosheet N2, a third nanosheet N3, and a fourth nanosheet N4. The nanosheet stack structure NSS may include the first nanosheet N1, the second nanosheet N2, the third nanosheet N3, and the fourth nanosheet N4 sequentially spaced apart from the lower side to the upper side in the vertical direction (Z direction), but the present disclosure is not limited thereto. For example, the nanosheet stack structure NSS may include two or more nanosheets. Herein, for convenience of description, the first nanosheet N1 and the fourth nanosheet N4 are respectively described as the lowermost nanosheet and the uppermost nanosheet among the first nanosheet N1, the second nanosheet N2, the third nanosheet N3, and the fourth nanosheet N4 included in the nanosheet stack structure NSS.

Parts of the plurality of sacrificial layers SL may be disposed between the first nanosheet N1, the second nanosheet N2, the third nanosheet N3, and the fourth nanosheet N4 included in the nanosheet stack structure NSS. The base substrate layer BSUB and the device separation layer STI may be exposed on a bottom surface of space between the first nanosheet N1, the second nanosheet N2, the third nanosheet N3, and the fourth nanosheet N4. Outer side surfaces of a second insulating layer CDL2 covering side surfaces of each of the first nanosheet N1, the second nanosheet N2, the third nanosheet N3, and the fourth nanosheet N4 included in the nanosheet stack structure NSS and the side surfaces of the stack structure of the plurality of dummy gate electrodes DPCP and the plurality of hard mask patterns HMK may be aligned with each other in the vertical direction (Z direction).

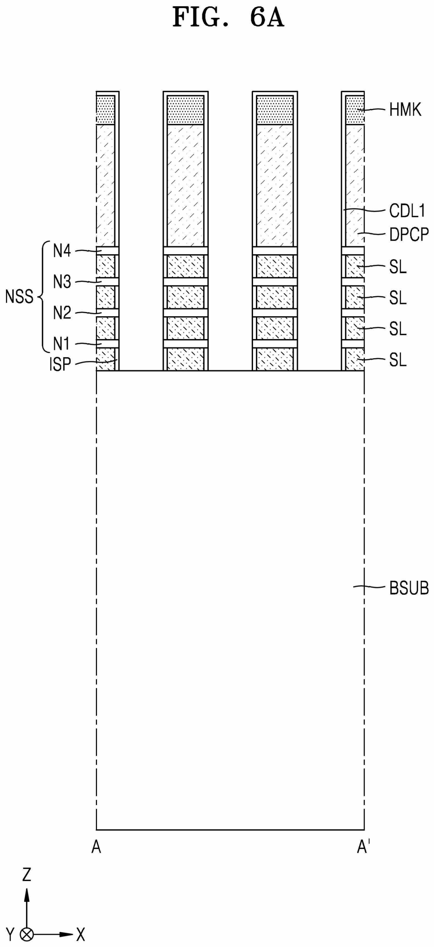

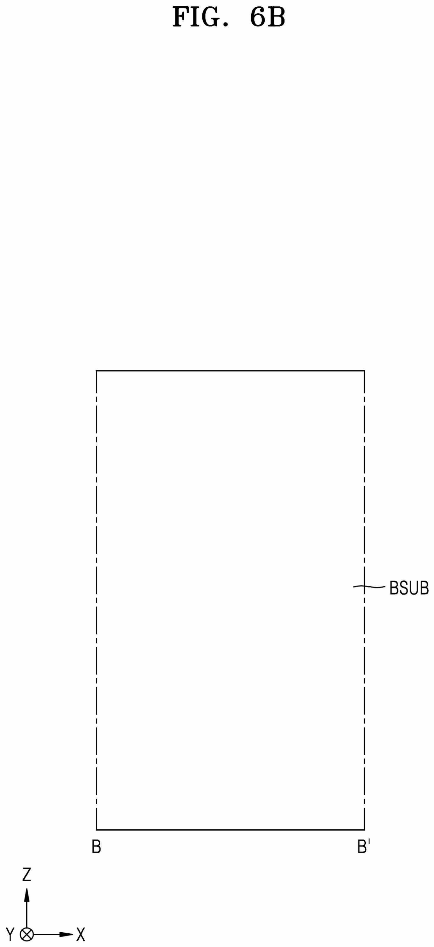

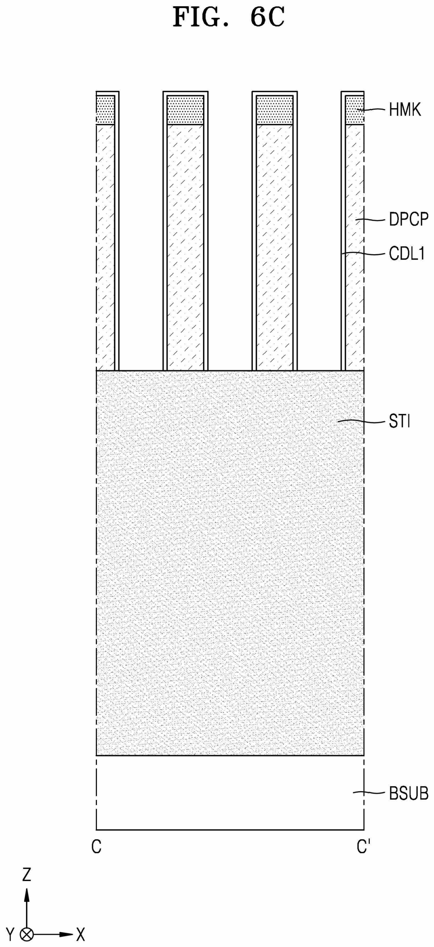

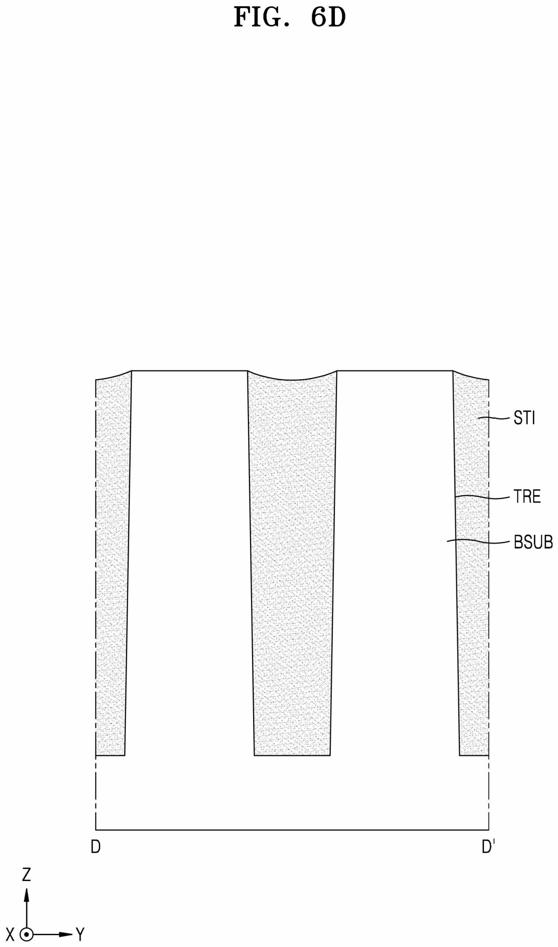

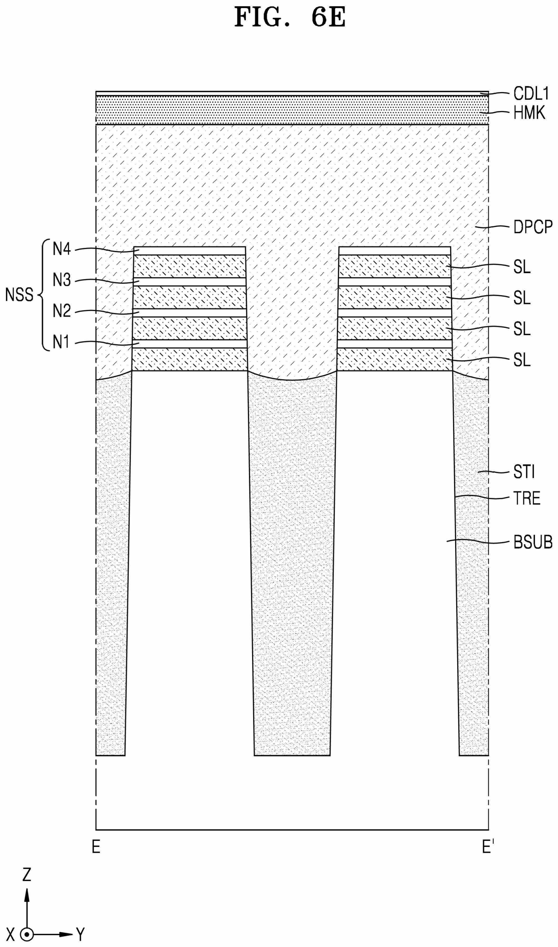

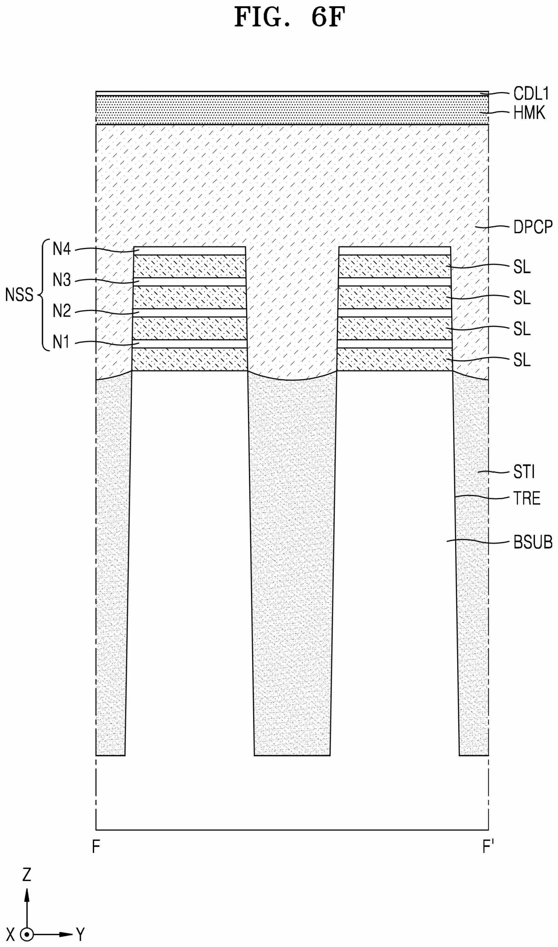

In FIGS. 6A, 6B, 6C, 6D, 6E, and 6F, after parts of the plurality of sacrificial layers SL are removed, a plurality of insulating spacers ISP filling a space from which the parts of the plurality of sacrificial layers SL are removed is formed. The parts of the plurality of sacrificial layers SL may be removed using an isotropic etching process. The plurality of insulating spacers ISP may be disposed between the base substrate layer BSUB and the first nanosheet N1, between the first nanosheet N1 and the second nanosheet N2, between the second nanosheet N2 and the third nanosheet N3, and between the third nanosheet N3 and the fourth nanosheet N4. The insulating spacer ISP may include, for example, a silicon nitride layer. In some implementations, the insulating spacer ISP may be formed by stacking a plurality of insulating layers. In some implementations, the insulating spacer ISP may be formed in some regions and may not be formed in other regions. In some implementations, the insulating spacer ISP may be omitted without being formed.

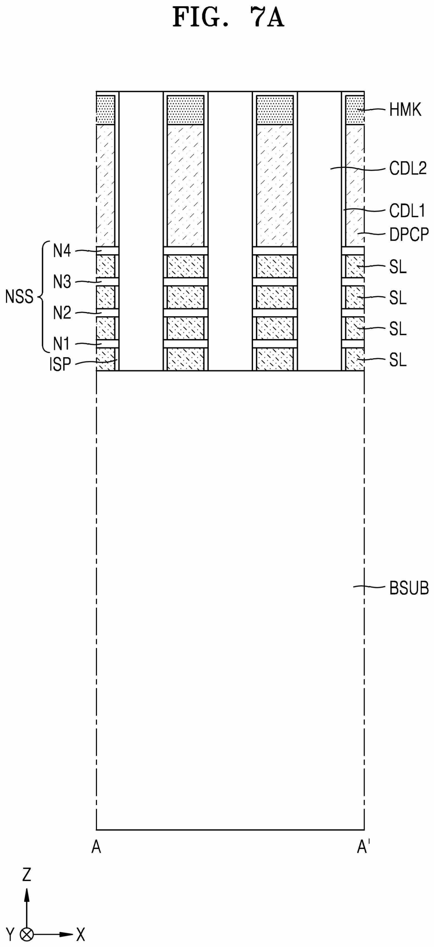

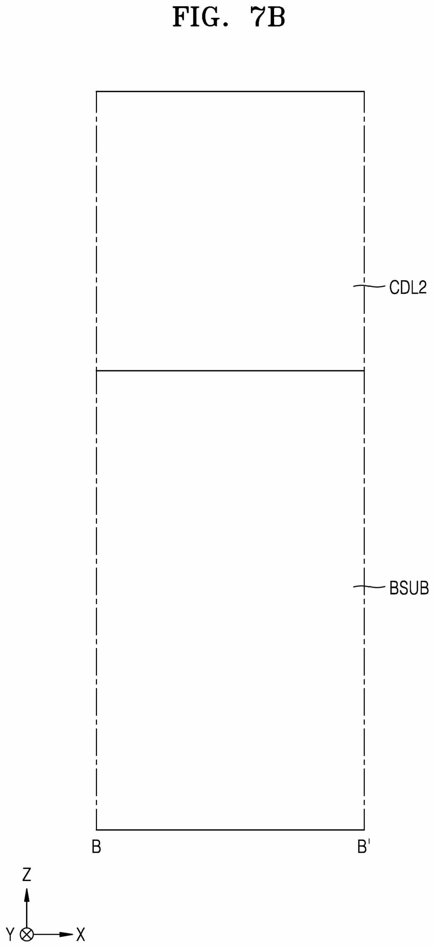

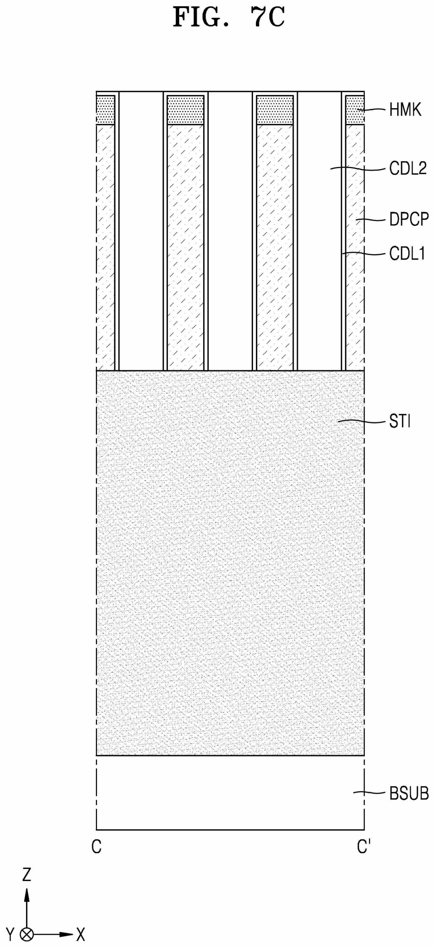

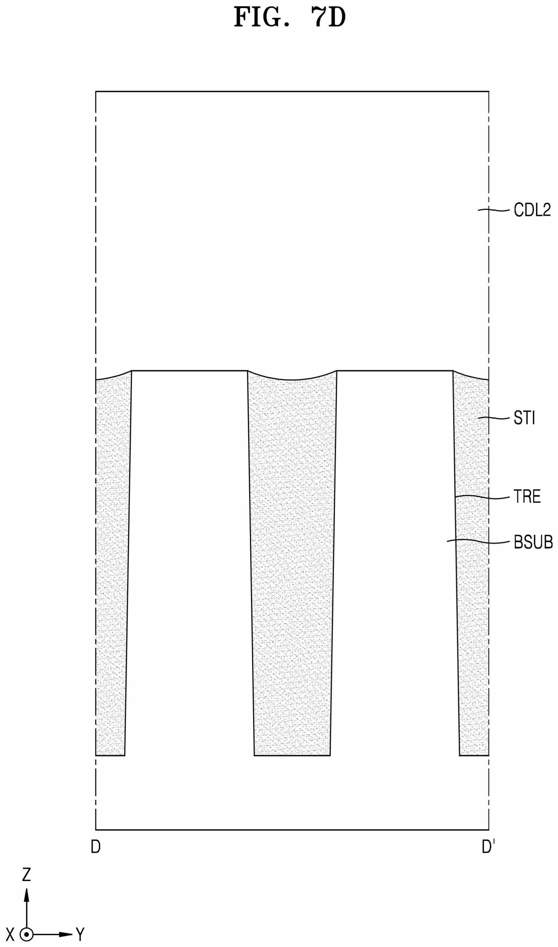

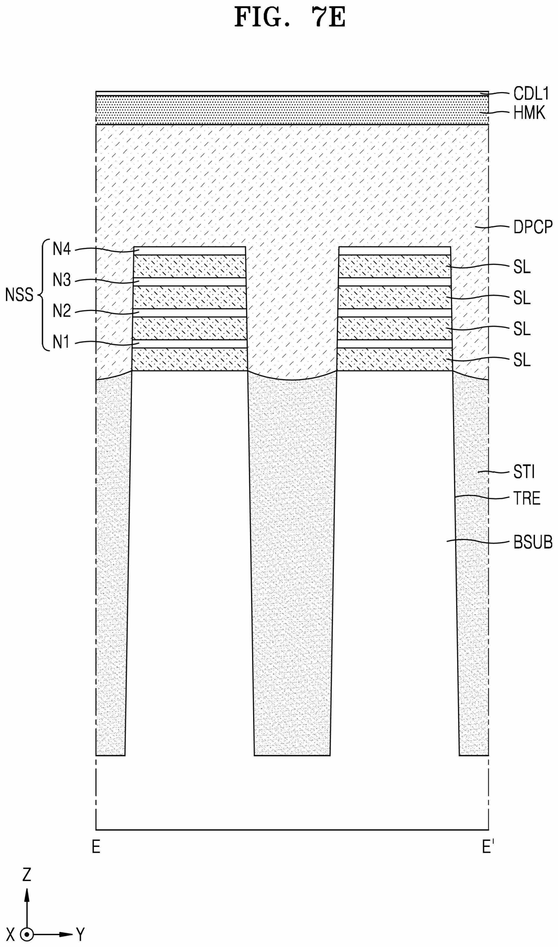

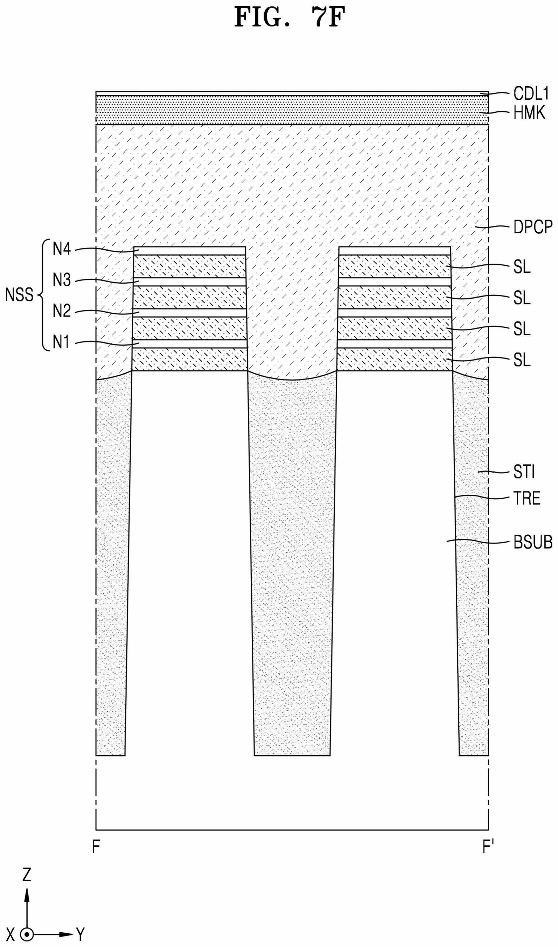

In FIGS. 7A, 7B, 7C, 7D, 7E, and 7F, the second insulating layer CDL2 covering the resultant shown in FIGS. 6A, 6B, 6C, 6D, 6E, and 6F is formed. For example, the second insulating layer CDL2 may be formed to fill spaces between the plurality of nanosheet stack structures NSS, and spaces between the stack structure of the plurality of dummy gate electrodes DPCP and the plurality of hard mask patterns HMK and the first insulating layer CDL1 covering the side surfaces of the stack structure. The second insulating layer CDL2 may include an oxide. For example, the second insulating layer CDL2 may include BoroPhosphoSilicate Glass (BPSG), PhosphoSilicate Glass (PSG), BoroSilicate Glass (BSG), Un-doped Silicate Glass (USG), Tetra Ethyl Ortho Silicate (TEOS), High Density Plasma (HDP), Tonen SilaZene (TOSZ), or a combination thereof.

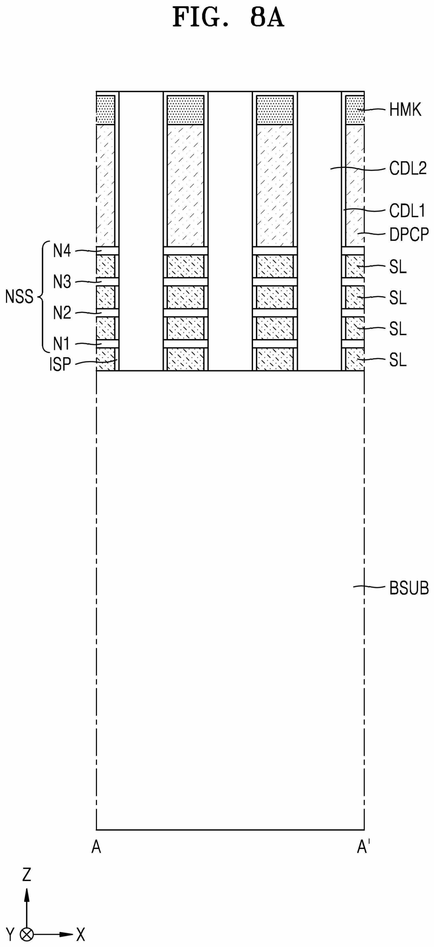

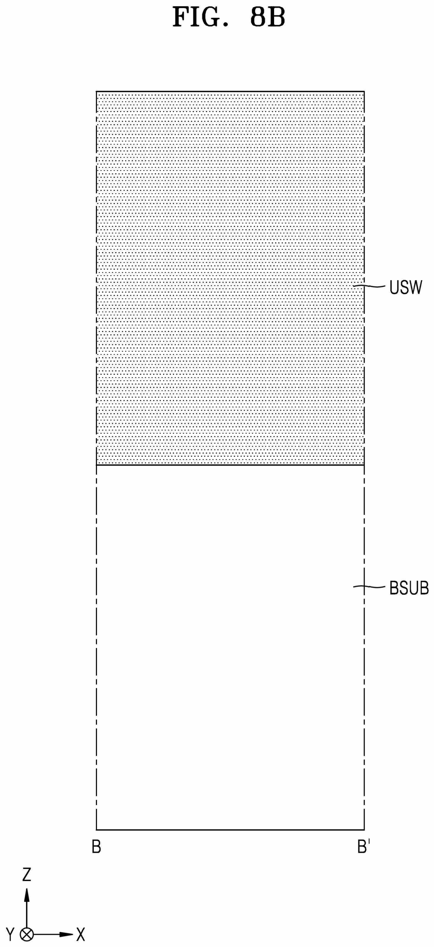

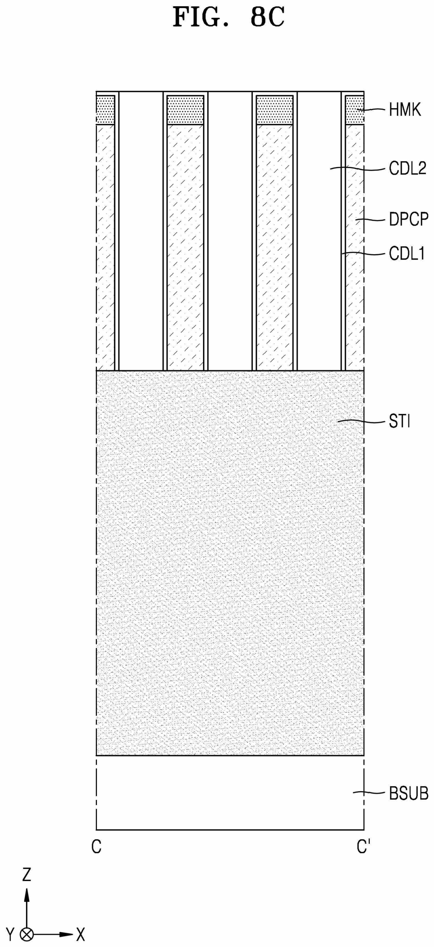

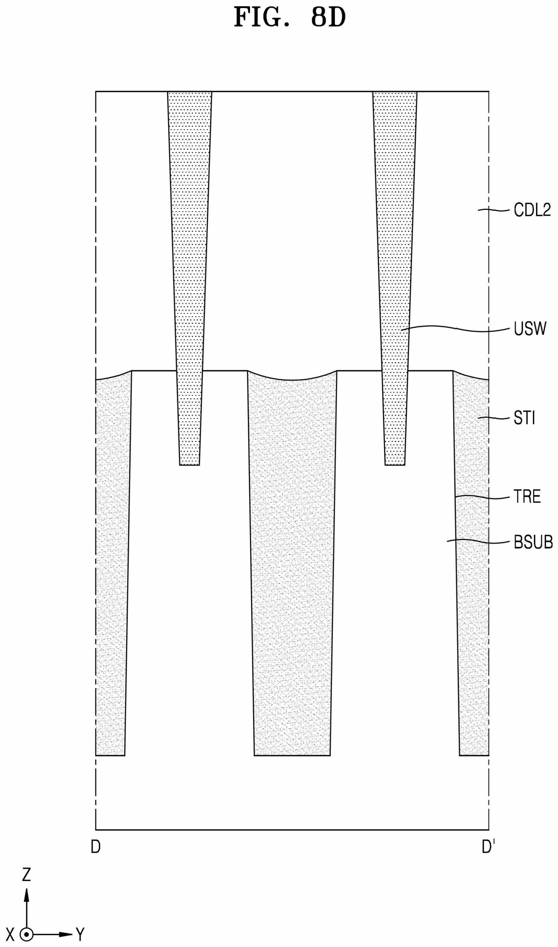

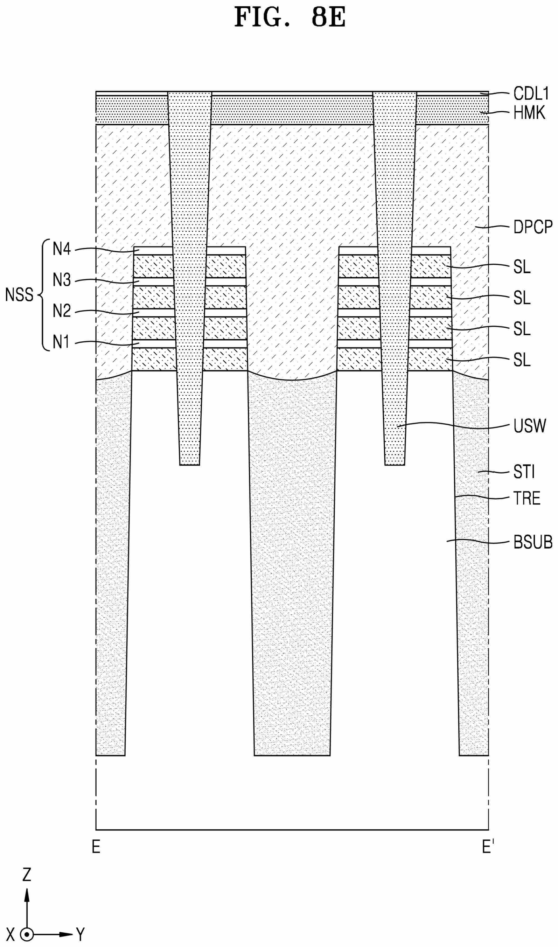

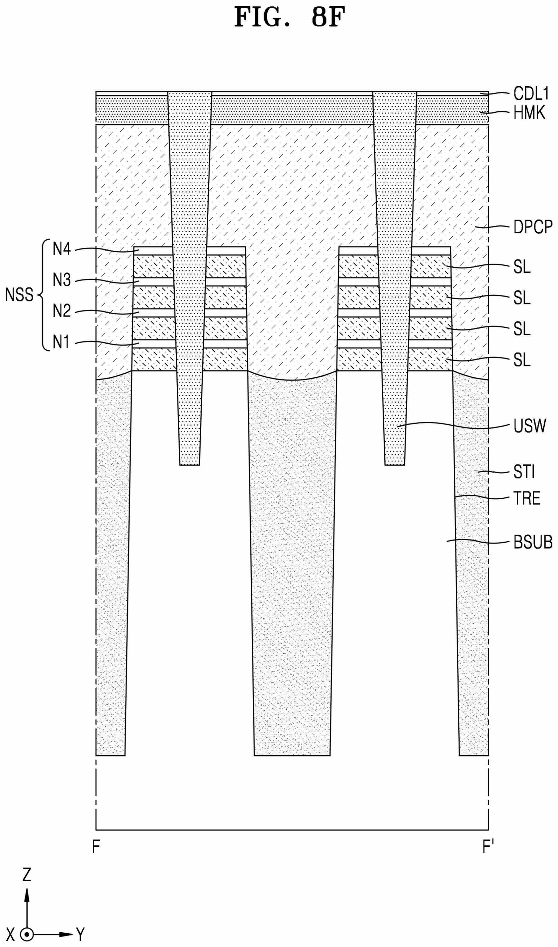

In FIGS. 8A, 8B, 8C, 8D, 8E, and 8F, a plurality of upper sheet separation walls USW extending into the base substrate layer BSUB are formed through the hard mask pattern HMK, the dummy gate electrode DPCP, the plurality of nanosheet stack structures NSS, the plurality of sacrificial layers SL, and the second insulating layer CDL2.

For example, after a plurality of recesses to which the base substrate layer BSUB is exposed are formed by removing parts of the hardmask pattern HMK, the dummy gate electrode DPCP, the plurality of nanosheet stack structures NSS, the plurality of sacrificial layers SL, and the second insulating layer CDL2, a preliminary upper separation material layer filling the plurality of recesses and covering the hardmask pattern HMK and the second insulating layer CDL2 may be formed, and the plurality of upper sheet separation walls USW filling the plurality of recesses by removing a part of the preliminary upper separation material layer may be formed. In some implementations, the part of the preliminary upper separation material layer may be removed by performing a CMP process so that the second insulating layer CDL2 is exposed. Each of the plurality of upper sheet separation walls USW may include nitride. For example, each of the plurality of upper sheet separation walls USW may include silicon nitride. The plurality of upper sheet separation walls USW may be formed to extend in the first horizontal direction (X direction) and be spaced apart from each other in the second horizontal direction (Y direction). Each of the plurality of upper sheet separation walls USW may be formed to extend from an upper side to a lower side and have a tapered shape with a horizontal width narrowing in the second horizontal direction (Y direction).

Each of the plurality of nanosheets N1, N2, N3, and N4 included in the plurality of nanosheet stack structures NSS shown in FIGS. 7A, 7B, 7C, 7D, 7E, and 7F may be separated into two by a plurality of upper sheet separation walls USW. The first nanosheet N1, the second nanosheet N2, the third nanosheet N3, and the fourth nanosheet N4 separated into two by the plurality of upper sheet separation walls USW may be spaced apart from each other in the second horizontal direction (Y direction) with the plurality of upper sheet separation walls USW disposed therebetween.

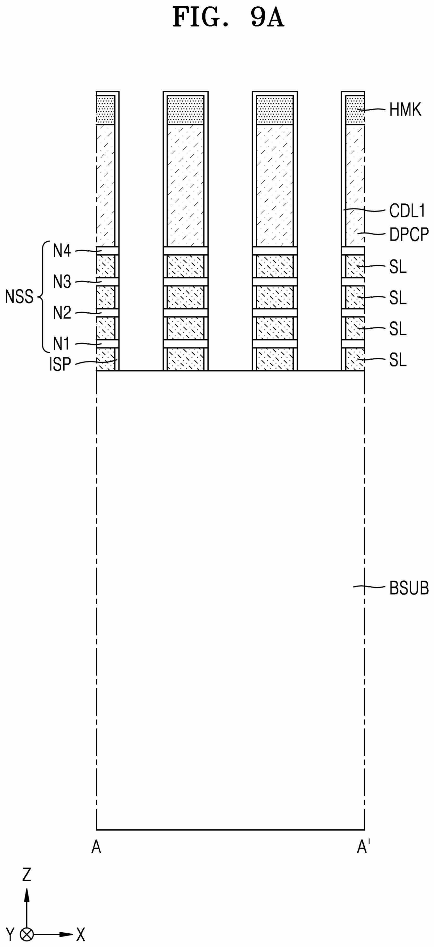

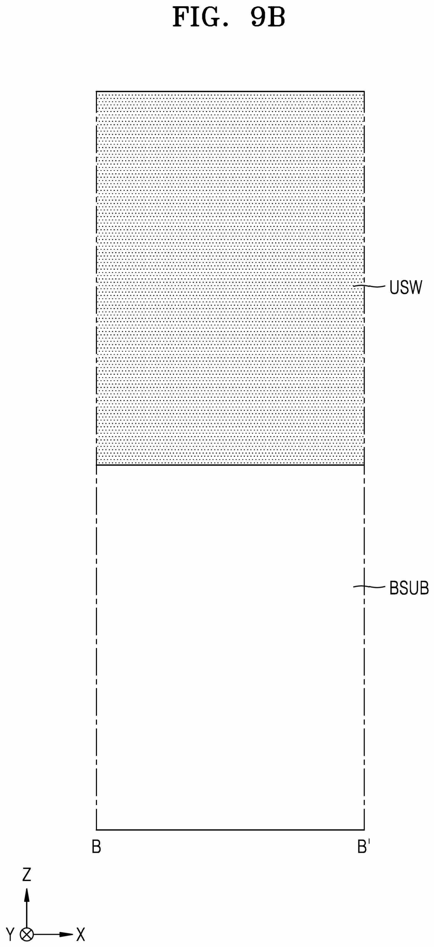

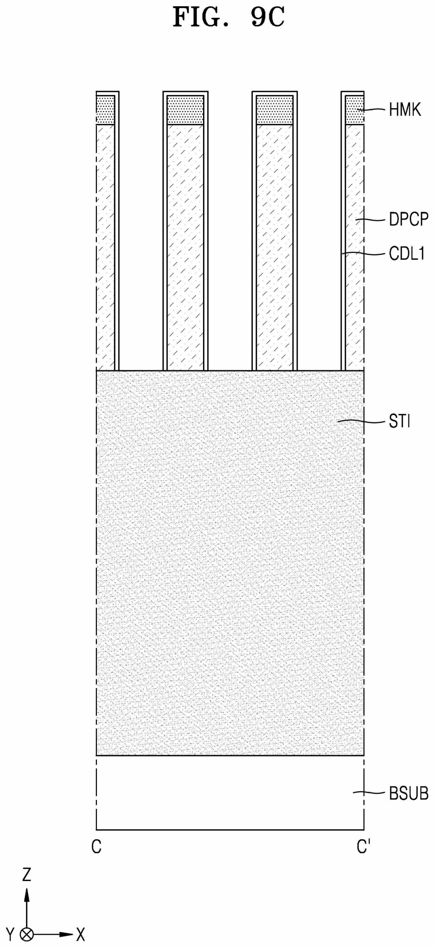

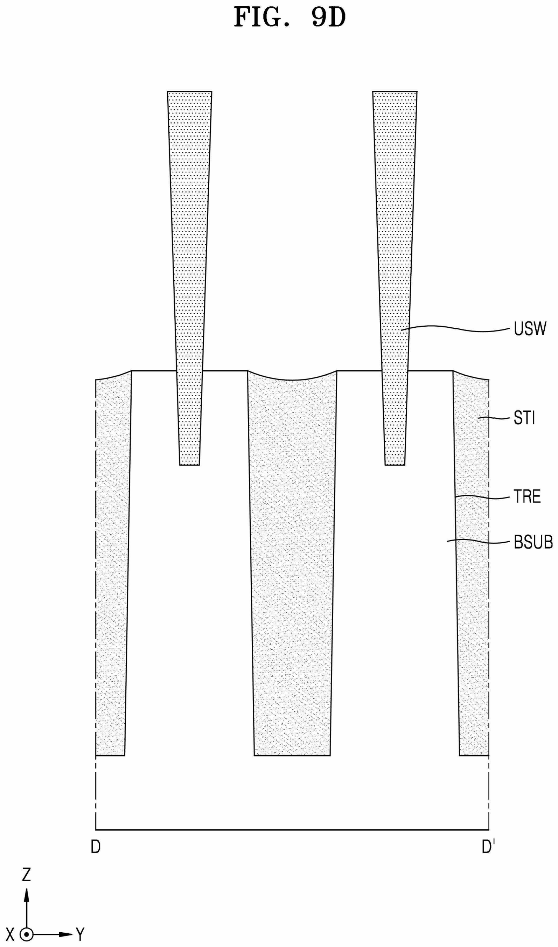

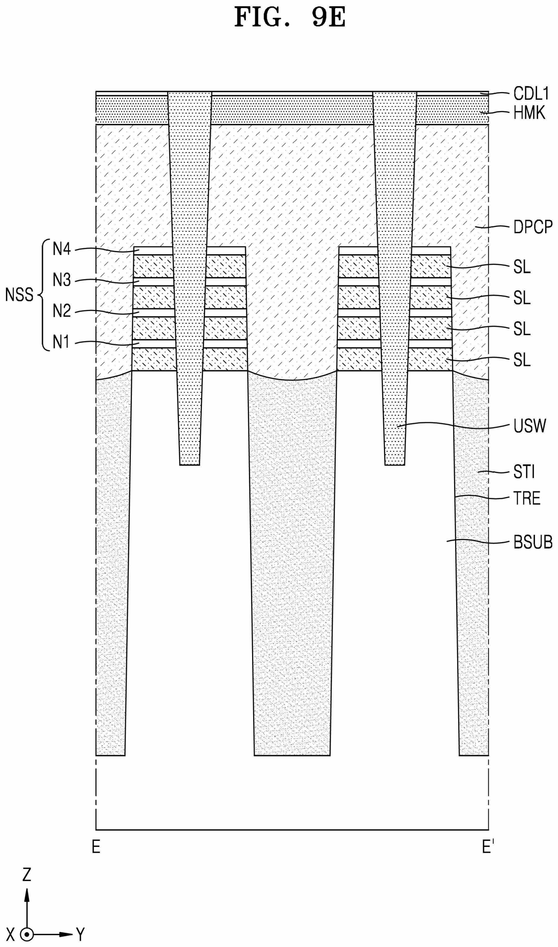

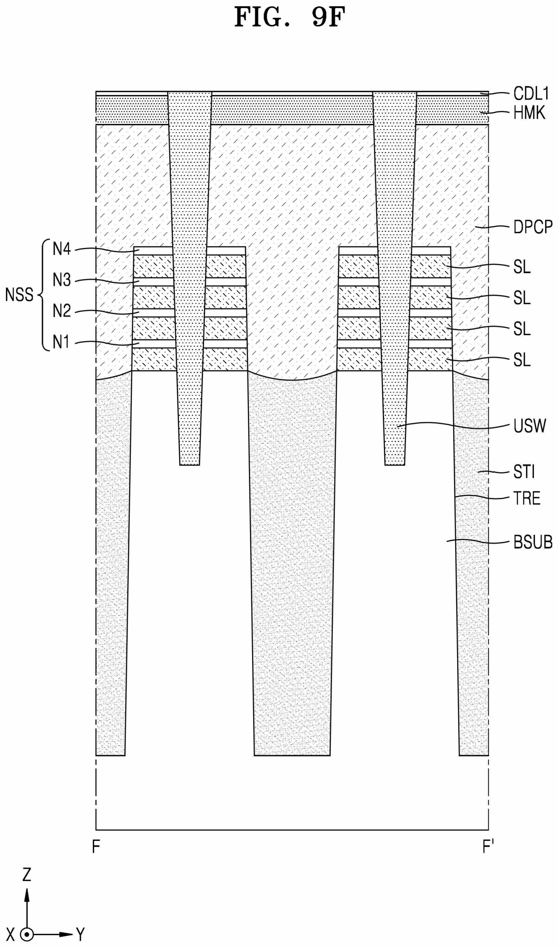

In FIGS. 8A, 8B, 8C, 8D, 8E, 8F, 9A, 9B, 9C, 9D, 9E, and 9F, the second insulating layer CDL2 is removed. The base substrate layer BSUB and the plurality of device separation layers STI may be exposed on a bottom surface of the space from which the second insulating layer CDL2 is removed.

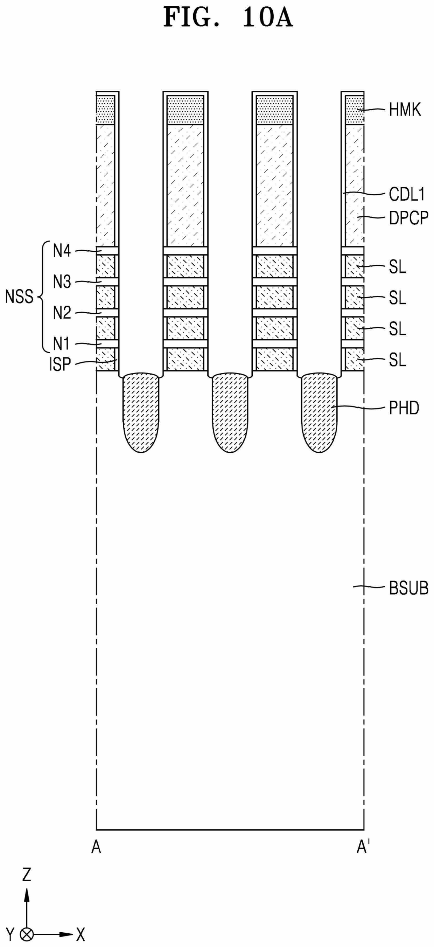

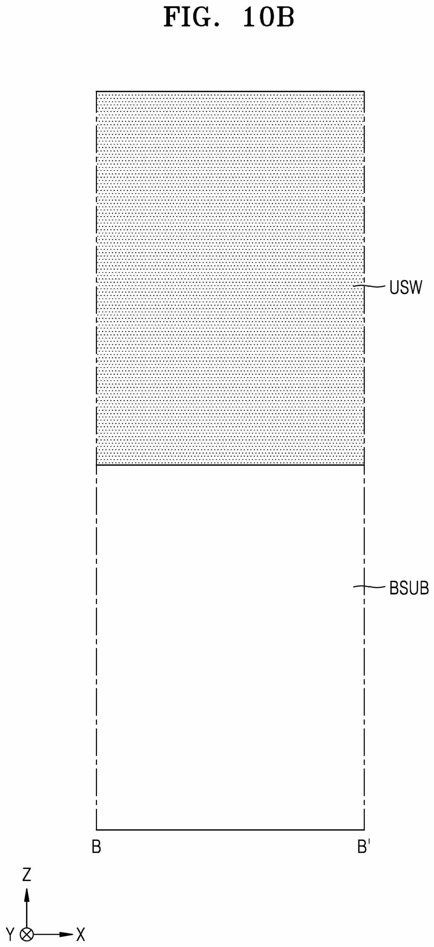

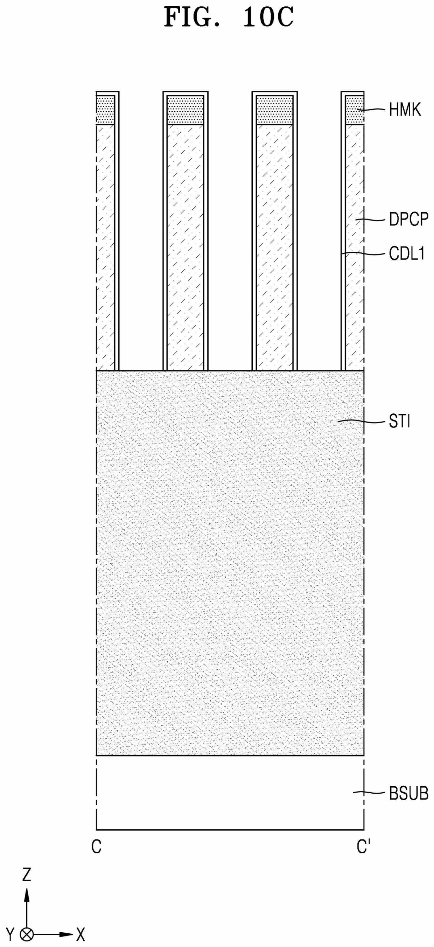

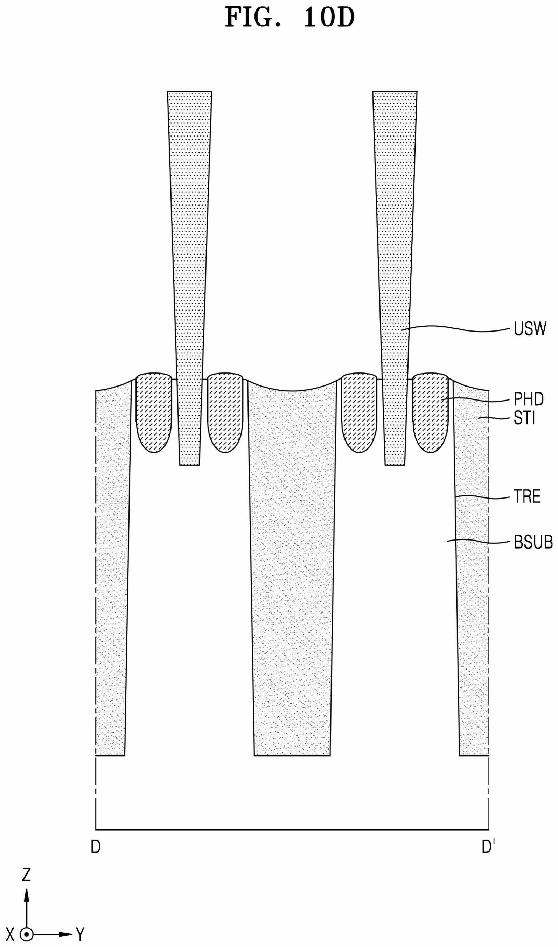

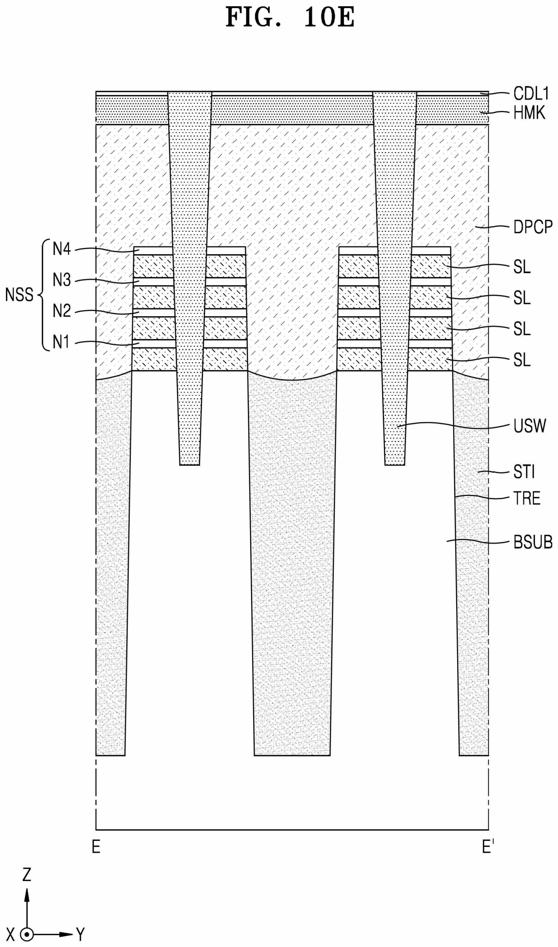

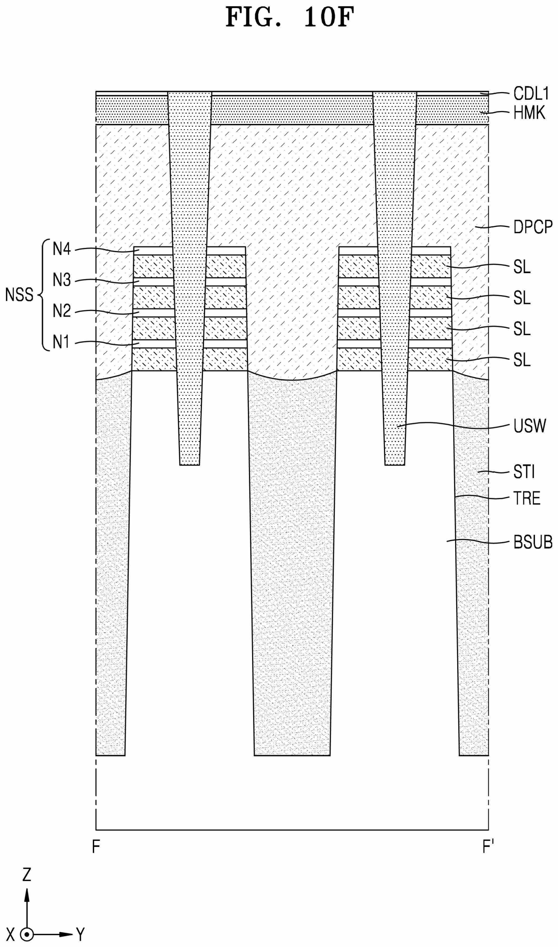

In FIGS. 10A, 10B, 10C, 10D, 10E, and 10F, after parts of the base substrate layer BSUB are removed, a plurality of place holder structures PHD filling a space from which the parts of the base substrate layer BSUB are removed are formed. In some configurations, the place holder structure PHD may include a semiconductor material. For example, the place holder structure PHD may include a compound semiconductor such as SiGe.

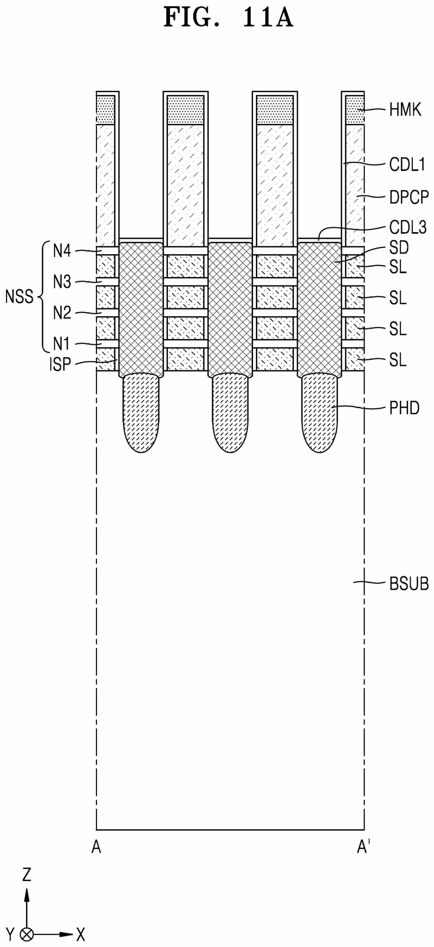

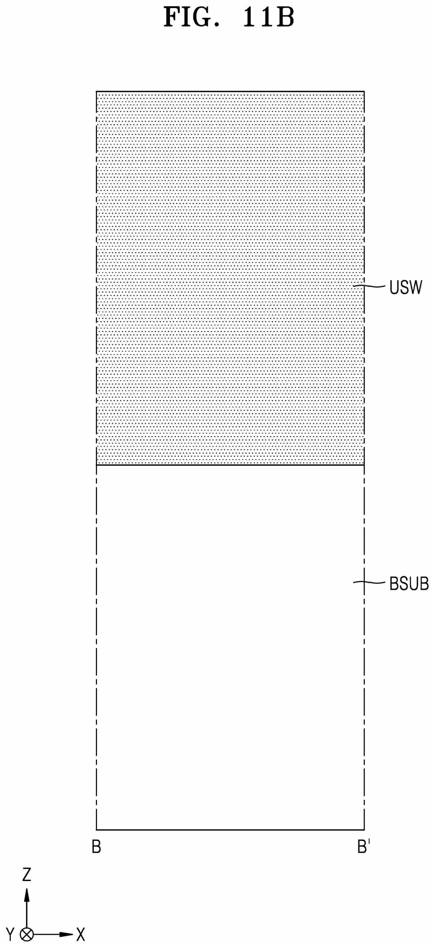

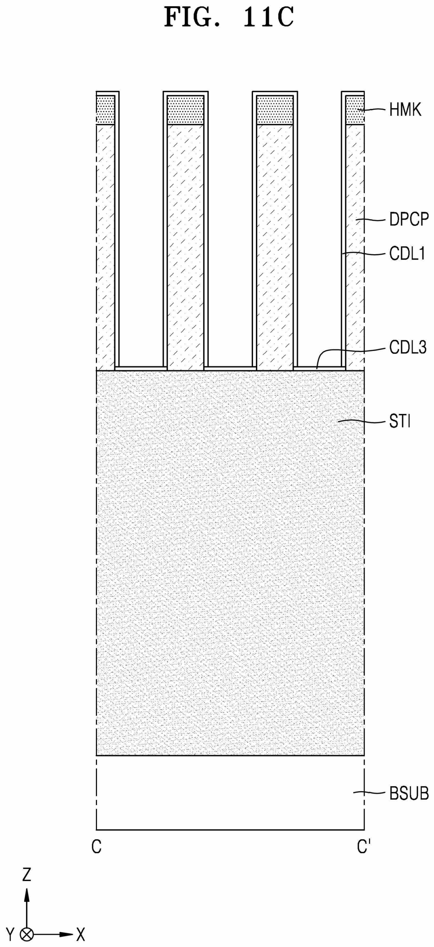

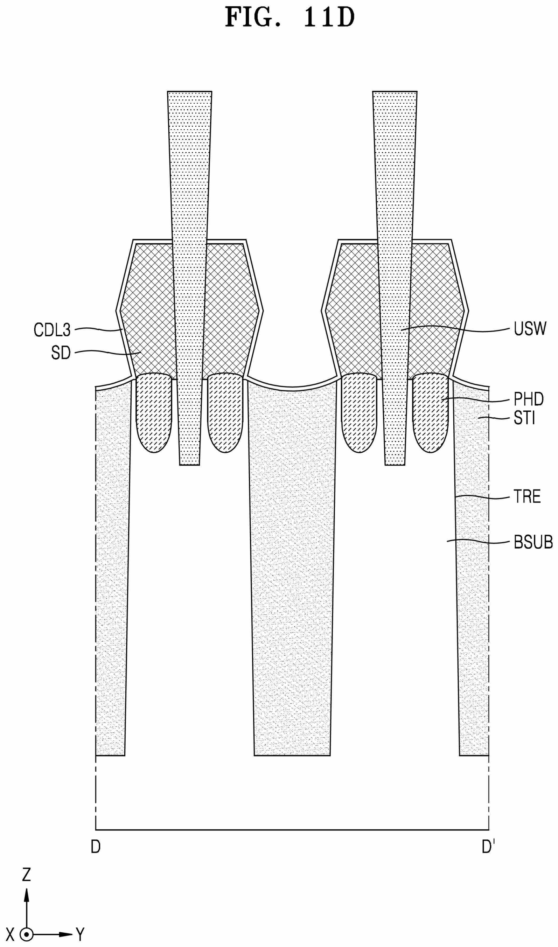

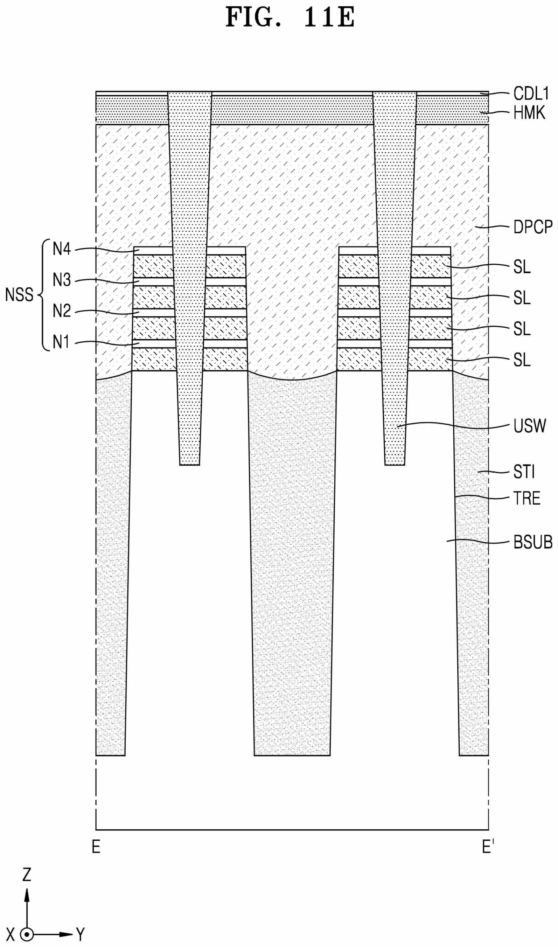

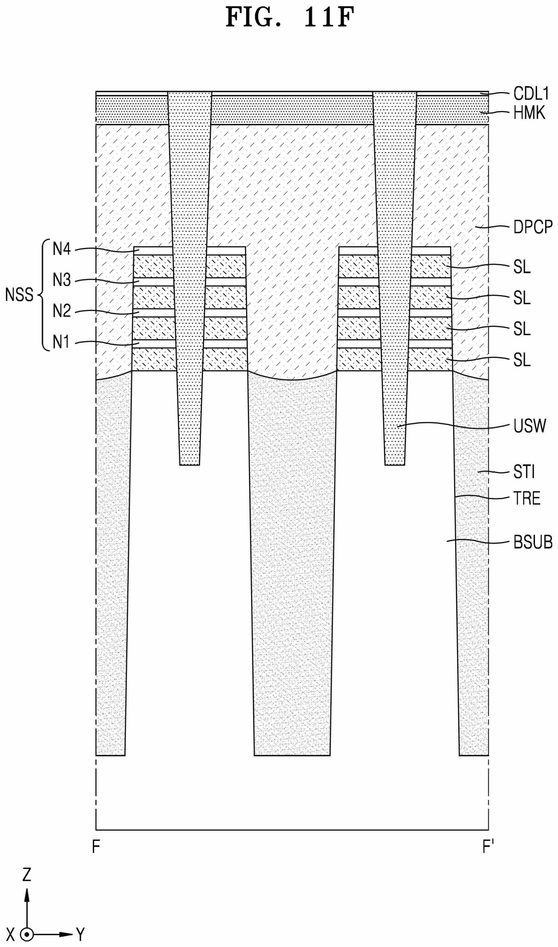

In FIGS. 11A, 11B, 11C, 11D, 11E, and 11F, after a plurality of source/drain regions SD are formed by epitaxial growth from the side surfaces of the first nanosheet N1, the second nanosheet N2, the third nanosheet N3, and the fourth nanosheet N4 included in each of the plurality of nanosheets stack structures NSS, a third insulating layer CDL3 covering a surface of a resultant in which the plurality of source/drain regions SD are formed is formed. For example, each of the plurality of source/drain regions SD may include an embedded SiGe structure including a plurality of epitaxially grown SiGe layers, an epitaxially grown Si layer, or an epitaxially grown SiC layer. In some implementations, the third insulating layer CDL3 may include nitride. In some implementations, some of the plurality of source/drain regions SD and the others may include impurities of different conductivity types. In some implementations, the first nanosheet N1, the second nanosheet N2, the third nanosheet N3, and the fourth nanosheet N4 in contact with some of the plurality of source/drain regions SD including impurities of different conductivity types and the first nanosheet N1, the second nanosheet N2, the third nanosheet N3, and the fourth nanosheet N4 in contact with the other source/drain regions SD may include impurities of different conductivity types. For example, the source/drain region SD in which an n-type metal oxide semiconductor NMOS transistor is formed may include n-type impurities, and the first nanosheet N1, the second nanosheet N2, the third nanosheet N3, and the fourth nanosheet N4 in contact with the source/drain region SD including the n-type impurities may include p-type impurities. For example, the source/drain region SD in which a p-type metal oxide semiconductor PMOS transistor is formed may include p-type impurities, and the first nanosheet N1, the second nanosheet N2, the third nanosheet N3, and the fourth nanosheet N4 in contact with the source/drain region SD including the p-type impurities may include n-type impurities.

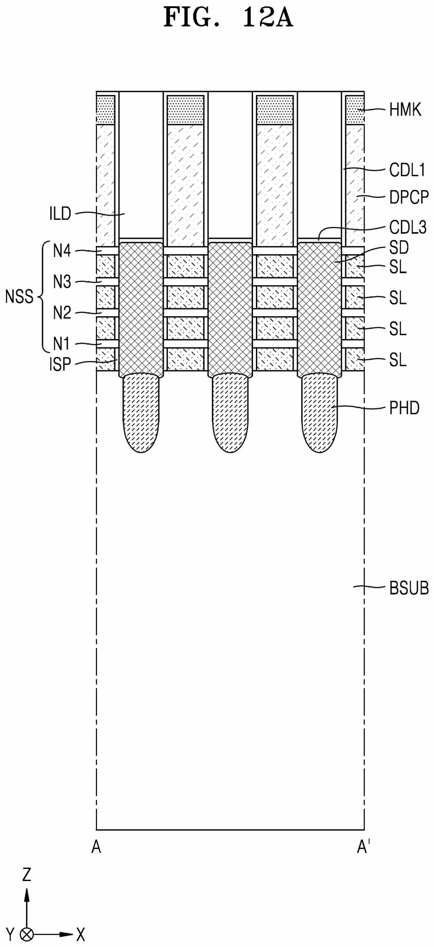

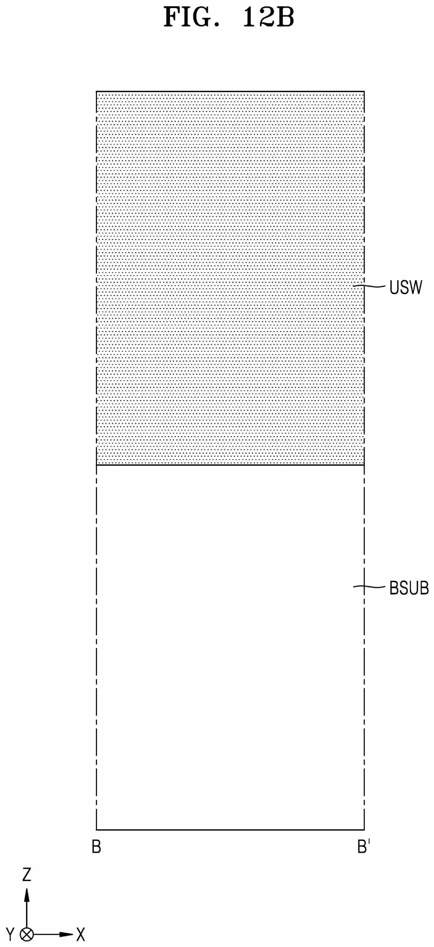

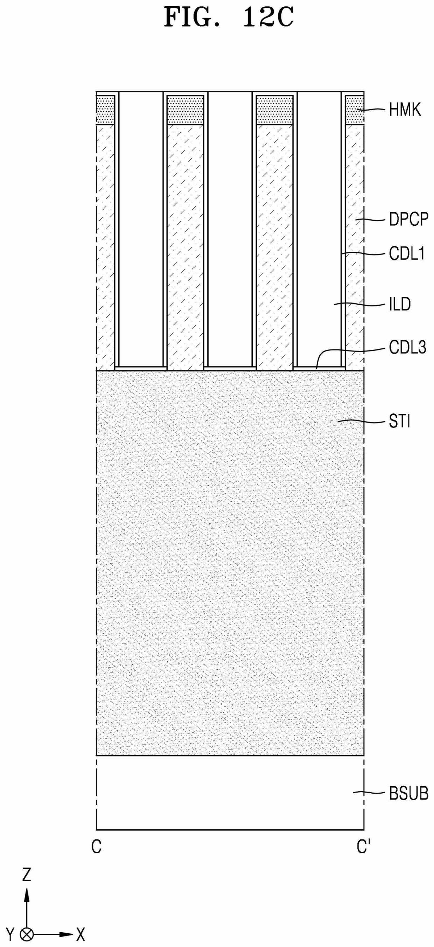

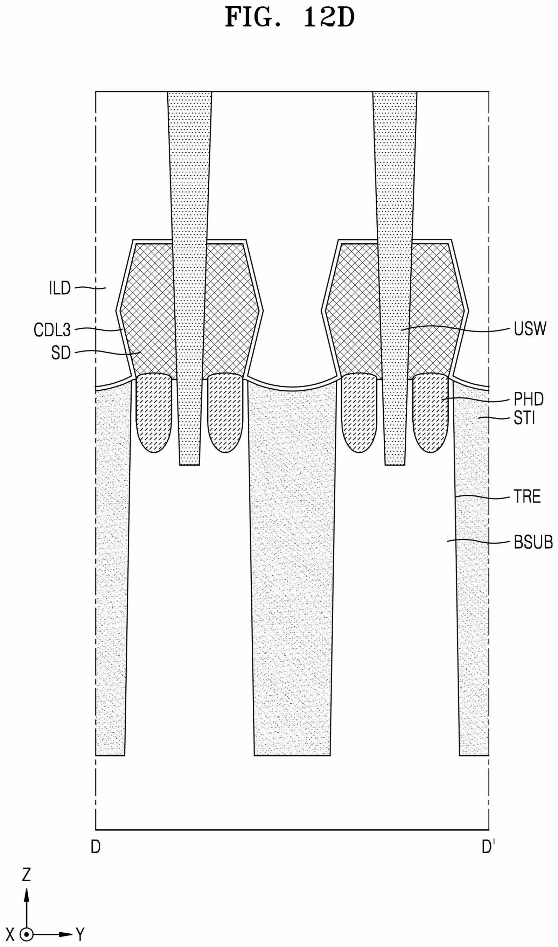

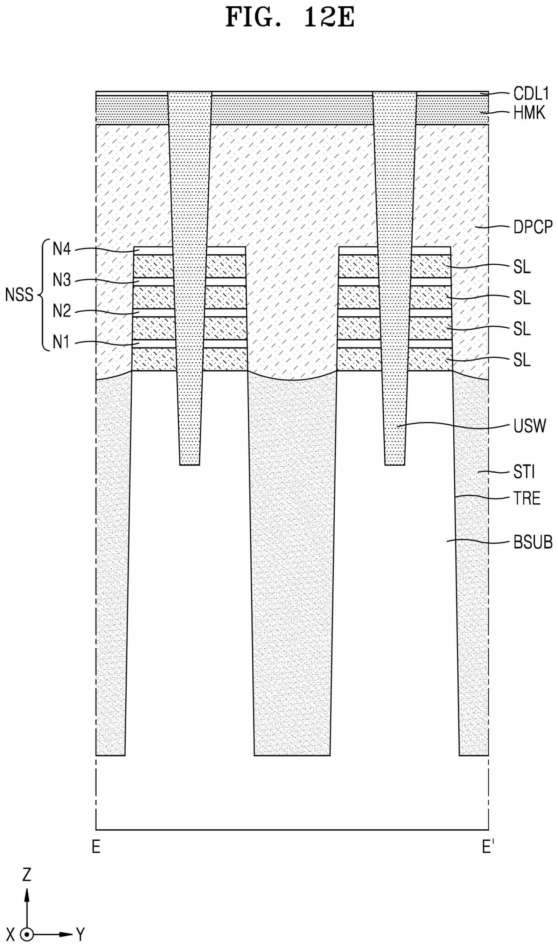

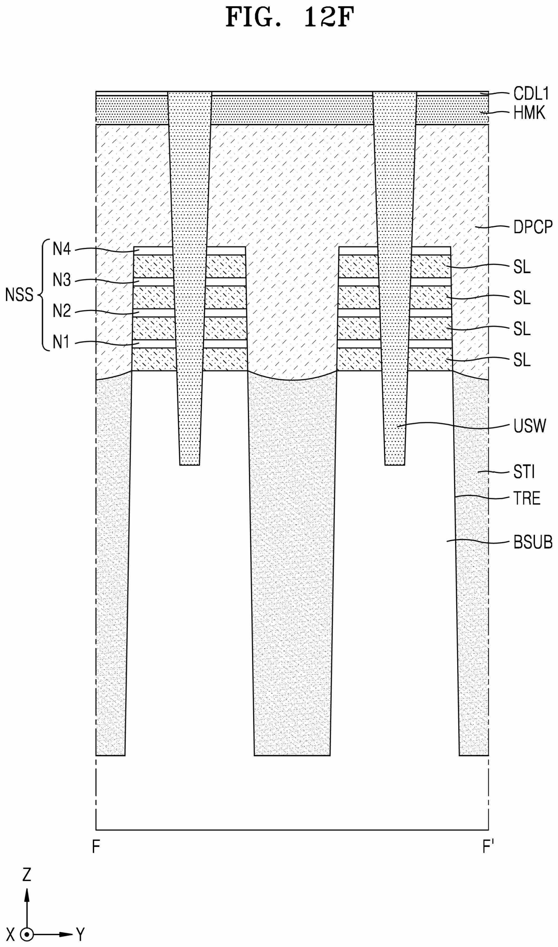

In FIGS. 12A, 12B, 12C, 12D, 12E, and 12F, an interlayer insulating layer ILD covering the third insulating layer CDL3 is formed. The interlayer insulating layer ILD may cover the third insulating layer CDL3 and be formed to fill the space between the stack structure of the plurality of dummy gate electrodes DPCP and the plurality of hard mask patterns HMK and the space between the plurality of upper sheet separation walls USW. For example, the interlayer insulating layer ILD may include silicon oxide or an insulating material having a lower dielectric constant than that of silicon oxide. In some implementations, the interlayer insulating layer ILD may include a tetraethyl orthosilicate (TEOS) layer or an ultra-low K (ULK) layer having an ultra-low dielectric constant of about 2.2 to about 2.4. The ULK layer may include a SiOC layer or a SiCOH layer.

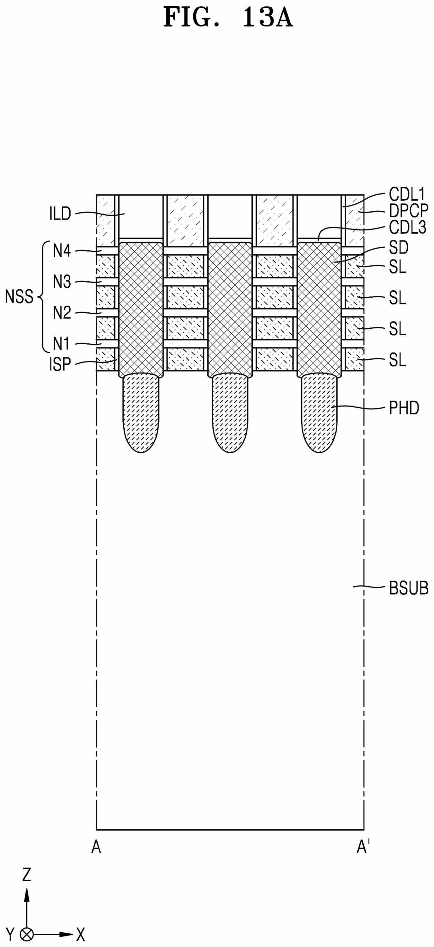

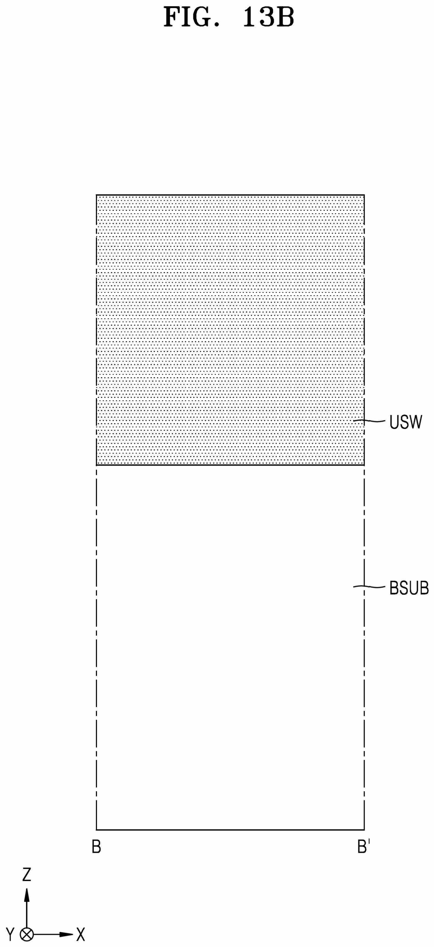

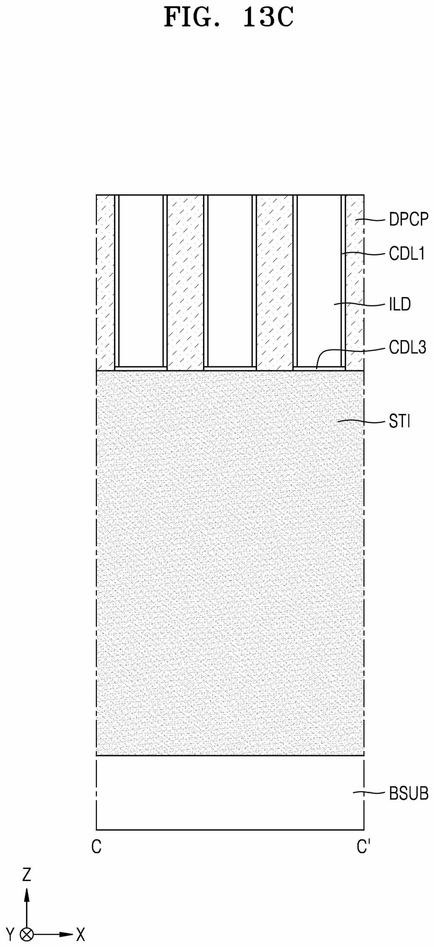

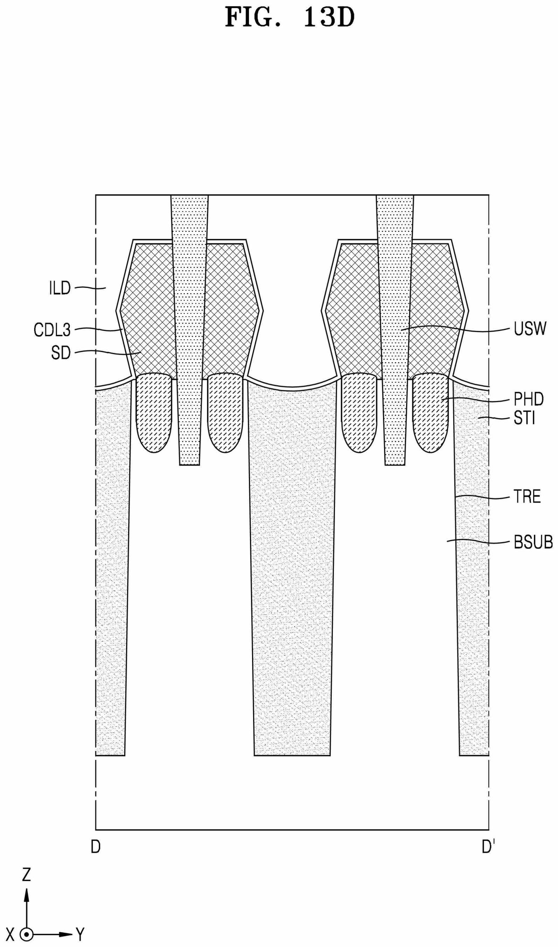

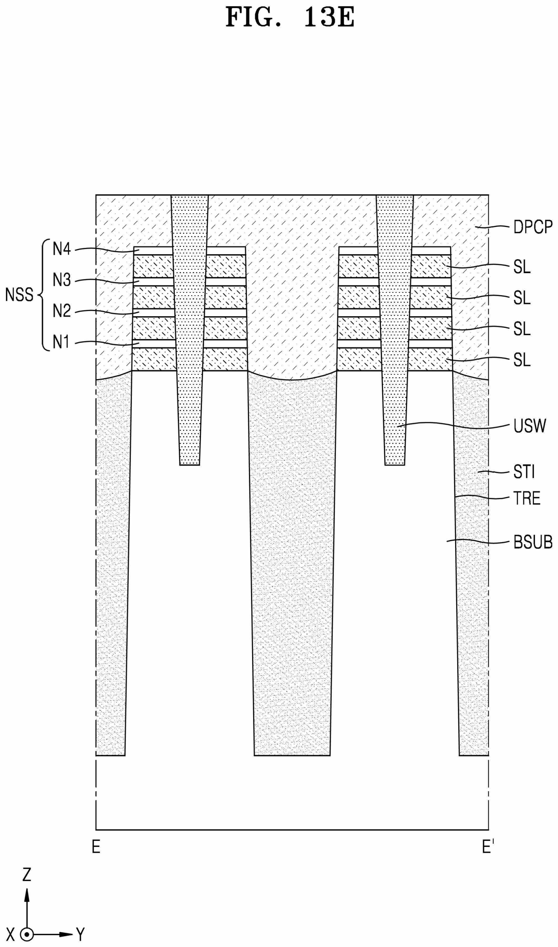

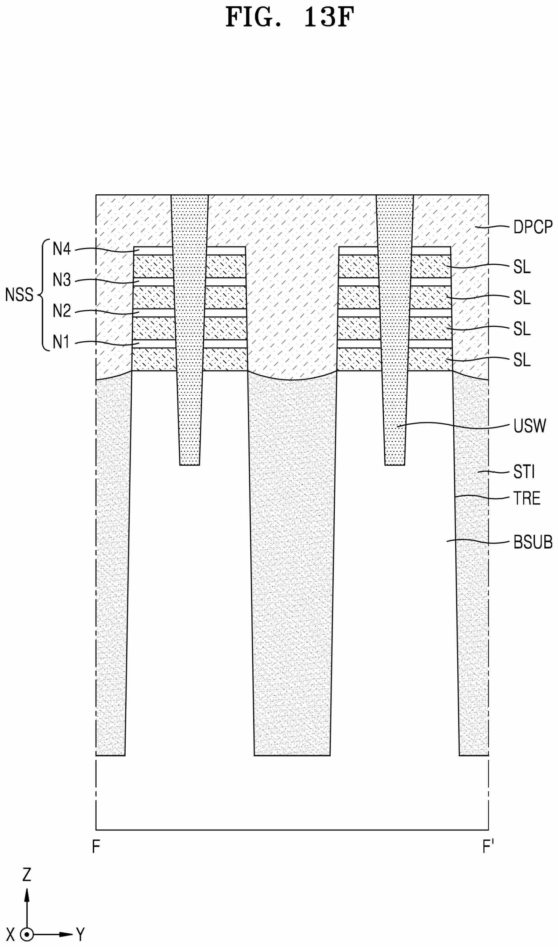

In FIGS. 13A, 13B, 13C, 13D, 13E, and 13F, the plurality of dummy gate electrodes DPCP are exposed by removing the plurality of hardmask patterns HMK, a part of the upper side of the interlayer insulating layer ILD, a part of the upper side of the first insulating layer CDL1, and parts of upper sides of the plurality of upper sheet separation walls USW. In some implementations, after the plurality of dummy gate electrodes DPCP are exposed, parts of the upper sides of the plurality of dummy gate electrodes DPCP, a part of the interlayer insulating layer ILD surrounding the parts of the upper side of the plurality of dummy gate electrodes DPCP, a part of the first insulating layer CDL1, and parts of the plurality of upper sheet separation walls USW may be further removed.

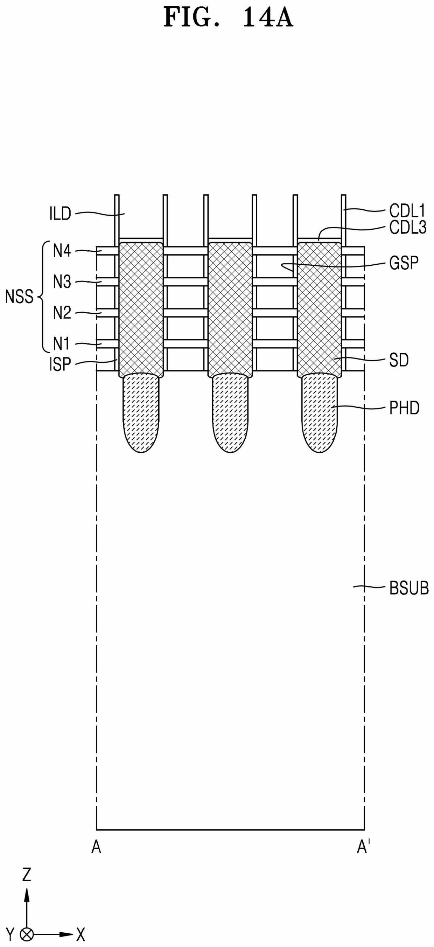

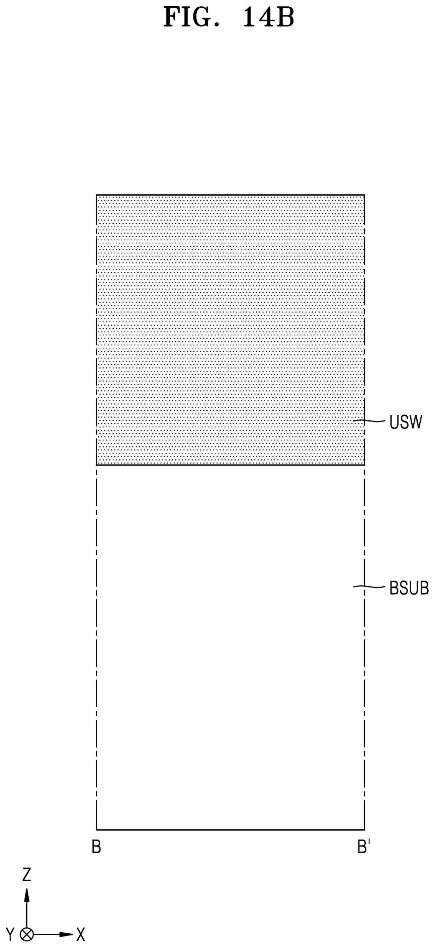

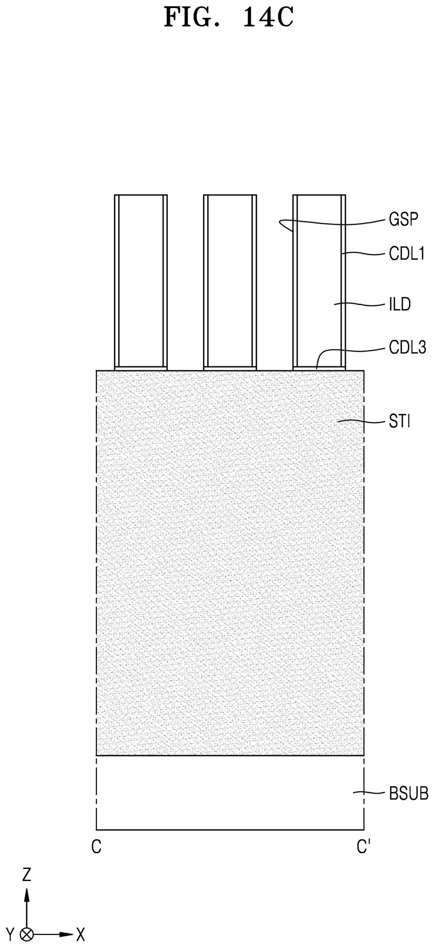

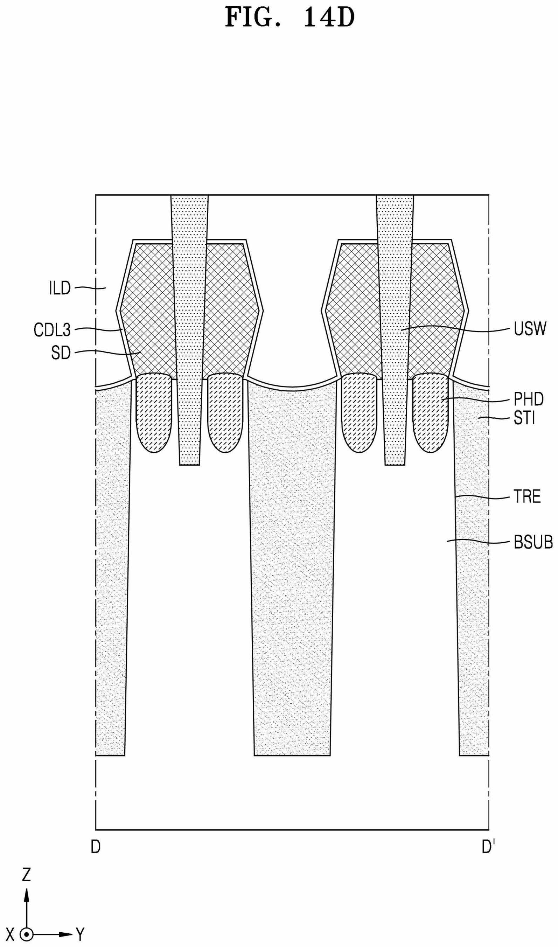

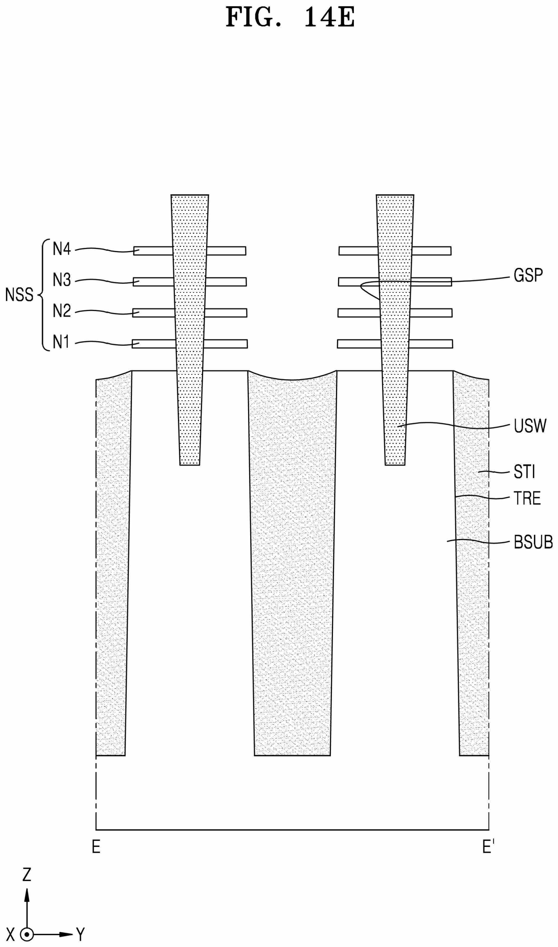

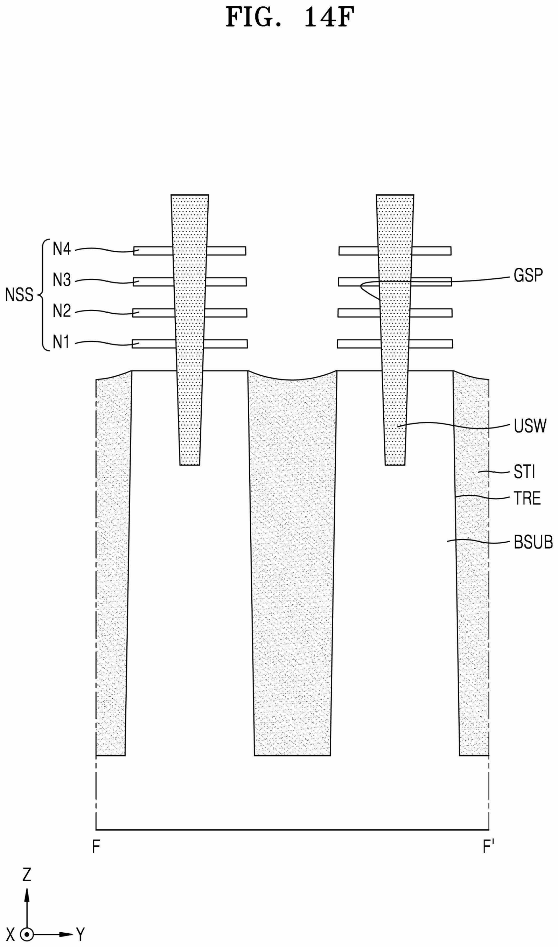

In FIGS. 13A, 13B, 13C, 13D, 13E, 13F, 14A, 14B, 14C, 14D, 14E, and 14F, a plurality of gate spaces GSP are formed by removing the plurality of dummy gate electrodes DPCP and the plurality of sacrificial layers SL. In some implementations, the plurality of dummy gate electrodes DPCP and the plurality of sacrificial layers SL may be removed by performing a wet etching process. In order to perform the wet etching process, for example, an etching solution including HNO₃, diluted hydrofluoric acid (DHF), NH₄OH, tetramethyl ammonium hydroxide (TMAH), KOH, or a combination thereof may be used. In some implementations, in a process of removing the plurality of dummy gate electrodes DPCP and the plurality of sacrificial layers SL, a part of the upper side of the device separation layer STI located below the plurality of dummy gate electrodes DPCP may be removed together.

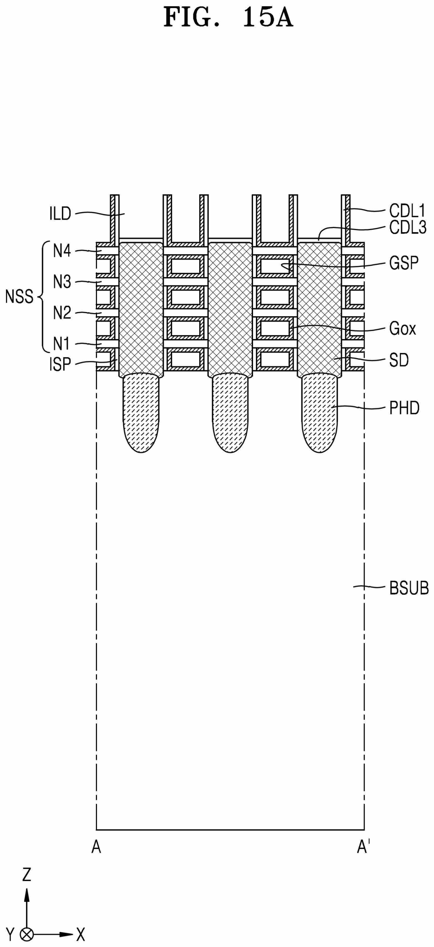

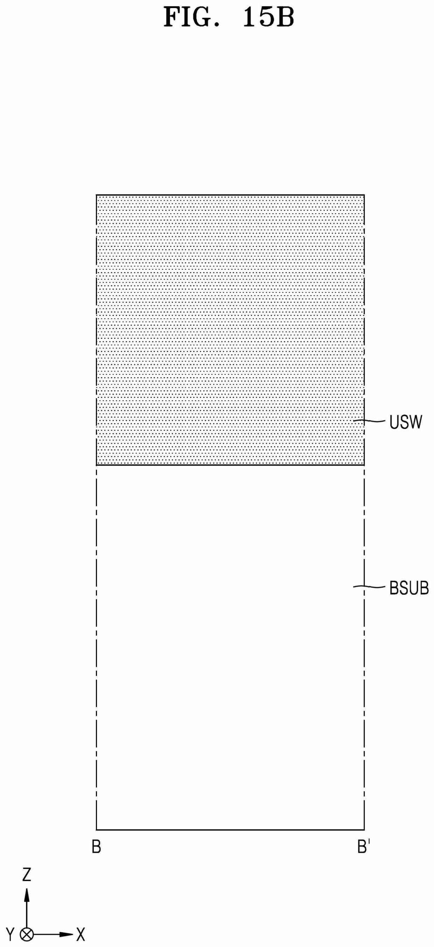

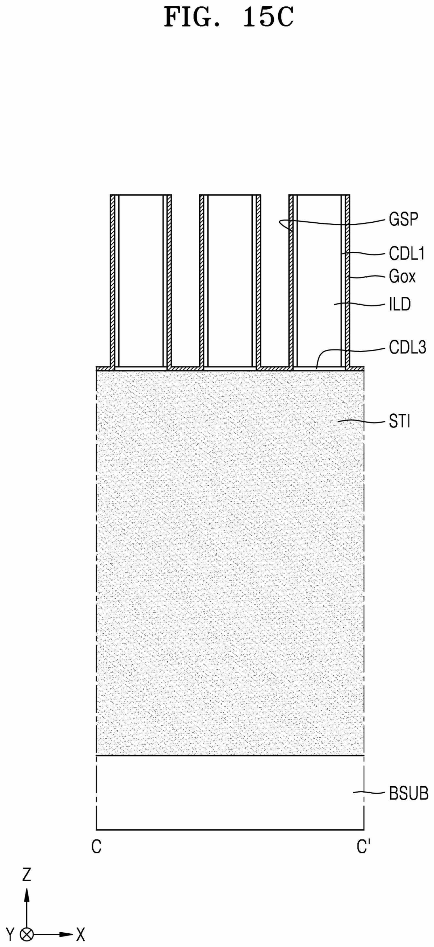

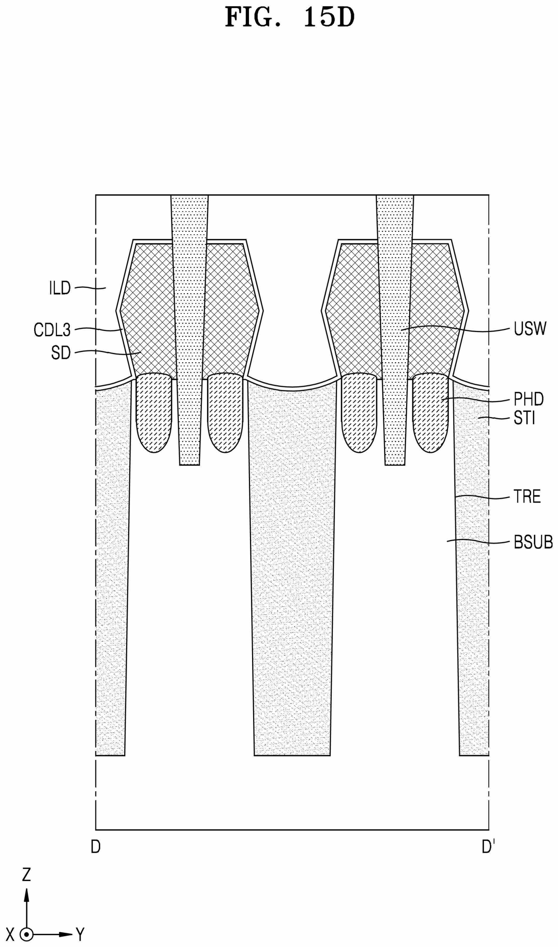

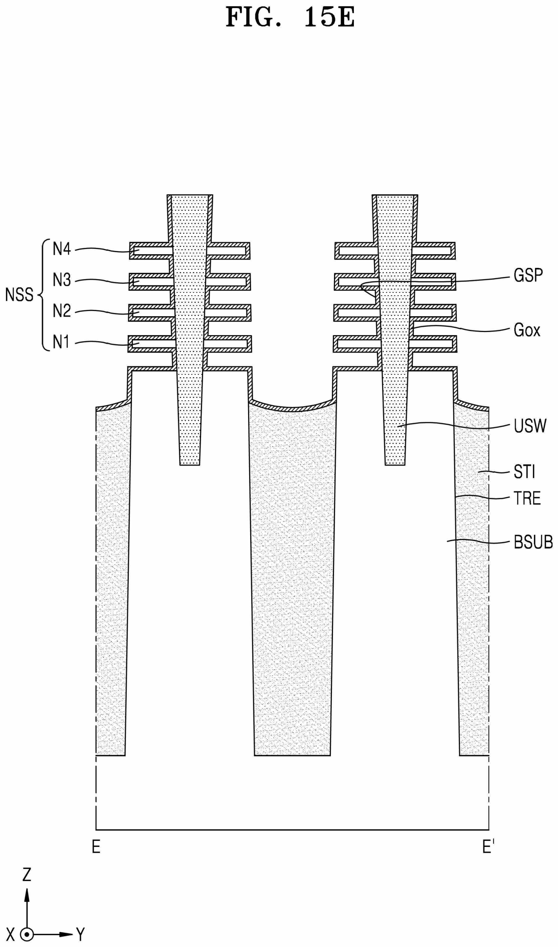

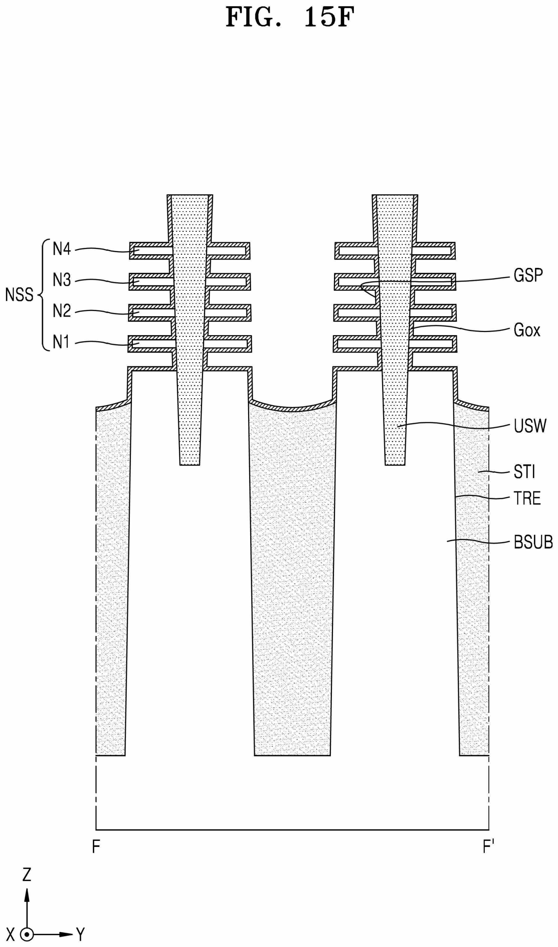

In FIGS. 15A, 15B, 15C, 15D, 15E, and 15F, a plurality of gate insulating layers Gox covering surfaces exposed in the plurality of gate spaces GSP are formed. The plurality of gate insulating layers Gox may be formed to conformally cover the surfaces of the first nanosheet N1, the second nanosheet N2, the third nanosheet N3, and the fourth nanosheet N4 included in the nanosheet stack structure NSS. The gate insulating layer Gox may include a silicon oxide layer, a high dielectric layer, or a combination thereof. In some implementations, the gate insulating layer Gox may have a stack structure of an interfacial layer and a high dielectric layer. The interfacial layer may include a low dielectric material having a dielectric constant of about 9 or less. For example, the interfacial layer may include oxide, nitride, or oxynitride. The high dielectric layer may include metal oxide or metal oxynitride. The high dielectric layer may include a material having a greater dielectric constant than that of a silicon oxide layer. For example, the high dielectric layer may have a dielectric constant of about 10 to about 25. The high dielectric layer may include a material selected from hafnium oxide, hafnium oxynitride, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate, and combinations thereof, but the material constituting the high dielectric layer may not be limited to the examples. The high dielectric layer may be formed by an ALD process, a CVD process, or a PVD process. The high dielectric layer may have a thickness of about 10 Å (angstroms) to about 40 Å, but is not limited thereto. In some implementations, the interfacial layer may be omitted. For example, the gate insulating layer Gox may include HfO₂, Al_{b}O₃, HfAlO₃, Ta₂O₃, or TiO₂.

In some implementations, the gate insulating layer Gox may include a ferroelectric material layer having ferroelectric characteristics or a phase dielectric material layer having phase dielectric characteristics. For example, the gate insulating layer Gox may include one ferroelectric material layer. For example, the gate insulating layer Gox may include a plurality of ferroelectric material layers spaced apart from each other. For example, the gate insulating layer Gox may have a stack layer structure in which a plurality of ferroelectric material layers and a plurality of phase dielectric material layers are alternately stacked.

The ferroelectric material layer may have a negative capacitance, and the phase dielectric material layer may have a positive capacitance. For example, when two or more capacitors are connected in series, and the capacitance of each capacitor has a positive value, the total capacitance is reduced compared to the capacitance of each individual capacitor. On the other hand, when at least one of capacitances of two or more capacitors connected in series has a negative value, the total capacitance may have a positive value and may be greater than the absolute value of each individual capacitance.

When the ferroelectric material layer having the negative capacitance and the phase dielectric material layer having the positive capacitance are connected in series, the overall capacitance value of the ferroelectric material layer and the phase dielectric material layer connected in series may increase. A transistor including the ferroelectric material layer may have a subthreshold swing (SS) voltage less than 60 mV/decade at room temperature, by using the increase in the overall capacitance value.

The ferroelectric material layer may have ferroelectric characteristics. For example, the ferroelectric material layer may include at least one of hafnium oxide, hafnium zirconium oxide, barium strontium titanium oxide, barium titanium oxide, or lead zirconium titanium oxide. Here, for example, hafnium zirconium oxide may be a material doped with zirconium (Zr) in hafnium oxide. As another example, hafnium zirconium oxide may be a compound of hafnium (Hf), zirconium (Zr), and oxygen (O).

The ferroelectric material layer may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn). The type of dopant included in the ferroelectric material layer may vary depending on which ferroelectric material is included in the ferroelectric material layer. When the ferroelectric material layer includes hafnium oxide, the dopant included in the ferroelectric material layer may include at least one of, for example, gadolinium (Gd), silicon (Si), zirconium (Zr), aluminum (Al), or yttrium (Y). When the dopant is aluminum (Al), the ferroelectric material layer may include 3 atomic% (at%) to 8 at% of aluminum. Here, a ratio of the dopant may be a ratio of aluminum to the sum of hafnium and aluminum. When the dopant is silicon (Si), the ferroelectric material layer may include 2 at% to 10 at% of silicon. When the dopant is yttrium (Y), the ferroelectric material layer may include 2 at% to 10 at% of yttrium. When the dopant is gadolinium (Gd), the ferroelectric material layer may include 1 at% to 7 at% of gadolinium. When the dopant is zirconium (Zr), the ferroelectric material layer may include 50 at% to 80 at% of zirconium.

The phase dielectric material layer may have phase dielectric characteristics. The phase dielectric material layer may include at least one of, for example, silicon oxide or a metal oxide having a high dielectric constant. The metal oxide included in the phase dielectric material layer may include at least one of, for example, hafnium oxide, zirconium oxide, or aluminum oxide, but is not limited thereto.

The ferroelectric material layer and the phase dielectric material layer may include the same material. The ferroelectric material layer may have ferroelectric characteristics, but the phase dielectric material layer may not have ferroelectric characteristics. For example, when the ferroelectric material layer and the phase dielectric material layer include hafnium oxide, a crystal structure of hafnium oxide included in the ferroelectric material layer is different from a crystal structure of hafnium oxide included in the phase dielectric material layer.

The ferroelectric material layer may have a thickness having ferroelectric characteristics. The thickness of the ferroelectric material layer may be, for example, about 0.5 nm to about 10 nm, but is not limited thereto. Because a critical thickness exhibiting ferroelectric characteristics may vary for each ferroelectric material, the thickness of the ferroelectric material layer may vary depending on the ferroelectric material.

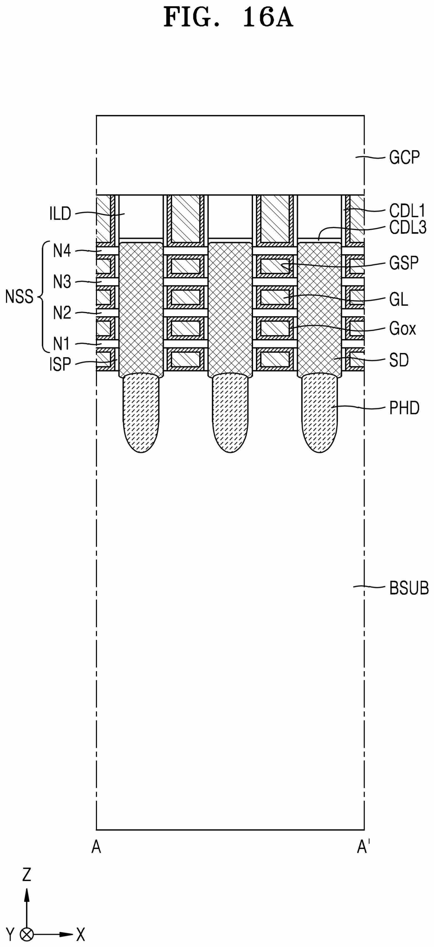

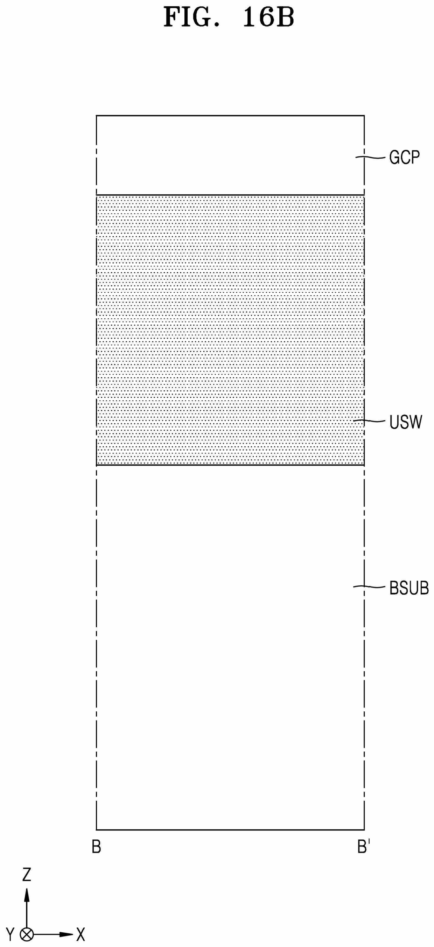

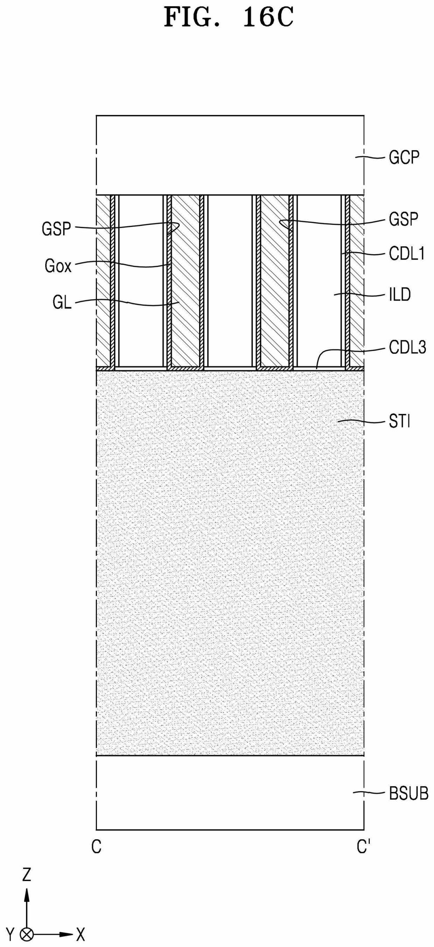

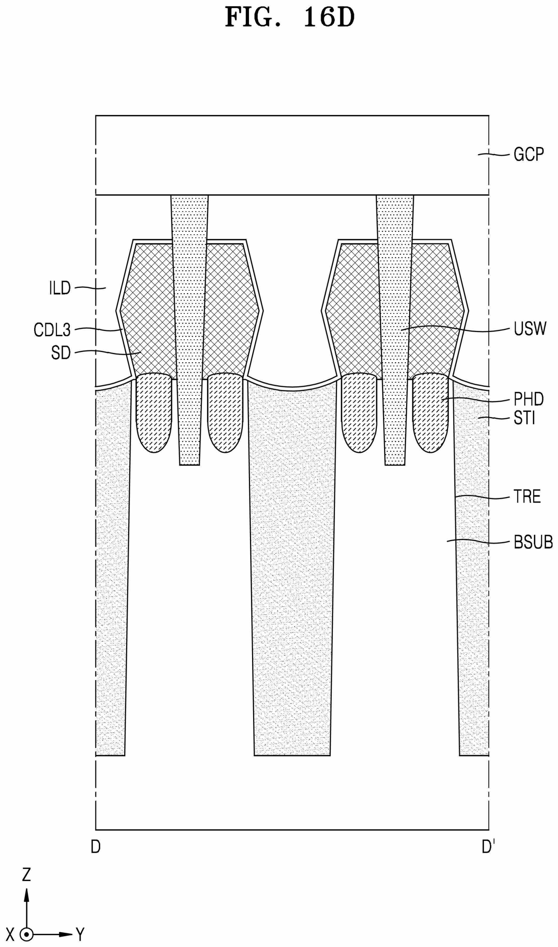

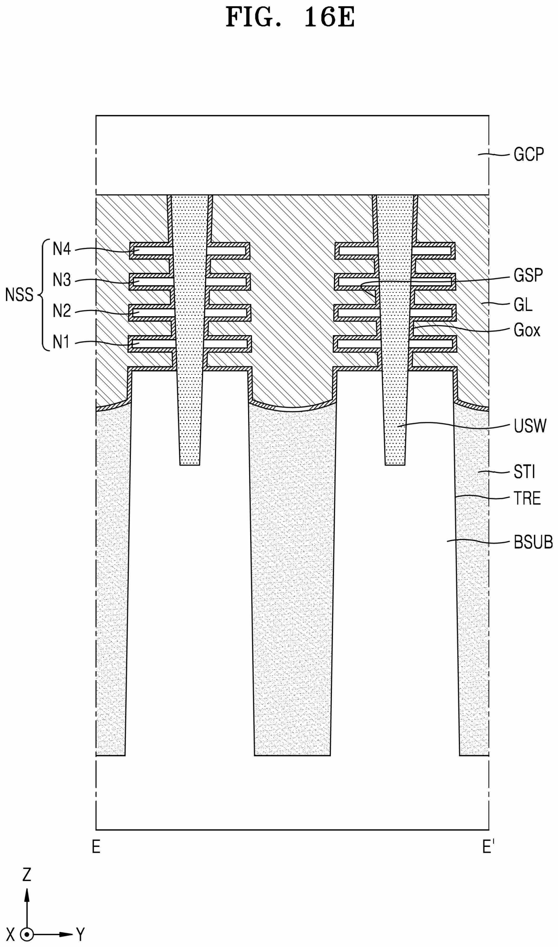

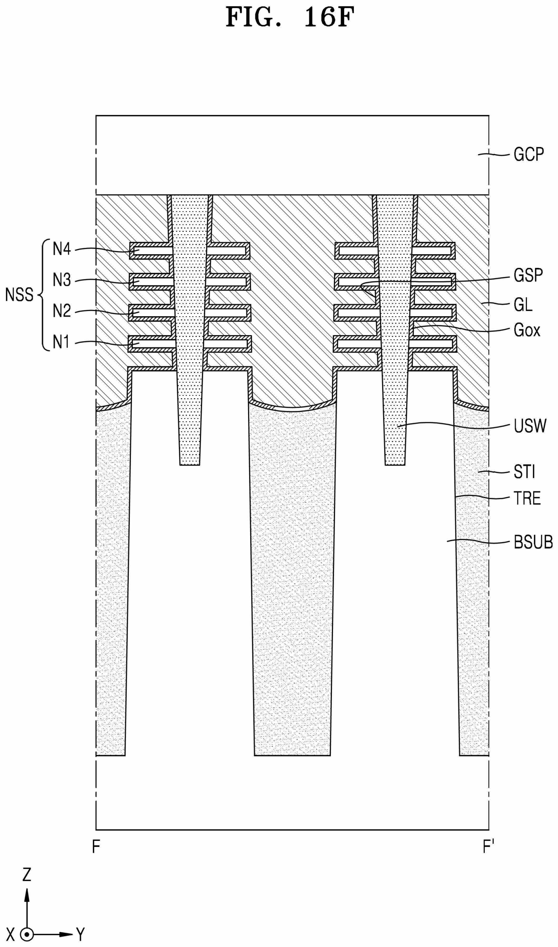

In FIGS. 16A, 16B, 16C, 16D, 16E, and 16F, a plurality of gate electrodes GL covering the plurality of gate insulating layers Gox and filling the plurality of gate spaces GSP are formed. The gate electrode GL may include a metal-containing layer for adjusting a work function and a metal-containing layer for gap-fill filling an upper space of the metal-containing layer for adjusting the work function. The metal-containing layer for adjusting the work function may include at least one metal selected from Ti, W, Ru, Nb, Mo, Hf, Ni, Co, Pt, Yb, Tb, Dy, Er, and Pd. In some implementations, the gate electrode GL may have a structure in which a metal nitride layer, a metal layer, a conductive capping layer, and a gap-fill metal layer are sequentially stacked. The metal nitride layer and the metal layer may include at least one metal selected from Ti, Ta, W, Ru, Nb, Mo, and Hf. The gap-fill metal layer may include a W layer or an Al layer. In some implementations, the gate electrode GL may include a stack structure of TiAlC/TiN/W, a stack structure of TiN/TaN/TiAlC/TiN/W, or a stack structure of TiN/TaN/TiN/TiAlC/TiN/W, but is not limited thereto.

In some implementations, the metal-containing layers for adjusting the work function of the gate electrodes GL in contact with the source/drain regions SD including impurities of different conductivity types may at least partially include different materials.

After forming the plurality of gate electrodes GL, a gate cover layer GCP covering the plurality of gate electrodes GL, the plurality of gate insulating layers Gox, the interlayer insulating layer ILD, and the plurality of upper sheet separation walls USW is formed. For example, the gate cover layer GCP may include silicon nitride.

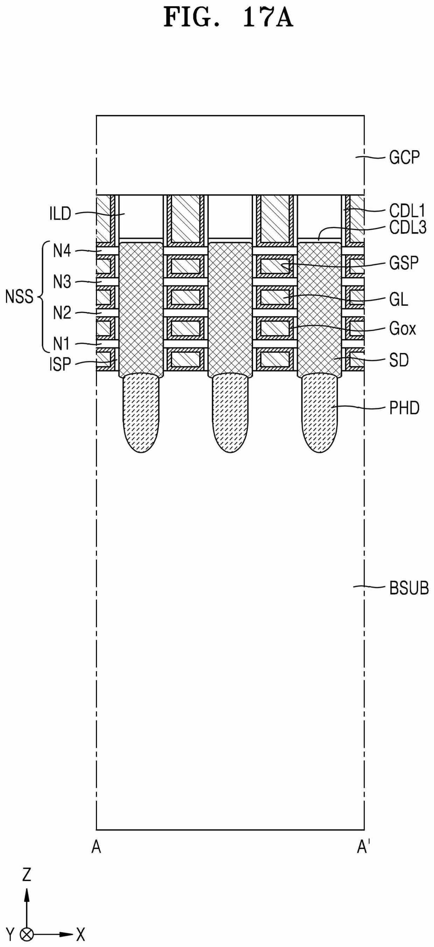

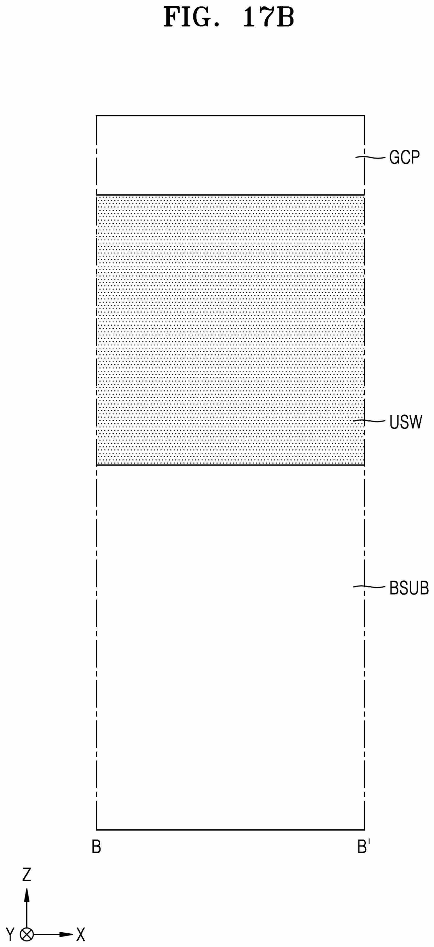

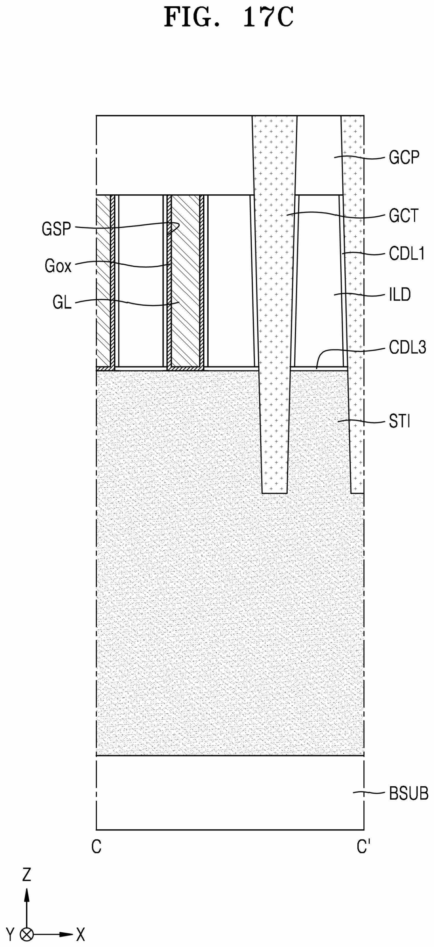

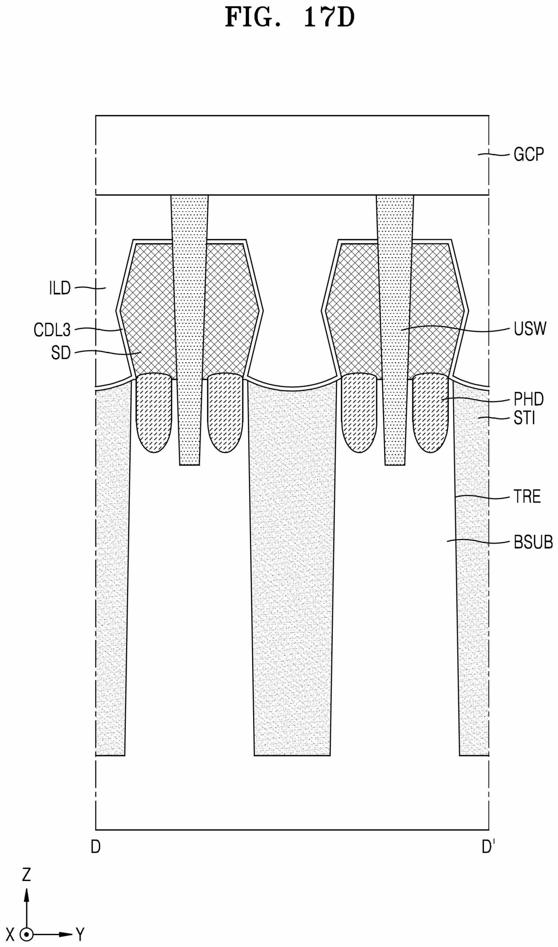

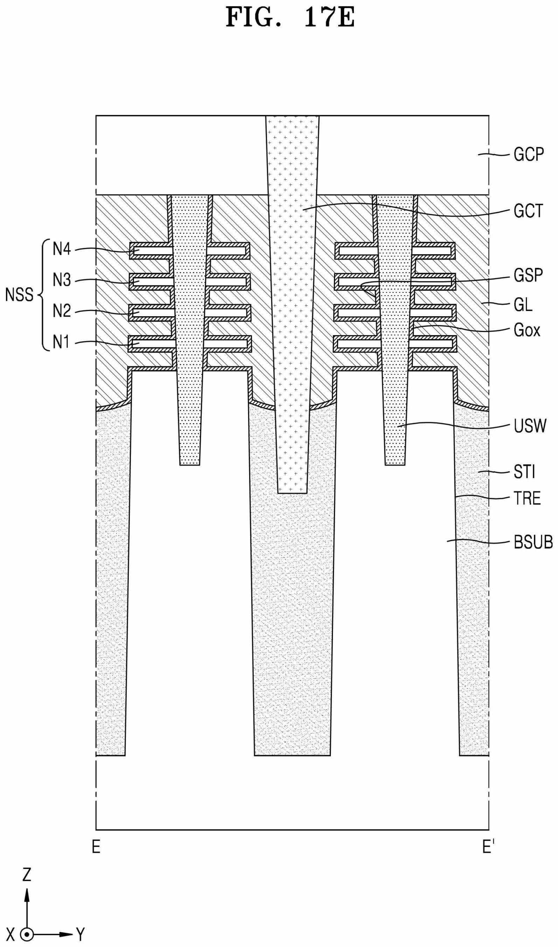

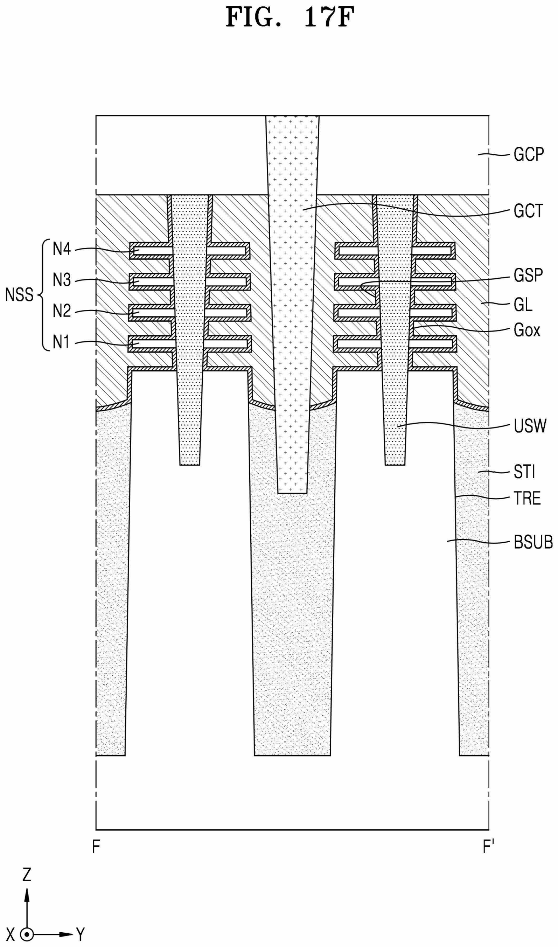

In FIGS. 17A, 17B, 17C, 17D, 17E, and 17F, at least one gate cut structure GCT penetrating the gate cover layer GCP and cutting at least some of a plurality of gate structures constituting the plurality of gate insulating layers Gox and the plurality of gate electrodes GL is formed. For example, the gate cut structure GCT may include silicon nitride. The gate cut structure GCT may penetrate the gate cover layer GCP, the gate electrode GL, and the gate insulating layer Gox and extend to the device separation layer STI. In some implementations, the gate cut structure GCT may penetrate the gate cover layer GCP, the gate electrode GL, and the gate insulating layer Gox and extend into the device separation layer STI. The gate cut structure GCT may cut at least some of the plurality of gate electrodes GL shown in FIGS. 16A, 16B, 16C, 16D, 16E, and 16F and be disposed between two separated gate electrodes GL spaced apart from each other in the second horizontal direction (Y direction).

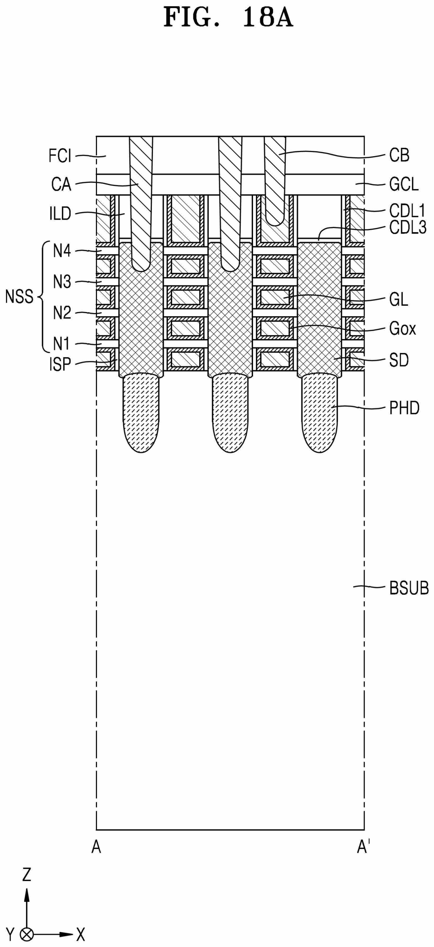

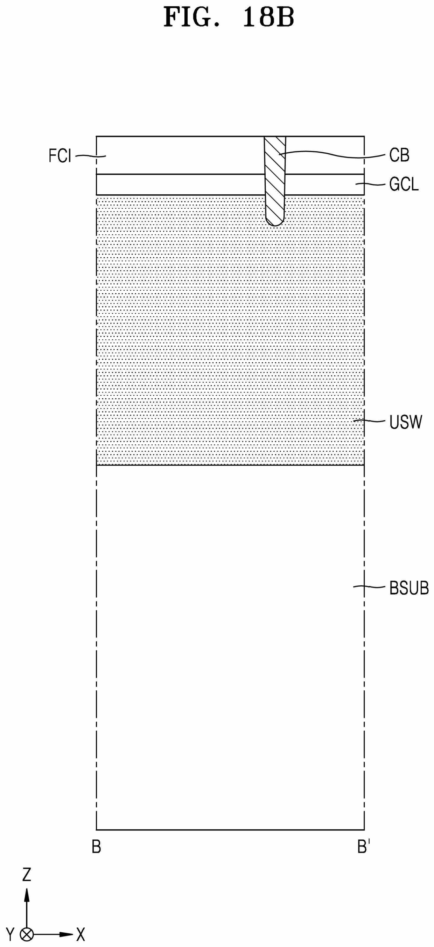

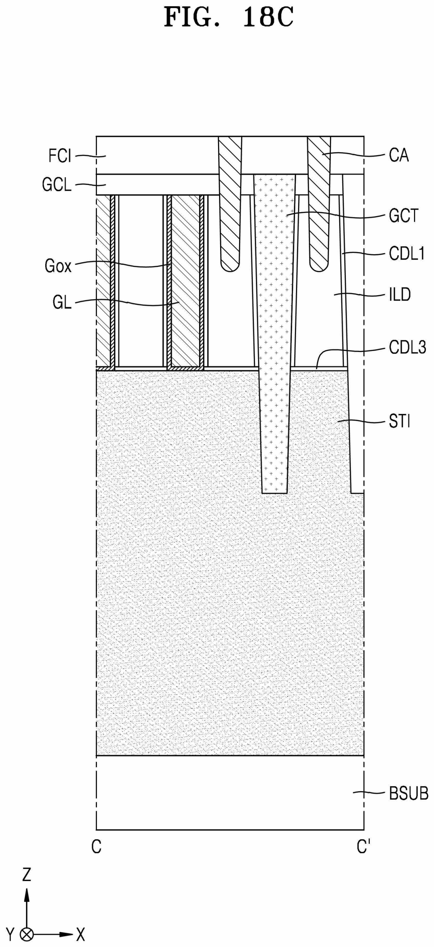

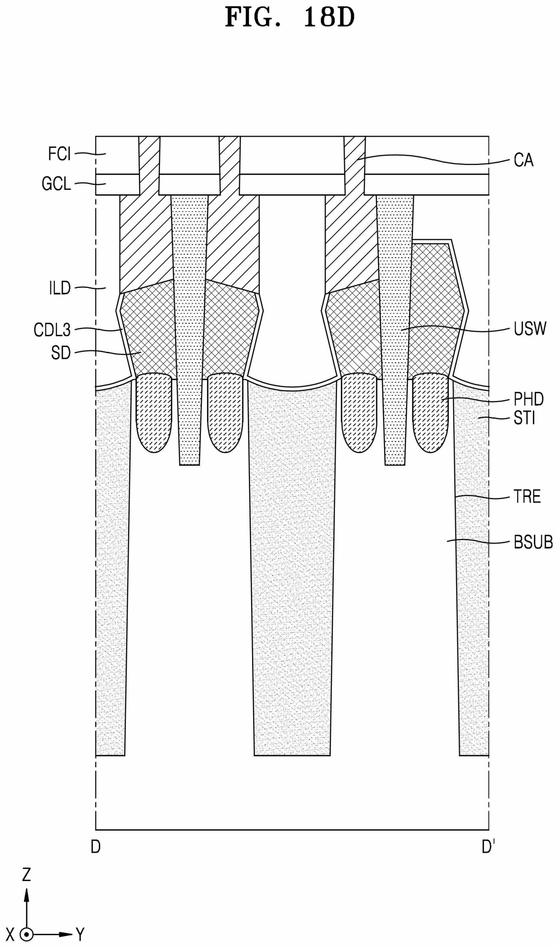

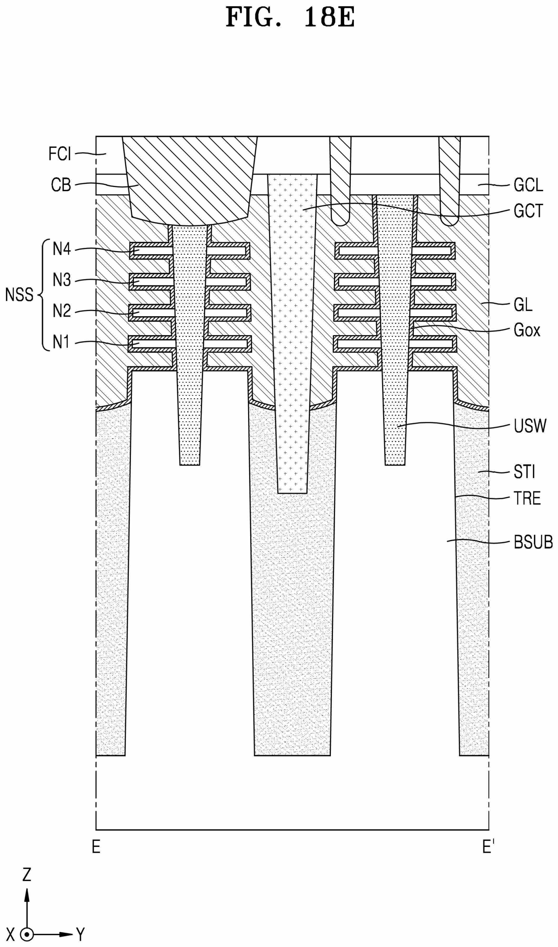

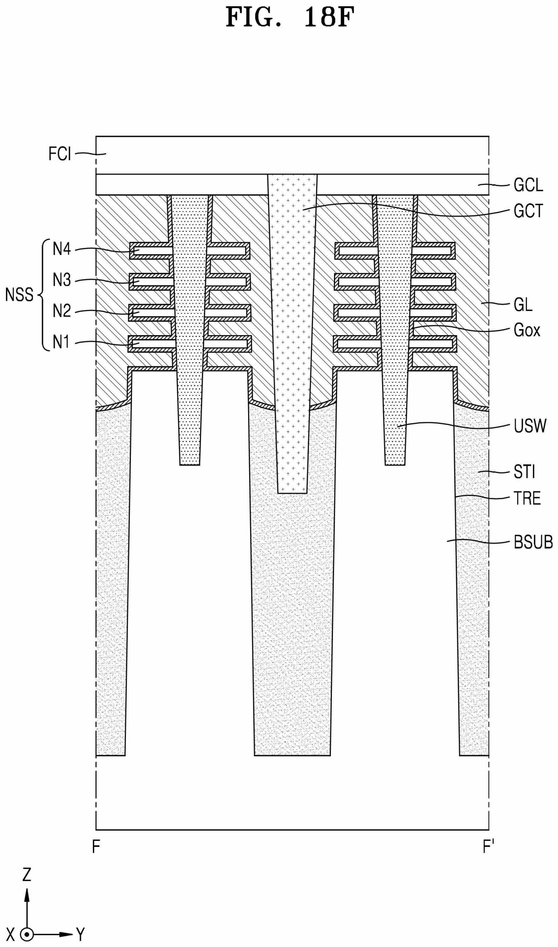

In FIGS. 17A, 17B, 17C, 17D, 17E, 17F, 18A, 18B, 18C, 18D, 18E, and 18F, after the gate cover layer GCP is removed, a gate capping layer GCL and a front insulating layer FCI covering the gate capping layer GCL are formed. For example, the gate capping layer GCL may include silicon nitride. In some implementations, the gate capping layer GCL may be a lower part of the gate cover layer GCP that remains after removing an upper part of the gate cover layer GCP. A plurality of first contacts CA penetrating the front insulating layer FCI, the gate capping layer GCL, and the interlayer insulating layer ILD and connected to the plurality of source/drain regions SD, and a plurality of second contacts CB penetrating the front insulating layer FCI and the gate capping layer GCL and connected to the plurality of gate electrodes GL are formed.

In some implementations, each of the plurality of first contacts CA may remove parts of each of the interlayer insulating layer ILD, the third insulating layer CDL3, and the source/drain region SD, before forming the gate capping layer GCL and the front insulating layer FCI, first form a lower portion filling a space from which the parts of each of the interlayer insulating layer ILD, the third insulating layer CDL3, and the source/drain region SD are removed, form the gate capping layer GCL and the front insulating layer FCI, penetrate the front insulating layer FCI and the gate capping layer GCL, and form an upper portion connected to the lower portion. Some of the plurality of second contacts CB may be formed to be connected to only one of the two gate electrodes GL spaced apart with the upper sheet separation wall USW disposed therebetween, and the other second contacts CB may be formed to be commonly connected to the two gate electrodes GL spaced apart with the upper sheet separation wall USW disposed therebetween.

The front insulating layer FCI may include BPSG, PSG, BSG, USG, TEOS, HDP, TOSZ, a ULK layer, or a combination thereof. Each of the plurality of first contacts CA and the plurality of second contacts CB may include metal, conductive metal nitride, or a combination thereof. For example, each of the plurality of first contacts CA and the plurality of second contacts CB may include a metal material such as W, Al, Cu, Ti, Ta, Ru, Mn, or Co, metal nitride, such as TiN, TaN, CoN, or WN, or an alloy, such as Cobalt Tungsten Phosphide (CoWP), Cobalt Tungsten Boron (CoWB), and Cobalt Tungsten Boron Phosphide (CoWBP). In some implementations, each of the first contact CA and the second contact CB may have a bar shape, a circle shape, an ellipse shape, or a polygonal shape in a plan view and may have a vertical column shape extending in the vertical direction (Z direction).

In some implementations, a metal silicide layer may be disposed between each of the plurality of source/drain regions SD and each of the plurality of first contacts CA. For example, the metal silicide layer may include tungsten silicide (WSi), titanium silicide (TiSi), cobalt silicide (CoSi), or nickel silicide (NiSi).

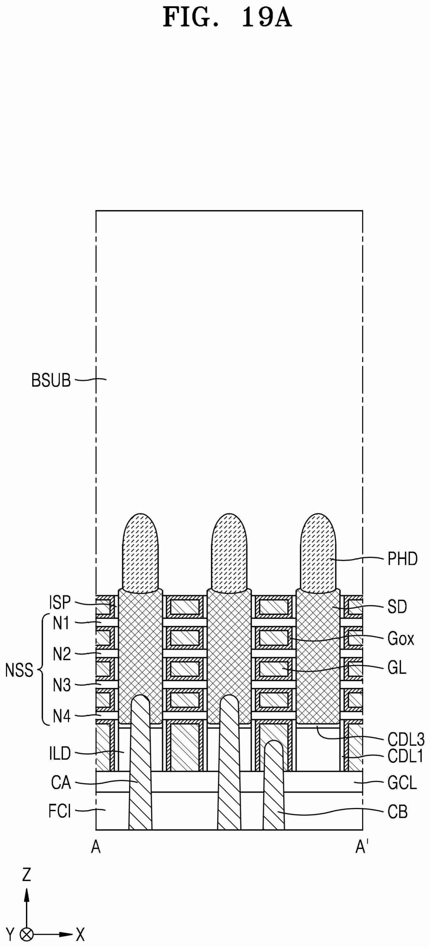

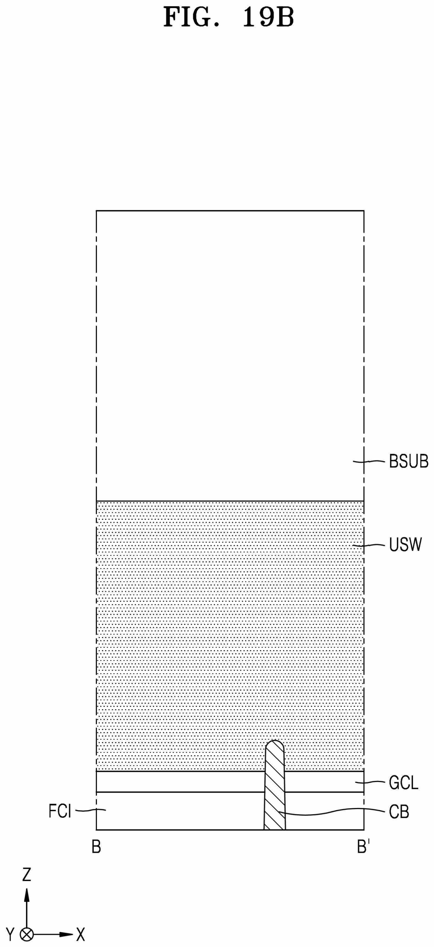

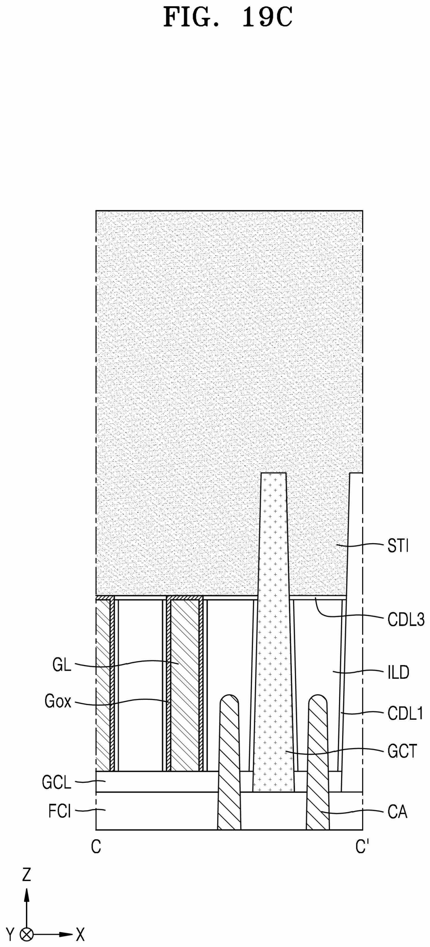

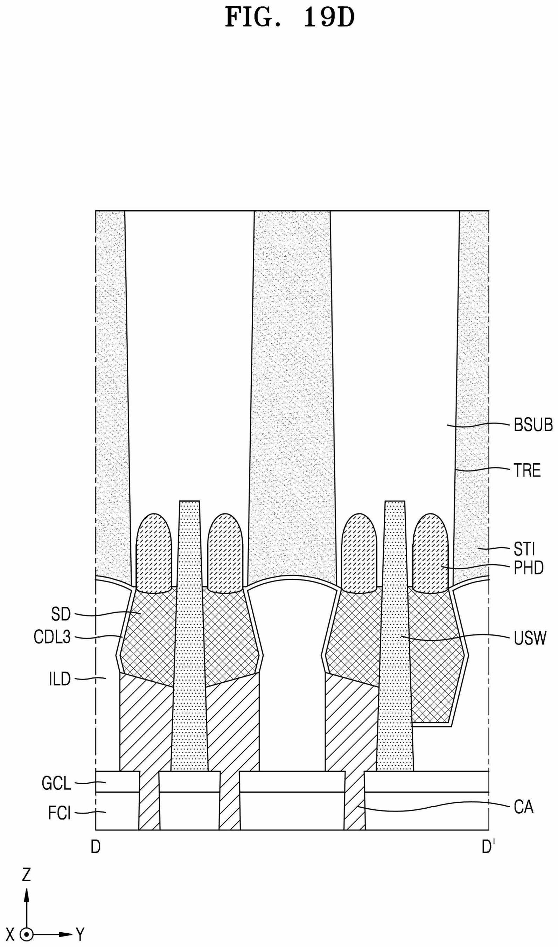

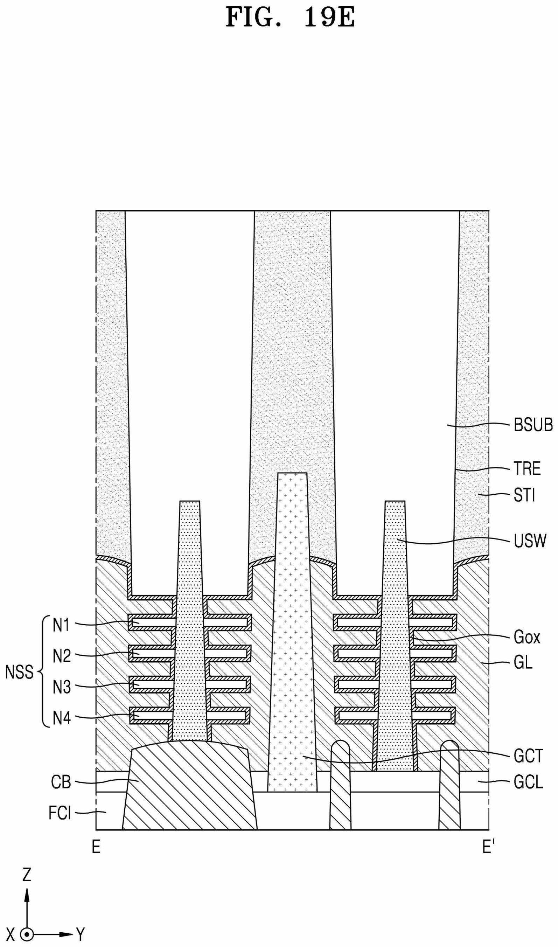

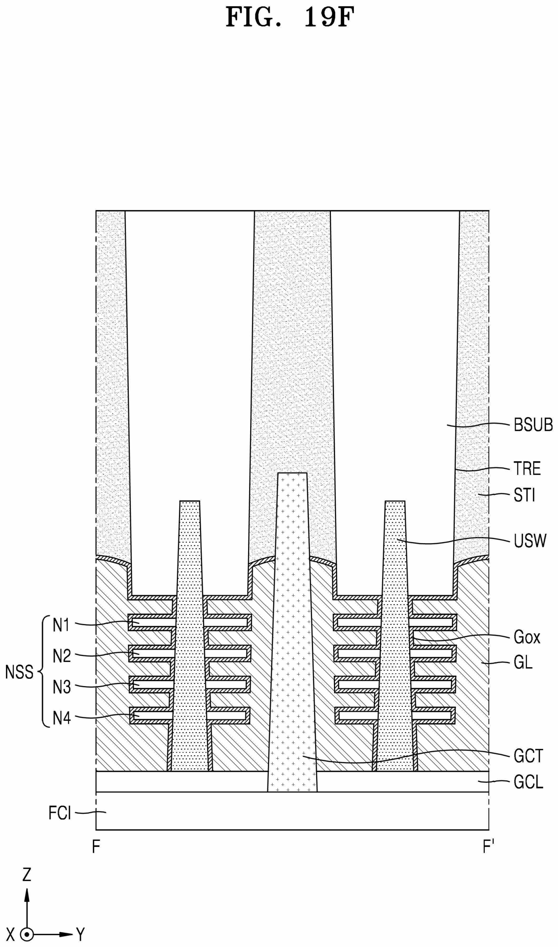

In FIGS. 19A, 19B, 19C, 19D, 19E, and 19F, the base substrate layer BSUB faces upward and the front insulating layer FCI faces downward by inverting the resultant of FIGS. 18A, 18B, 18C, 18D, 18E, and 18F. The device separation layer STI is exposed by removing a part of the upper side of the base substrate layer BSUB, which is a part of the lower side of the base substrate layer BSUB in the resultant of FIGS. 18A, 18B, 18C, 18D, 18E, and 18F. For example, the part of the upper side of the base substrate layer BSUB may be removed by performing a grinding process and/or a CMP process so that the device separation layer STI is exposed.

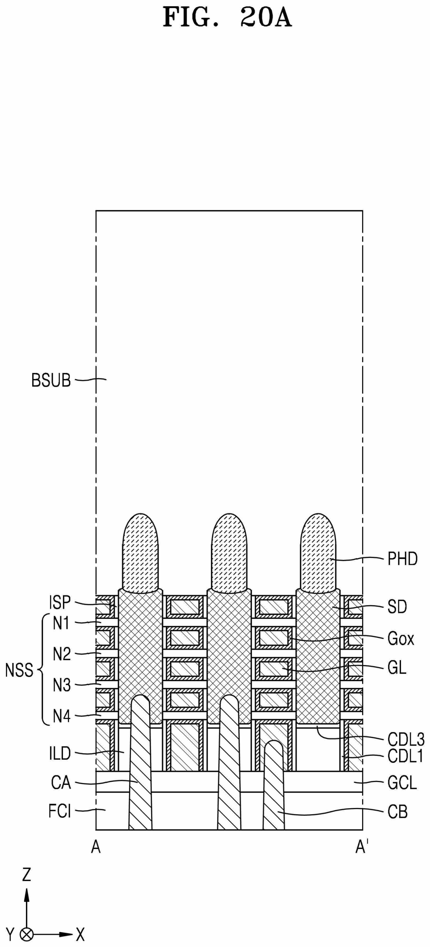

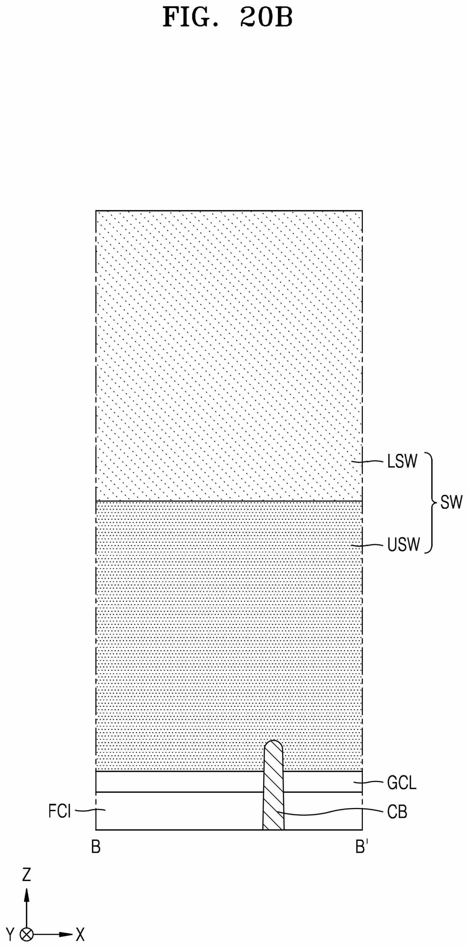

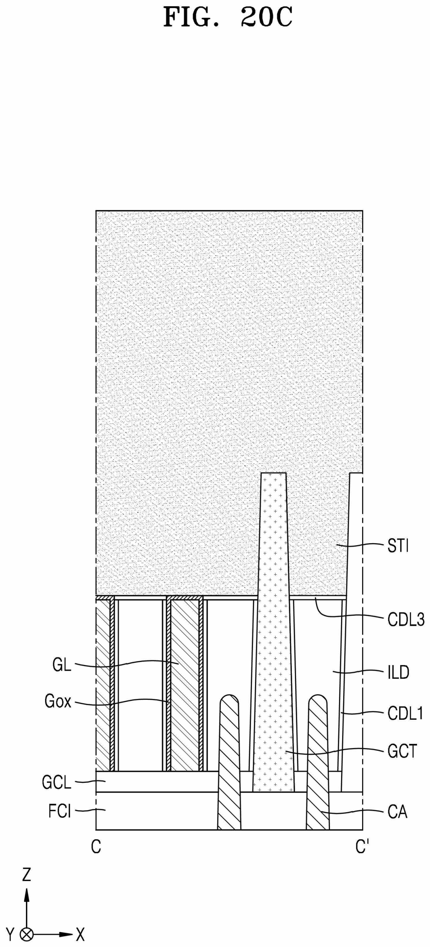

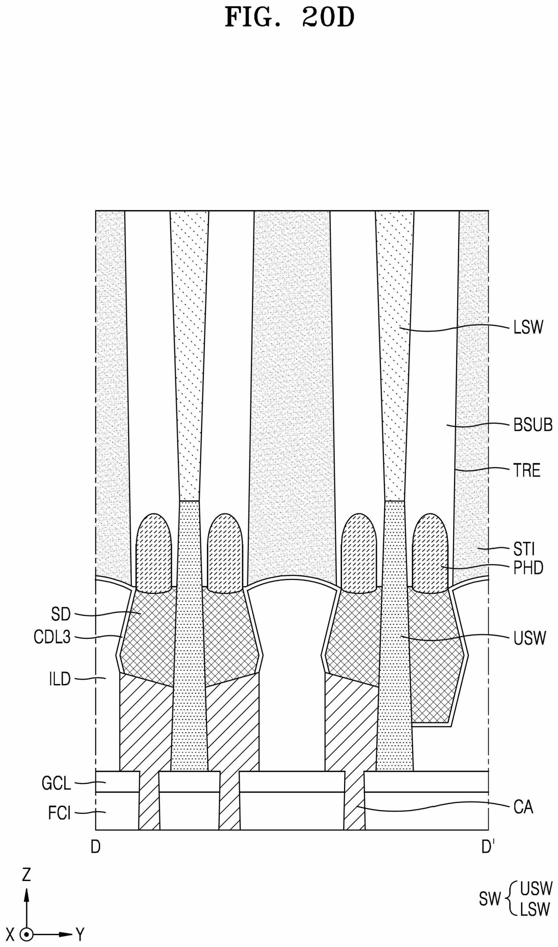

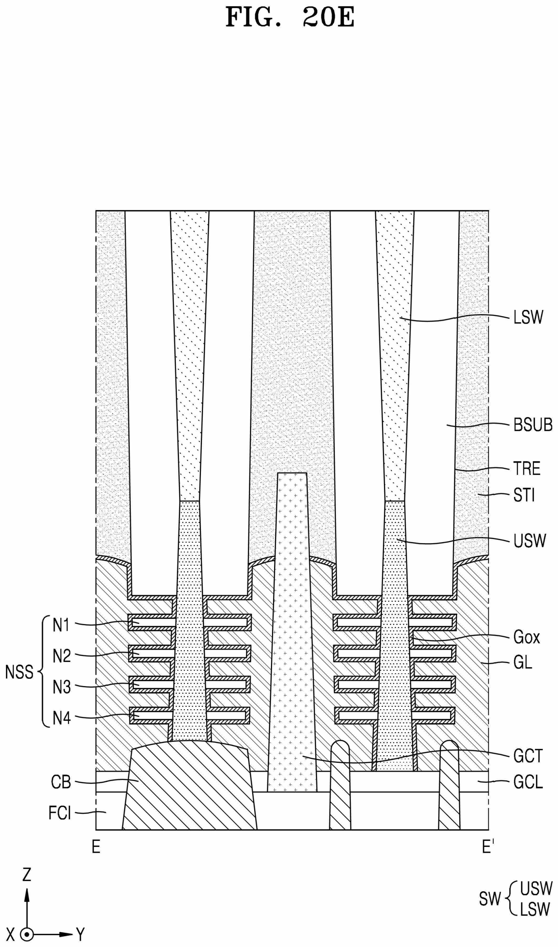

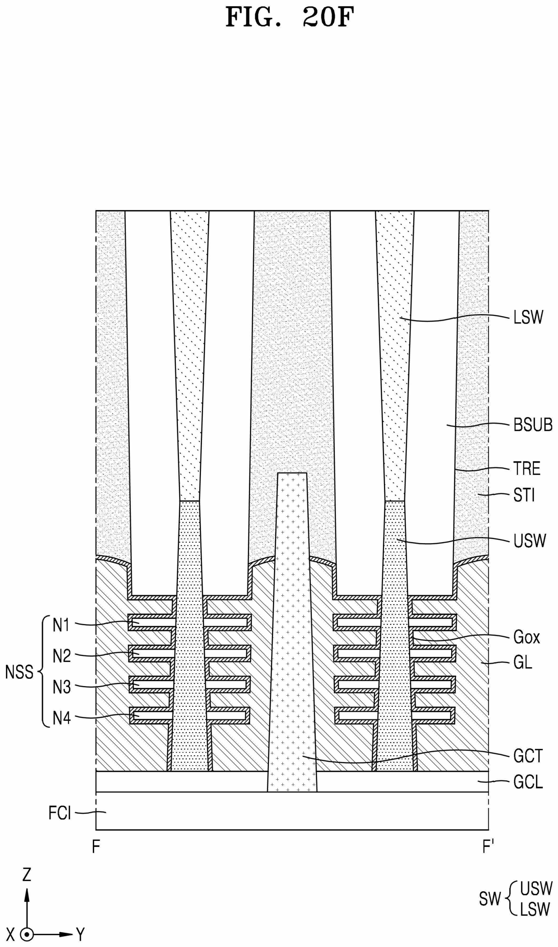

In FIGS. 20A, 20B, 20C, 20D, 20E, and 20F, a plurality of lower sheet separation walls LSW penetrating the base substrate layer BSUB and connected to the plurality of upper sheet separation walls USW are formed. For example, after forming a plurality of recesses in which the plurality of upper sheet separation walls USW are exposed by removing parts of the base substrate layer BSUB, a preliminary lower separation material layer filling the plurality of recesses and covering the base substrate layer BSUB and the plurality of device separation layers STI may be formed, and the plurality of lower sheet separation walls LSW may be formed by removing a part of the preliminary lower separation material layer covering the base substrate layer BSUB and the plurality of device separation layers STI. In some implementations, the part of the preliminary lower separation material layer may be removed by performing a CMP process so that the base substrate layer BSUB and the plurality of device separation layers STI are exposed.

Each of the plurality of lower sheet separation walls LSW may include nitride. For example, each of the plurality of lower sheet separation walls LSW may include silicon nitride. The plurality of lower sheet separation walls LSW may be formed to extend in the first horizontal direction (X direction) and be spaced apart from each other in the second horizontal direction (Y direction). The plurality of lower sheet separation walls LSW may overlap the plurality of upper sheet separation walls USW respectively corresponding thereto in the vertical direction (Z direction). Each of the plurality of lower sheet separation walls LSW may be formed to extend from an upper side to a lower side and have a tapered shape with a horizontal width narrowing in the second horizontal direction (Y direction). For example, each of the plurality of lower sheet separation walls LSW may be formed to extend toward each of the plurality of upper sheet separation walls USW corresponding thereto and have the tapered shape with the horizontal width narrowing in the second horizontal direction (Y direction), and each of the plurality of upper sheet separation walls USW may be formed to extend toward each of the plurality of lower sheet separation walls LSW corresponding thereto and have the tapered shape with the horizontal width narrowing in the second horizontal direction (Y direction). The plurality of lower sheet separation walls LSW and the plurality of upper sheet separation walls USW corresponding to each other may constitute a plurality of sheet separation walls SW. The plurality of sheet separation walls SW may extend in the first horizontal direction (X direction) and may be spaced apart from each other in the second horizontal direction (Y direction).

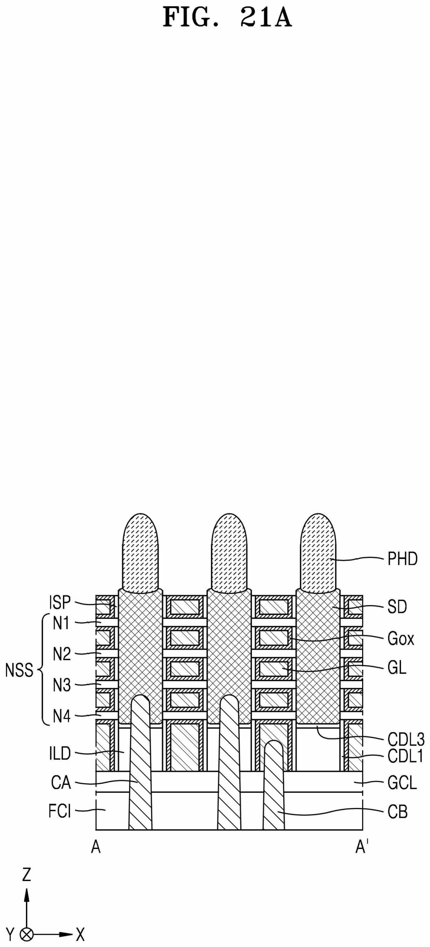

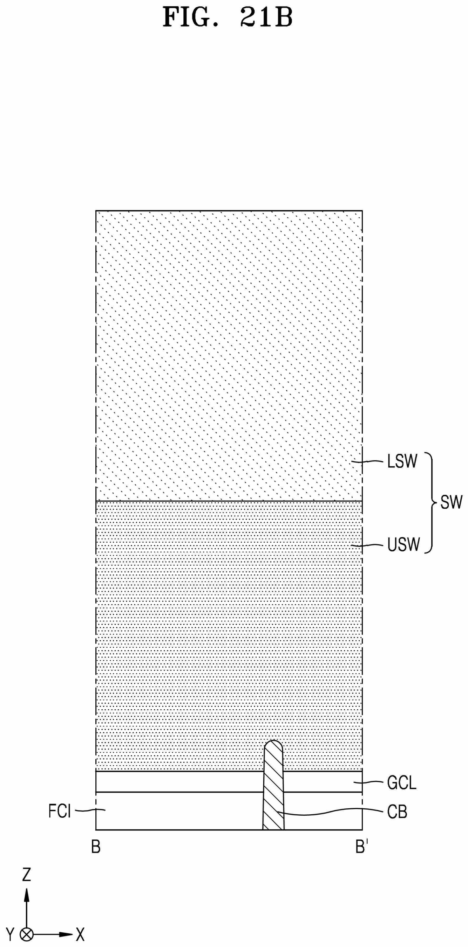

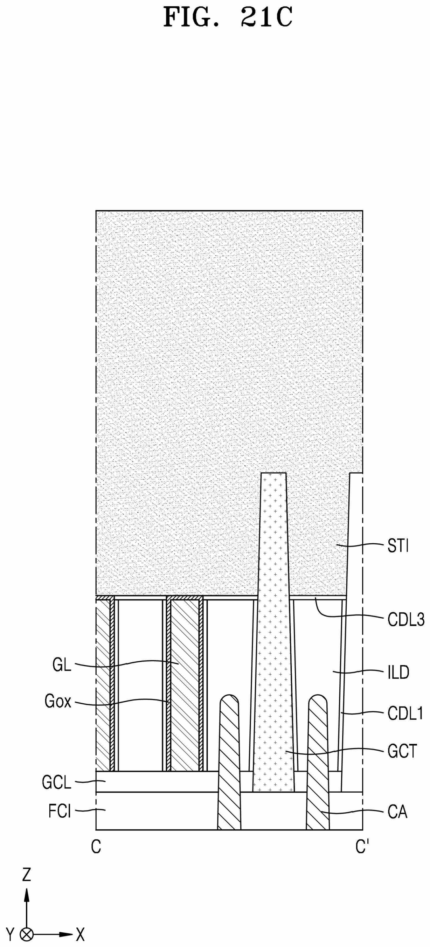

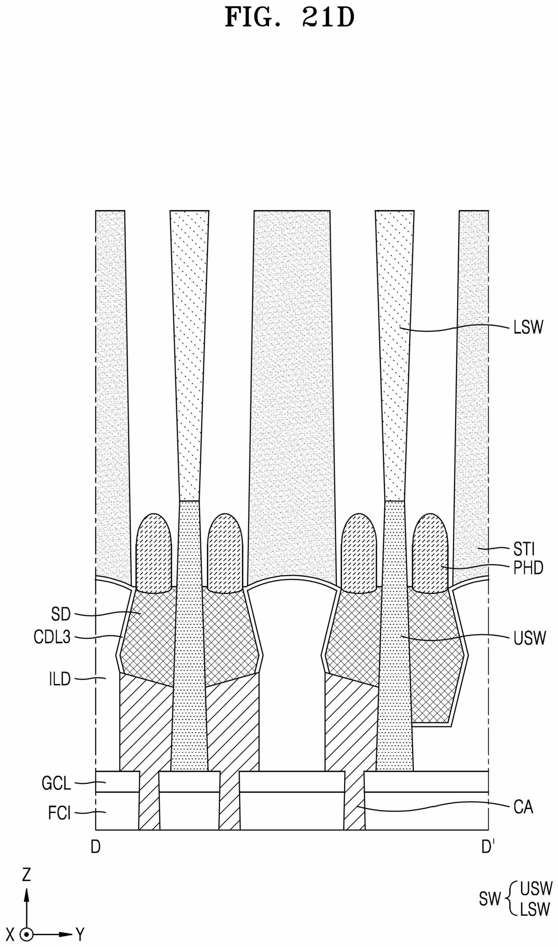

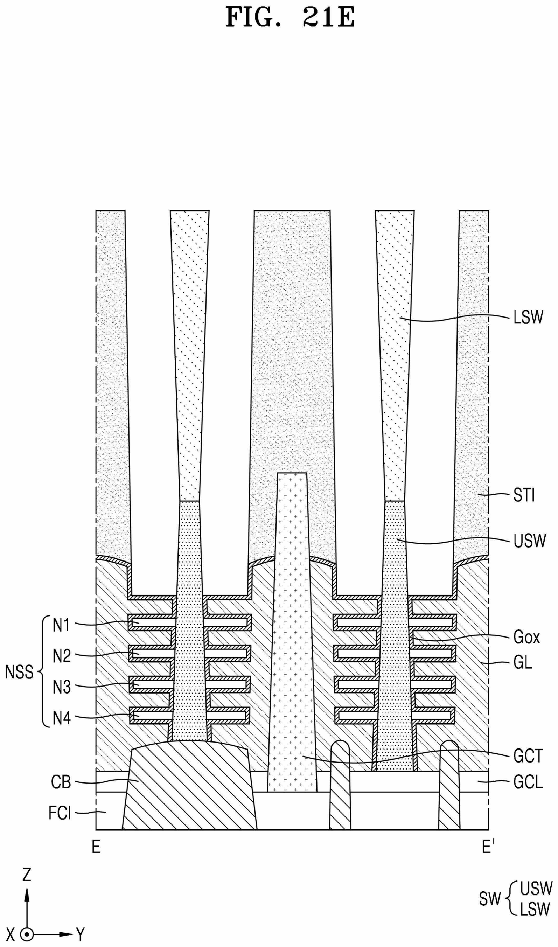

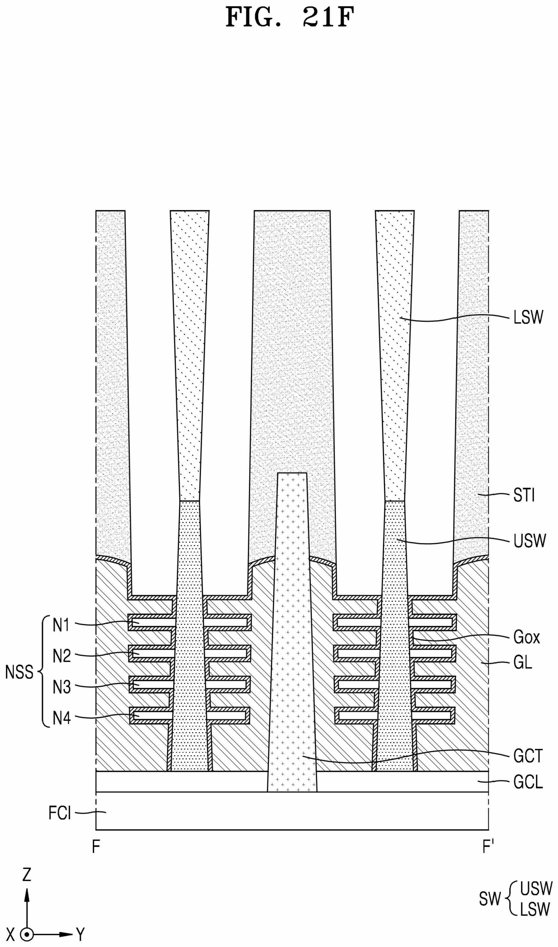

In FIGS. 20A, 20B, 20C, 20D, 20E, 20F, 21A, 21B, 21C, 21D, 21E, and 21F, the plurality of place holder structures PHD are exposed by removing the base substrate layer BSUB. For example, the base substrate layer BSUB may be removed by performing a wet etching process.

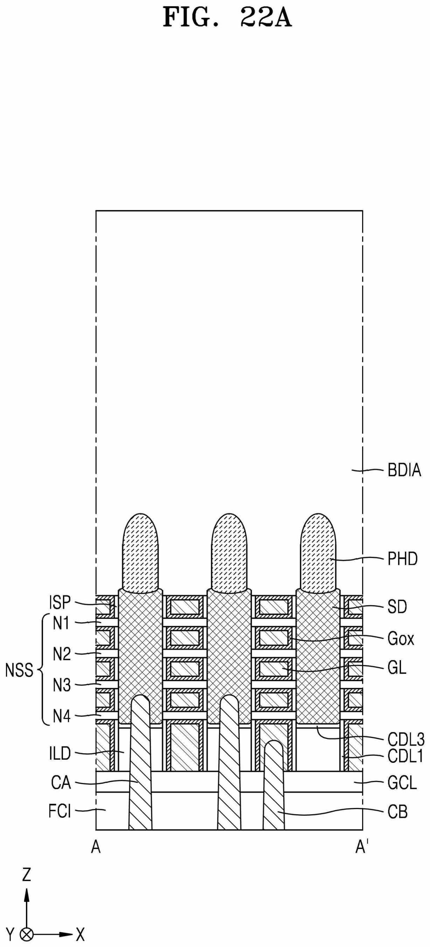

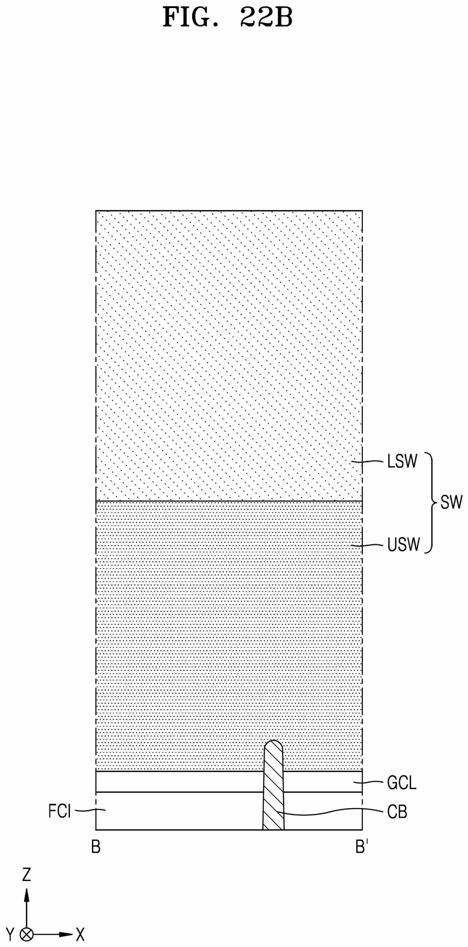

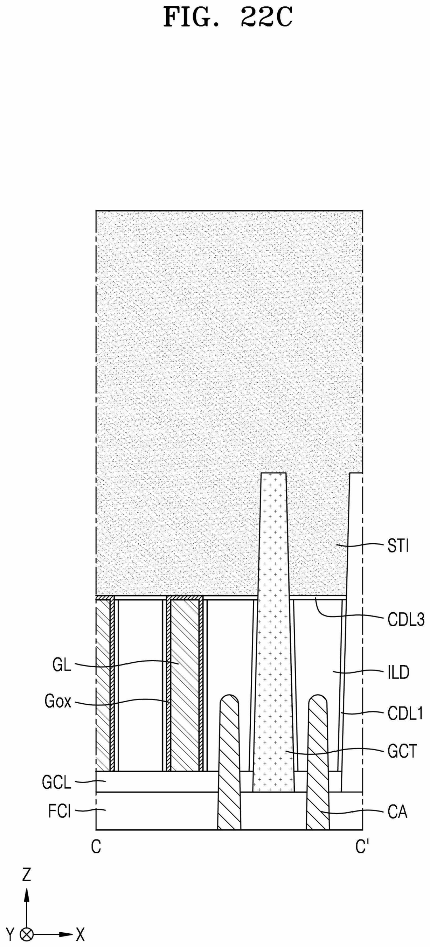

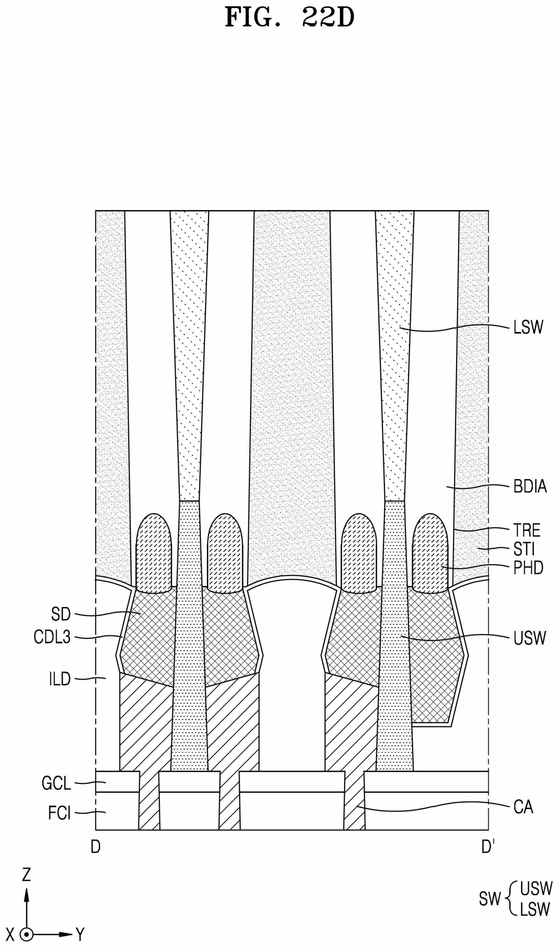

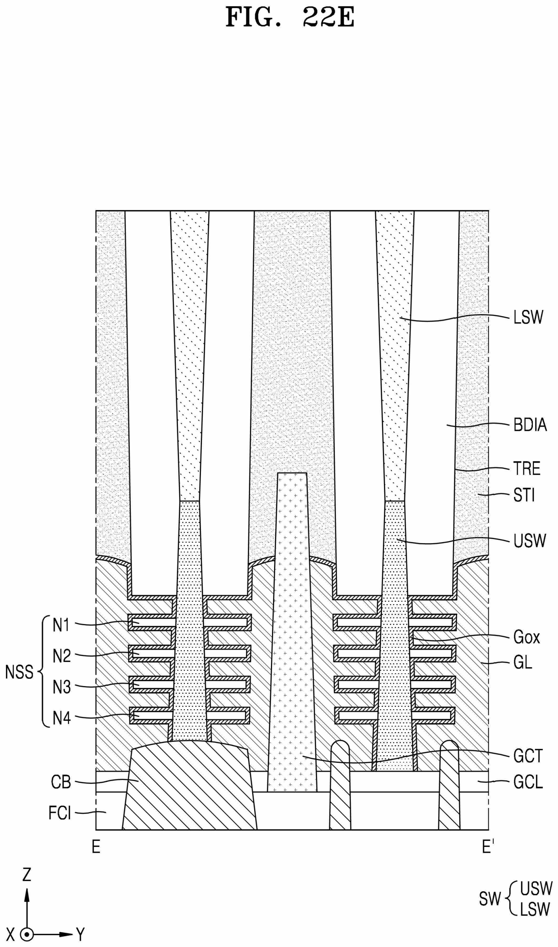

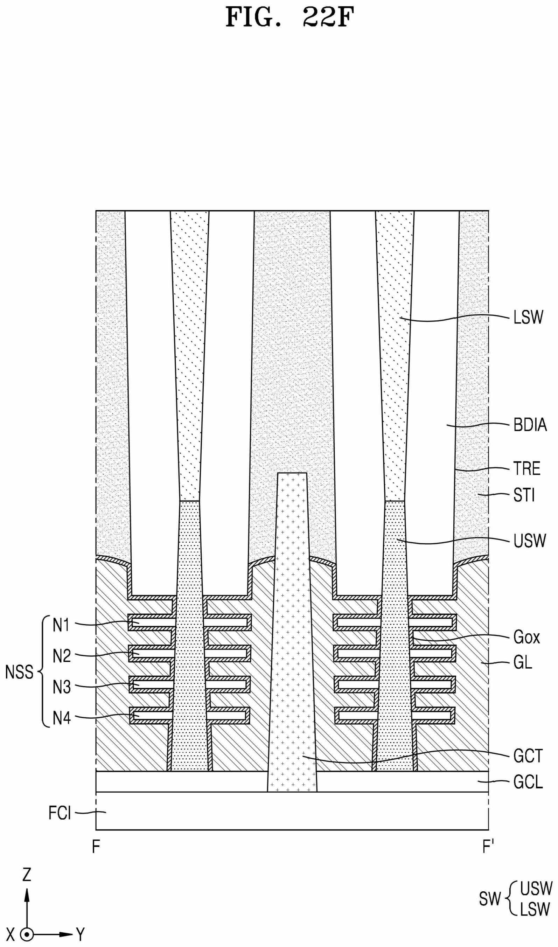

In FIGS. 22A, 22B, 22C, 22D, 22E, and 22F, a first backside insulating layer BDIA filling a space from which the base substrate layer BSUB is removed described with reference to FIGS. 20A, 20B, 20C, 20D, 20E, 20F, 21A, 21B, 21C, 21D, 21E, and 21F is formed. The first backside insulating layer BDIA may be formed to surround the plurality of sheet separation walls SW and the plurality of place holder structures PHD and fill spaces between the plurality of device separation layers STI. The first backside insulating layer BDIA may include BPSG, PSG, BSG, USG, TEOS, HDP, TOSZ, a ULK layer, or a combination thereof. The first backside insulating layer BDIA may be formed by forming a first backside insulating material layer filling a space from which the base substrate layer BSUB is removed and covering the plurality of device separation layers STI, and then removing a part of the first backside insulating material layer through a CMP process so that the plurality of device separation layers STI and the plurality of lower sheet separation walls LSW are exposed.

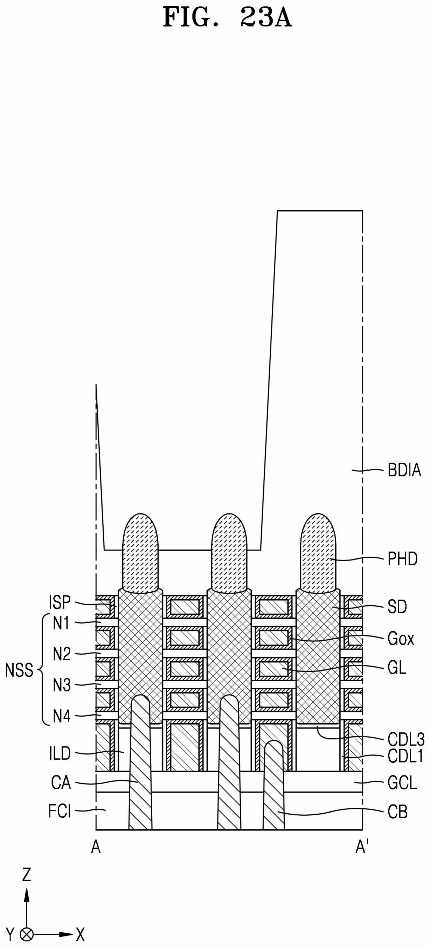

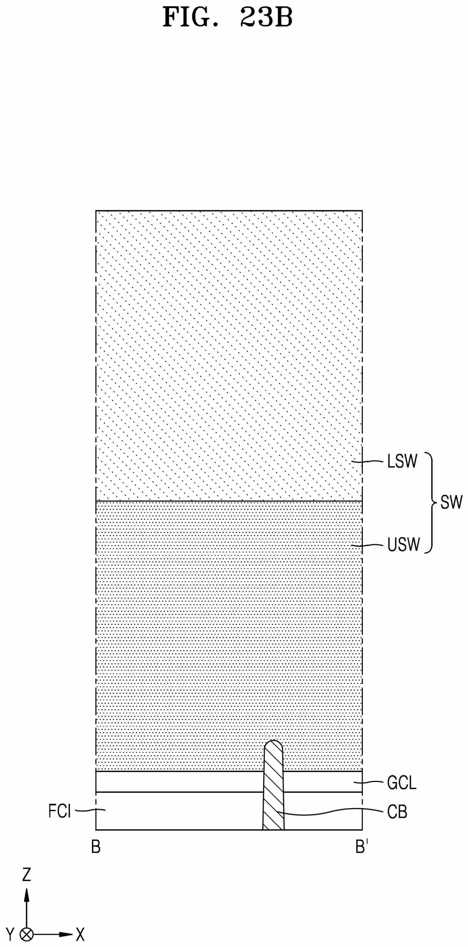

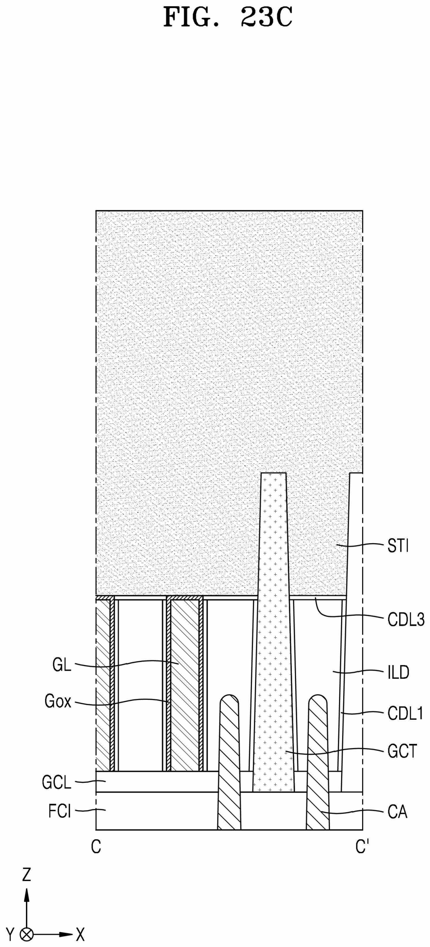

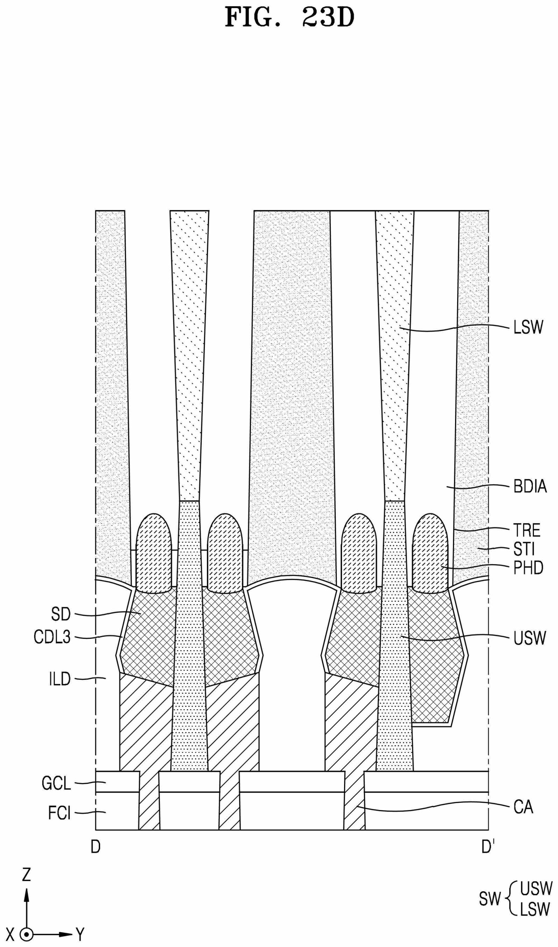

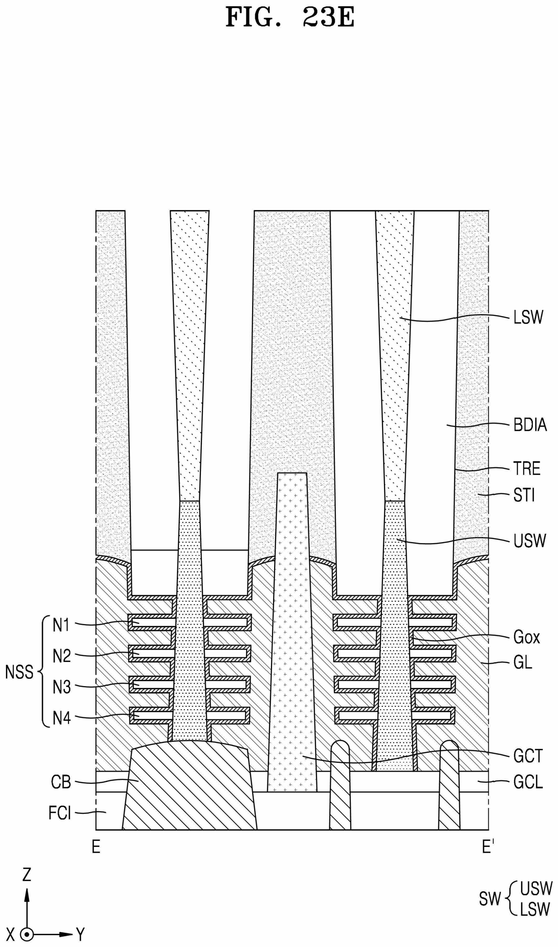

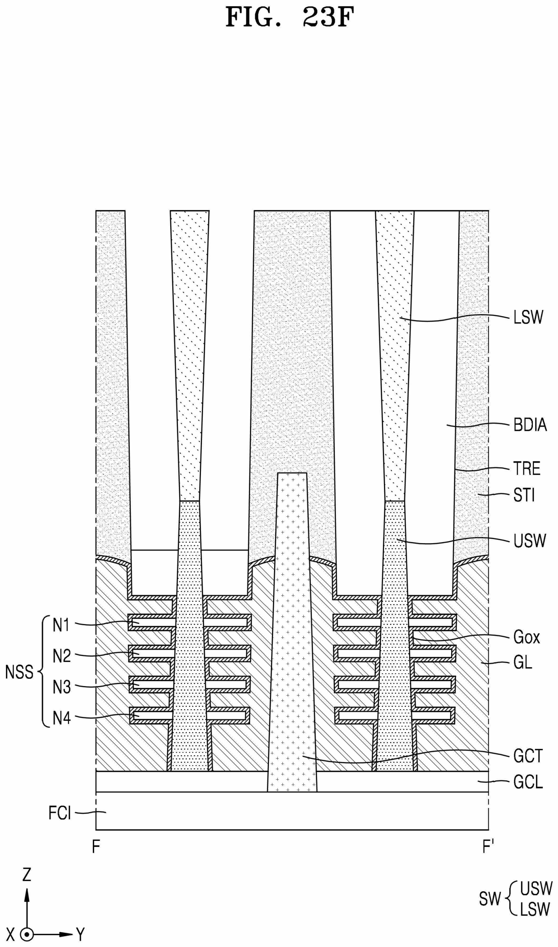

In FIGS. 23A, 23B, 23C, 23D, 23E, and 23F, at least some of the plurality of place holder structures PHD are exposed by removing a part of the first backside insulating layer BDIA. In some implementations, at least some of the plurality of sheet separation walls SW adjacent to at least some of the plurality of place holder structures PHD exposed by removing the part of the first backside insulating layer BDIA may also be exposed. In some implementations, a part of the first backside insulating layer BDIA may be removed so as not to expose lower portions of at least some of the plurality of place holder structures PHD but expose upper portions thereof. For example, the lower portions of at least some of the plurality of place holder structures PHD of which upper portions are exposed may be surrounded by the first backside insulating layer BDIA.

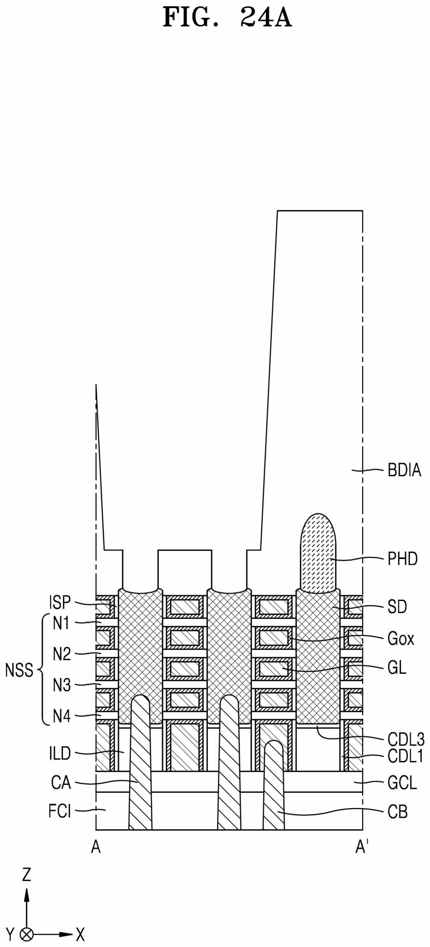

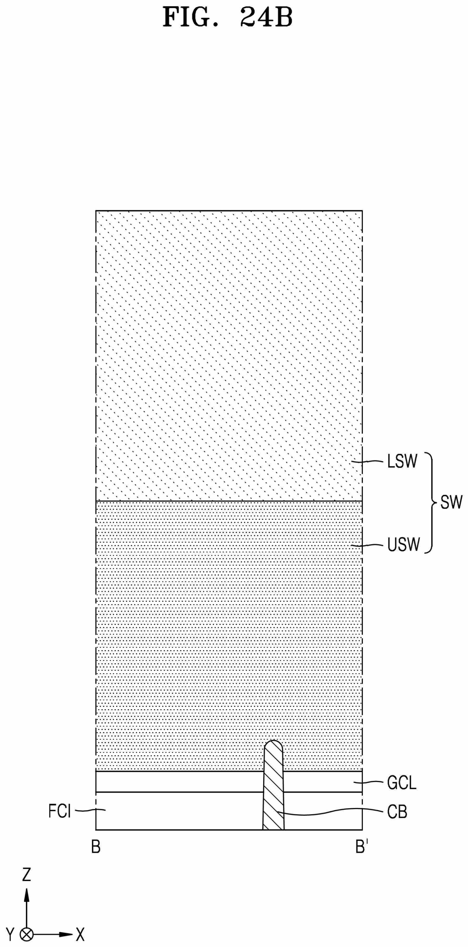

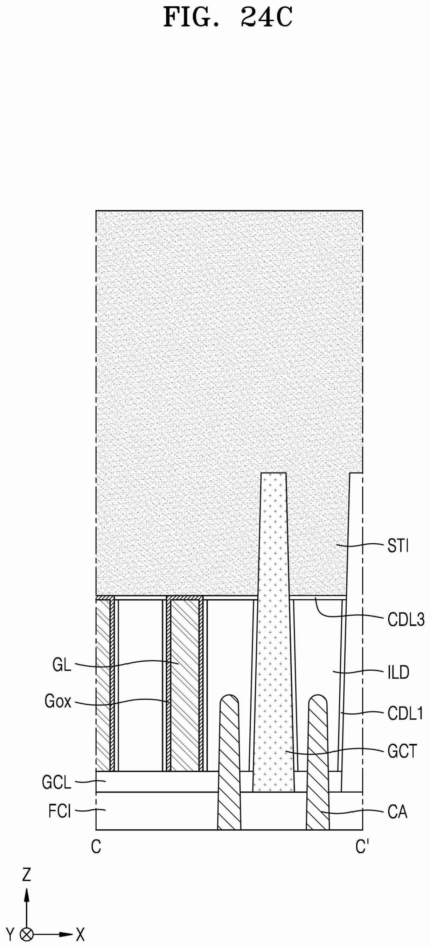

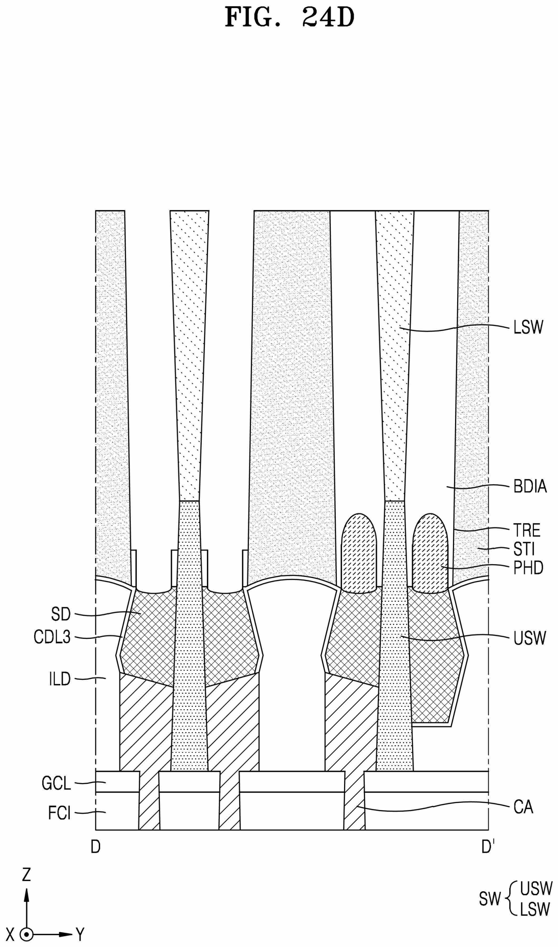

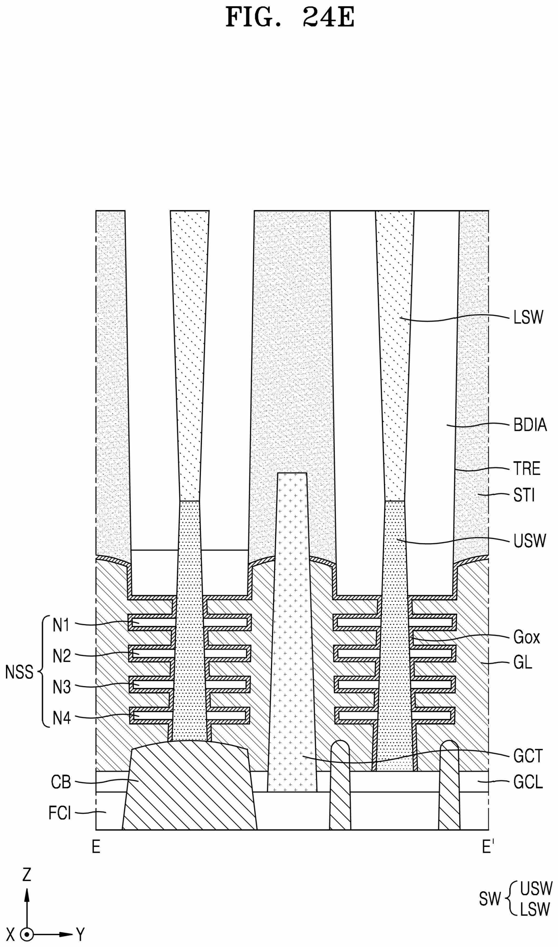

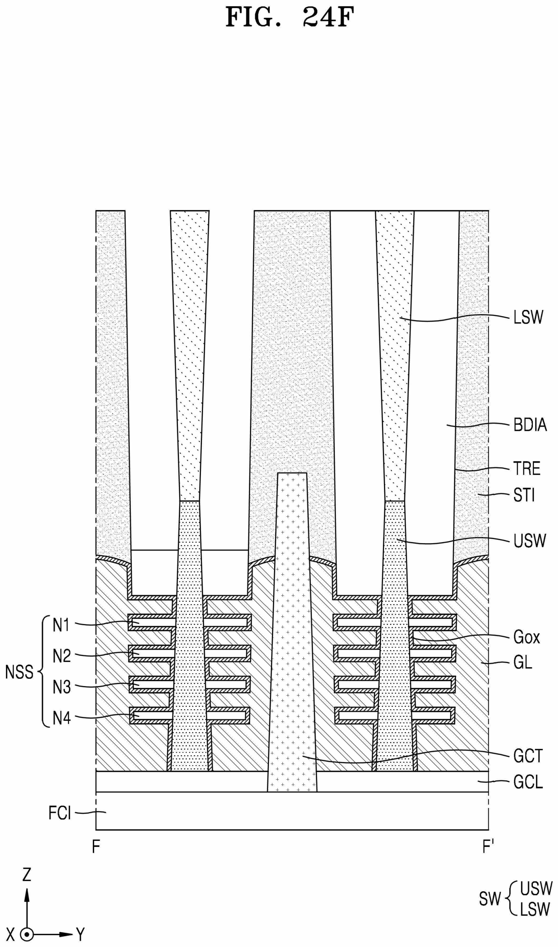

In FIGS. 24A, 24B, 24C, 24D, 24E, and 24F, some of the plurality of source/drain regions SD connected to at least some of the plurality of place holder structures PHD are exposed by removing at least some of the plurality of place holder structures PHD exposed by removing a part of the first backside insulating layer BDIA.

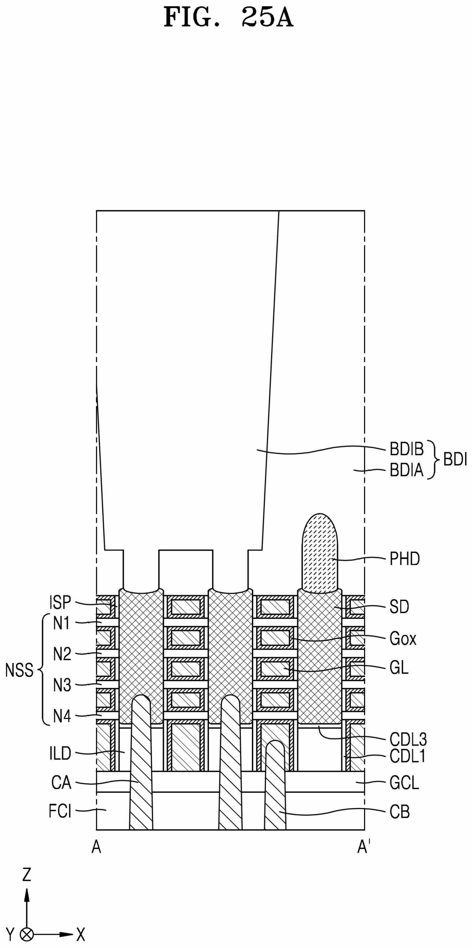

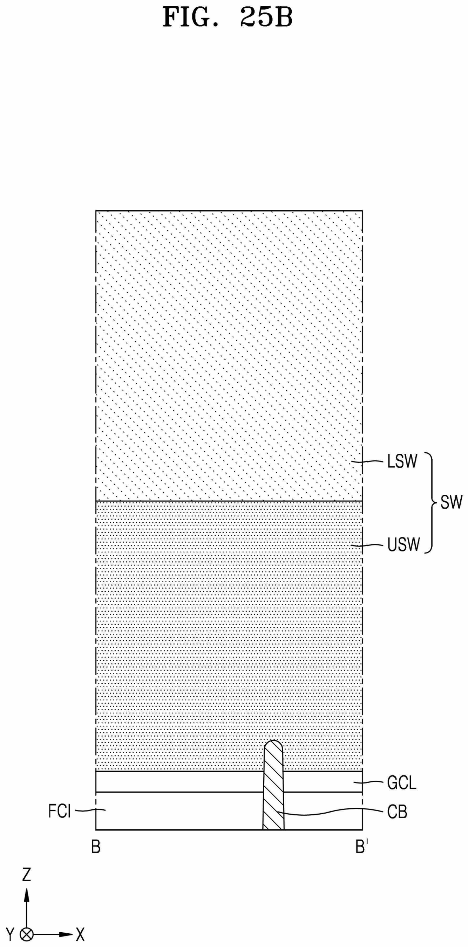

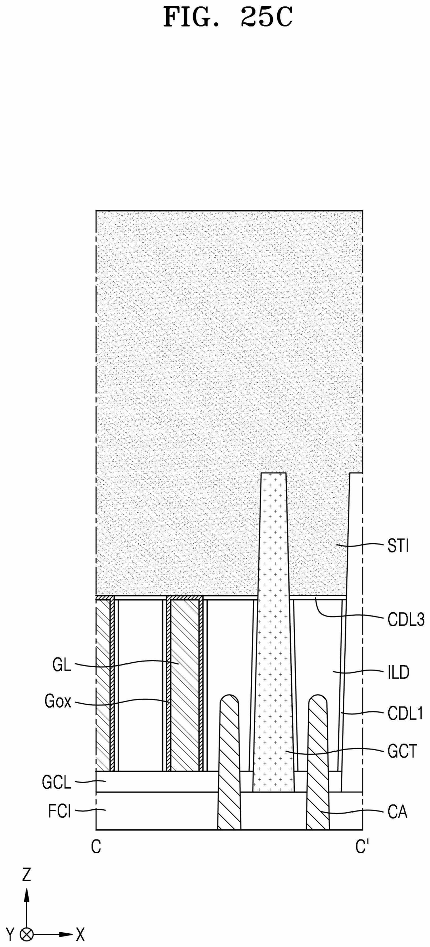

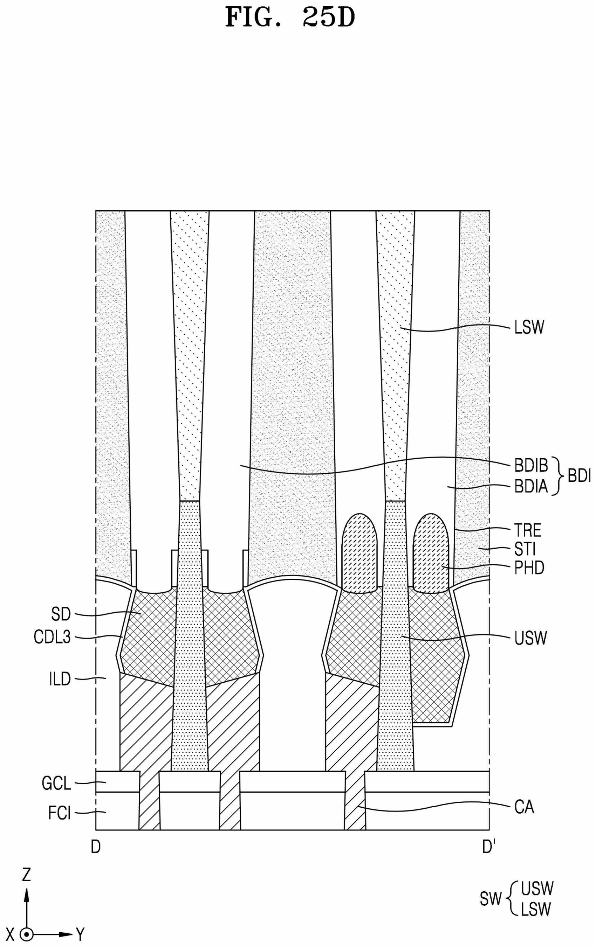

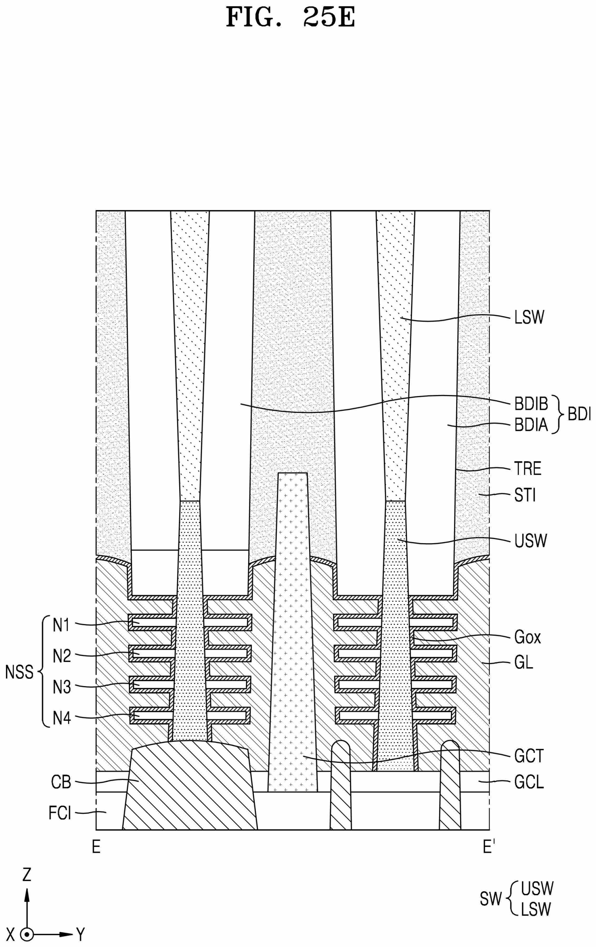

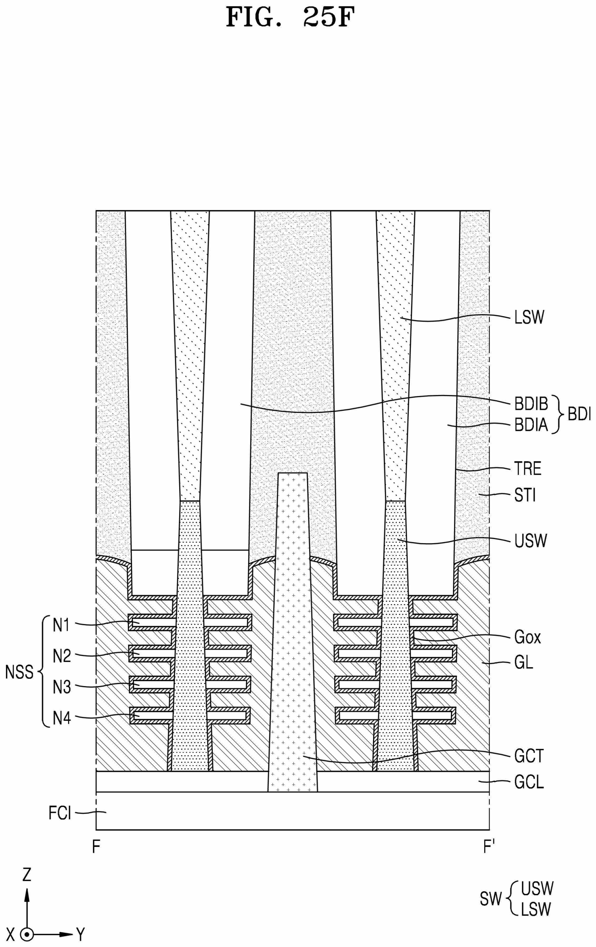

In FIGS. 25A, 25B, 25C, 25D, 25E, and 25F, a second backside insulating layer BDIB filling a space from which a part of the first backside insulating layer BDIA is removed and a space from which at least some of the place holder structures PHD are removed described with reference to FIGS. 23A, 23B, 23C, 23D, 23E, 23F, 24A, 24B, 24C, 24D, 24E, and 24F is formed. The second backside insulating layer BDIB may be formed to surround the plurality of sheet separation walls SW and the plurality of place holder structures PHD and fill spaces between the plurality of device separation layers STI. In some implementations, the second backside insulating layer BDIB may include the same material as the first backside insulating layer BDIA. For example, the second backside insulating layer BDIB may include BPSG, PSG, BSG, USG, TEOS, HDP, TOSZ, a ULK layer, or a combination thereof. The first backside insulating layer BDIA and the second backside insulating layer BDIB may constitute a backside insulating layer BDI. The second backside insulating layer BDIB may be formed by forming a second backside insulating material layer filling the space from which a part of the first backside insulating layer BDIA is removed and the space from which at least some of the place holder structures PHD are removed and covering the first backside insulating layer BDIA and the plurality of device separation layers STI and then, removing a part of the second backside insulating material layer through a CMP process so that the first backside insulating layer BDIA, the plurality of device separation layers STI, and the plurality of lower sheet separation walls LSW are exposed.

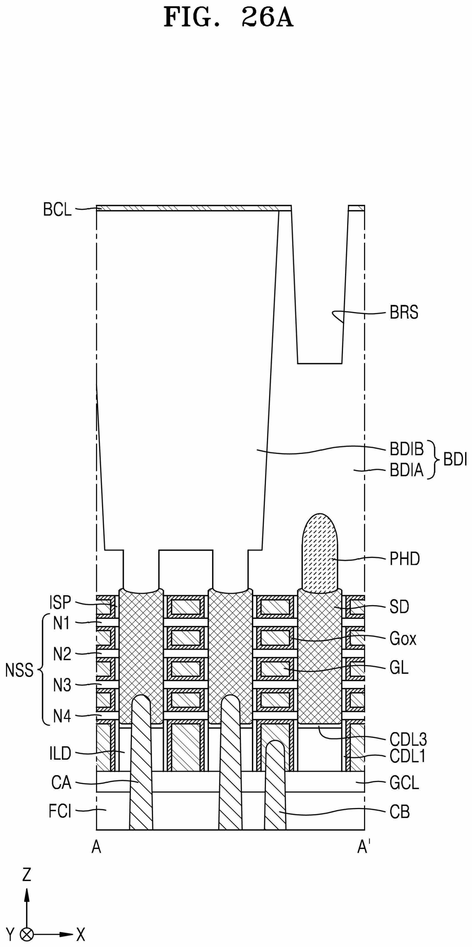

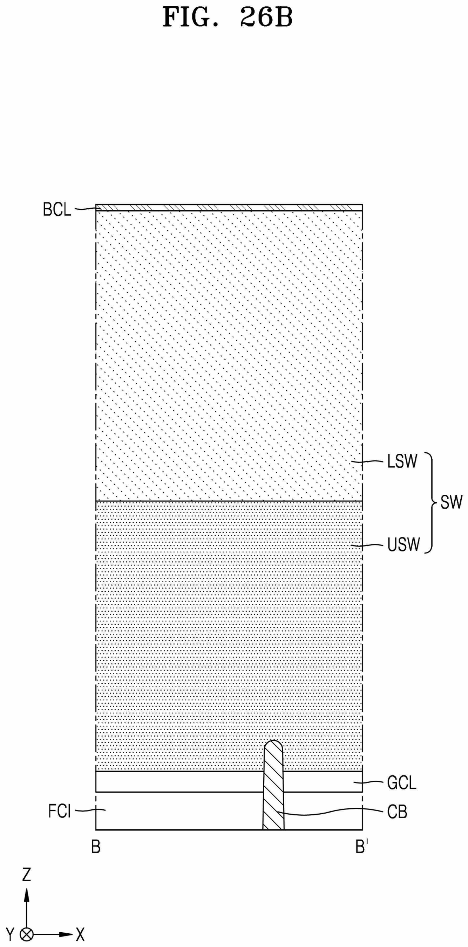

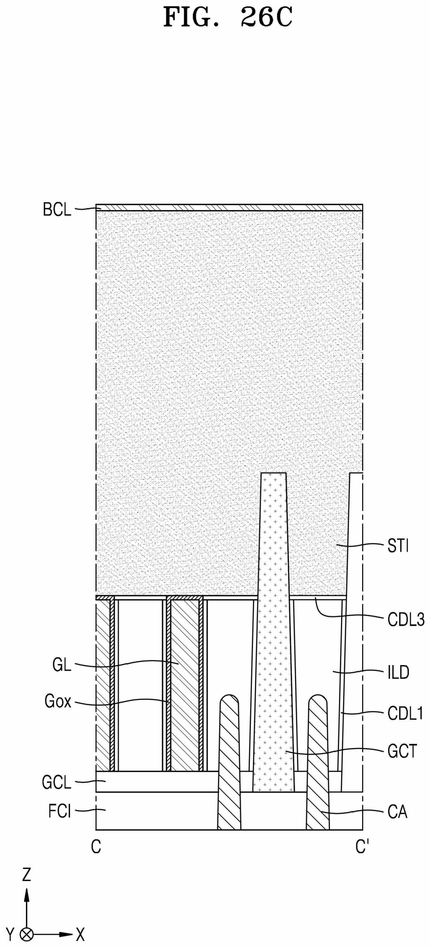

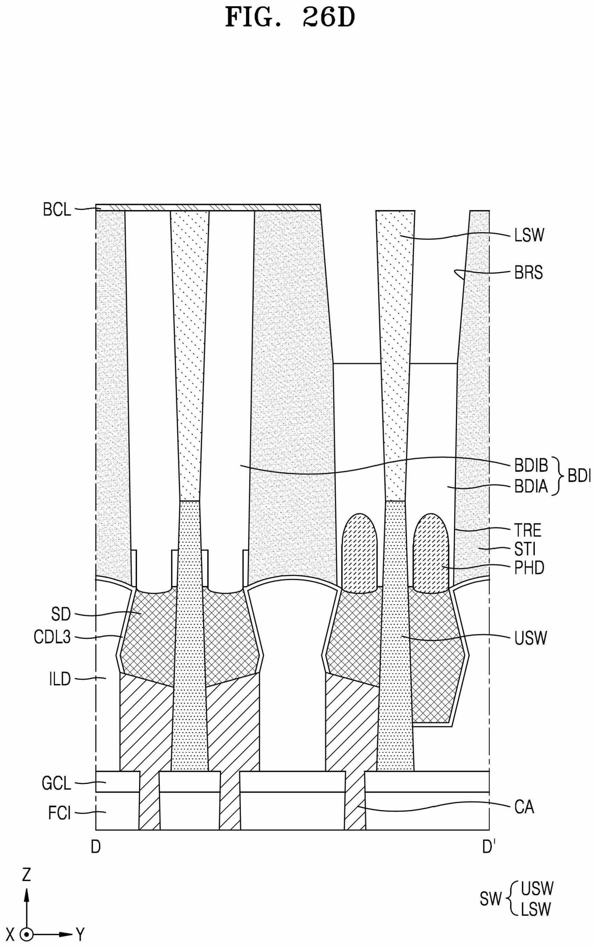

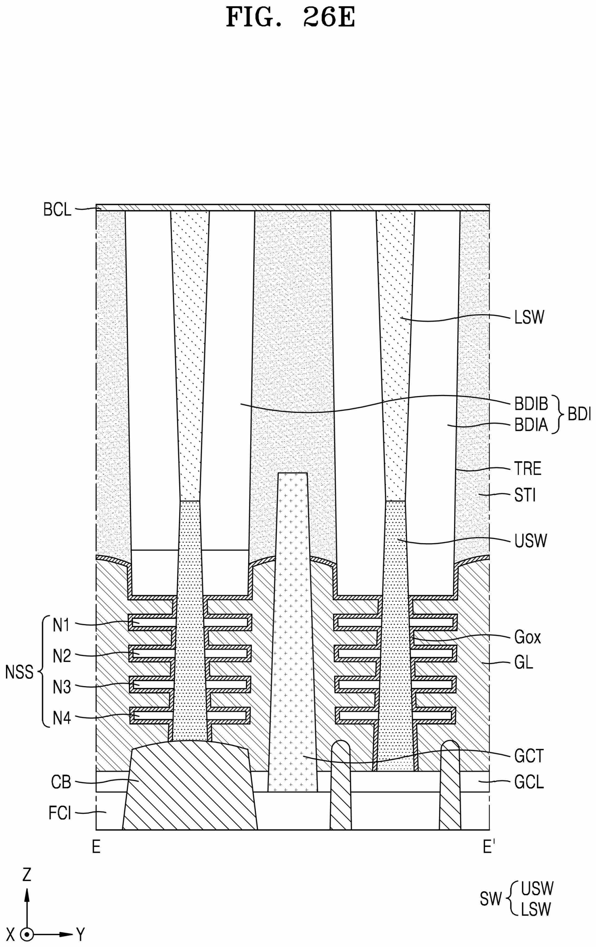

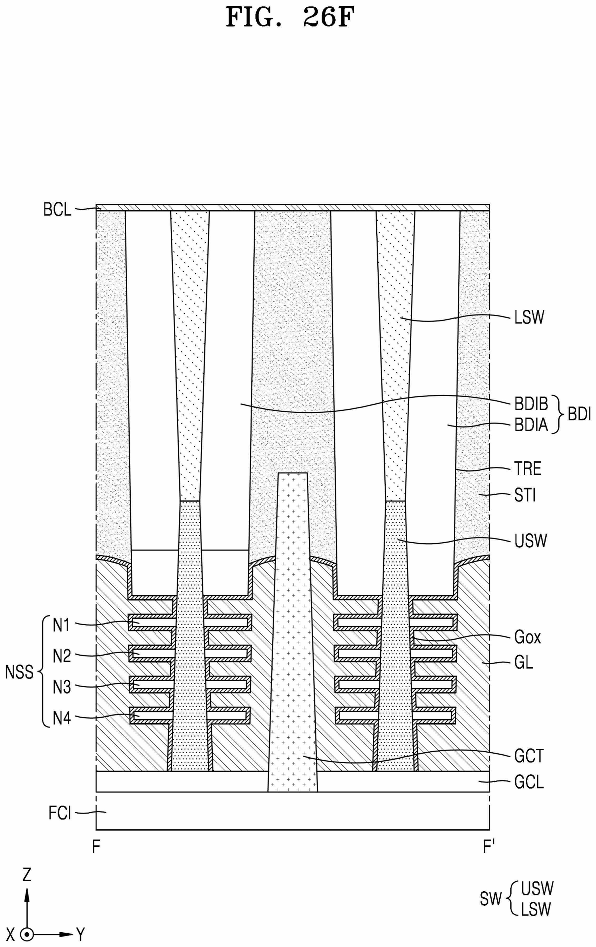

In FIGS. 26A, 26B, 26C, 26D, 26E, and 26F, after a backside mask pattern BCL is formed, backside recess spaces BRS are formed by removing parts of the plurality of device separation layers STI and parts of the backside insulating layer BDI by using the backside mask pattern BCL as an etching mask. The backside mask pattern BCL may, for example, not overlap the remaining place holder structures PHD in the vertical direction (Z direction). For example, the backside mask pattern BCL may have openings overlapping the remaining place holder structures PHD in the vertical direction (Z direction). Parts of the plurality of device separation layers STI and parts of the backside insulating layer BDI may be removed until the remaining place holder structures PHD are not exposed. For example, parts of the backside insulating layer BDI may be exposed on bottom surfaces of the backside recess spaces BRS. The backside mask pattern BCL may cover all of the plurality of sheet separation walls SW. The plurality of backside mask patterns BCL may include a polymer, a carbide, or a nitride.

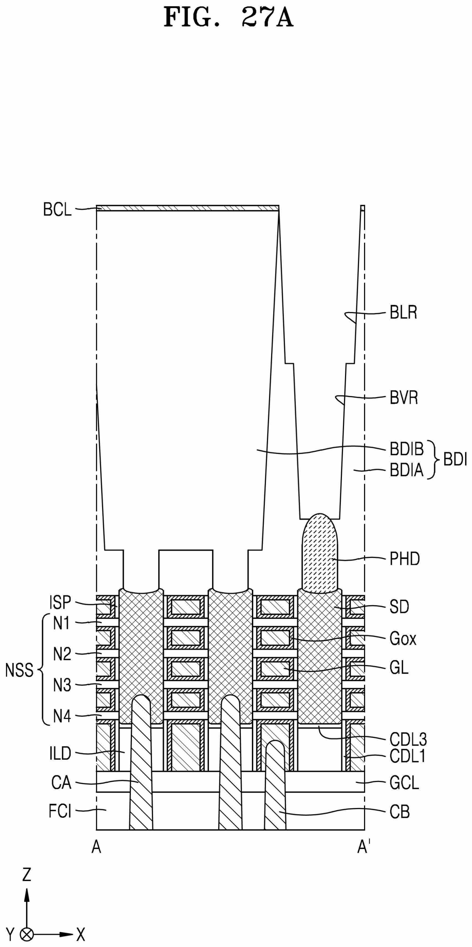

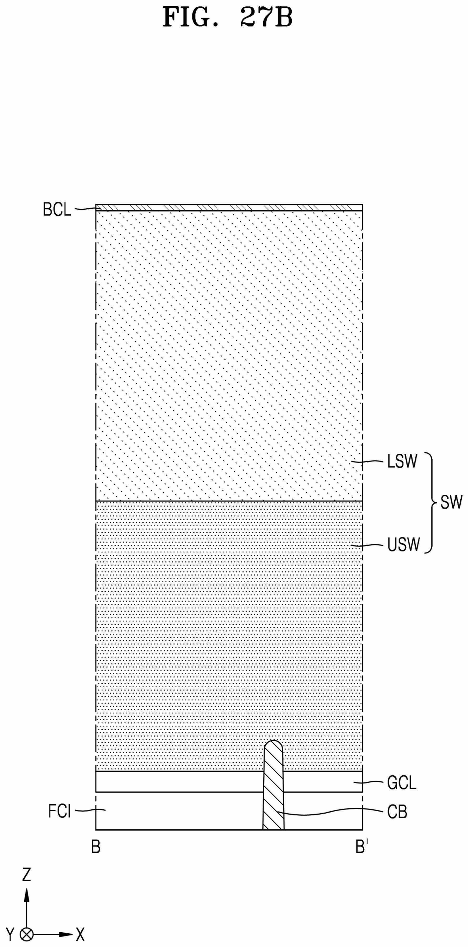

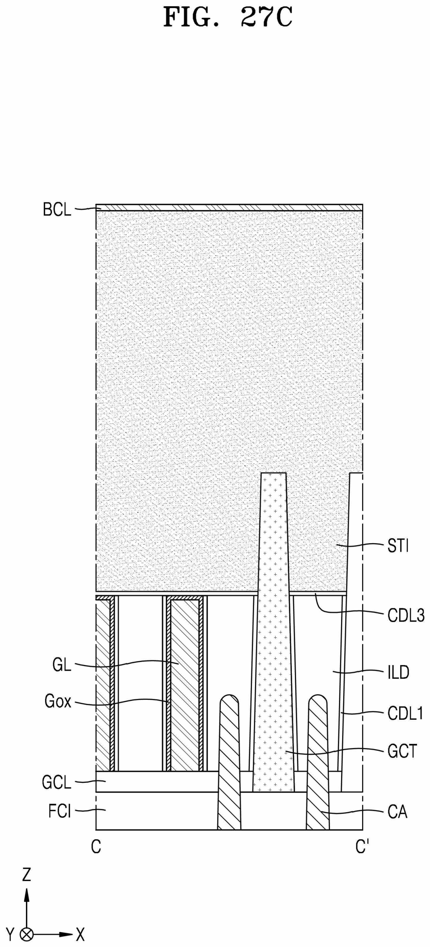

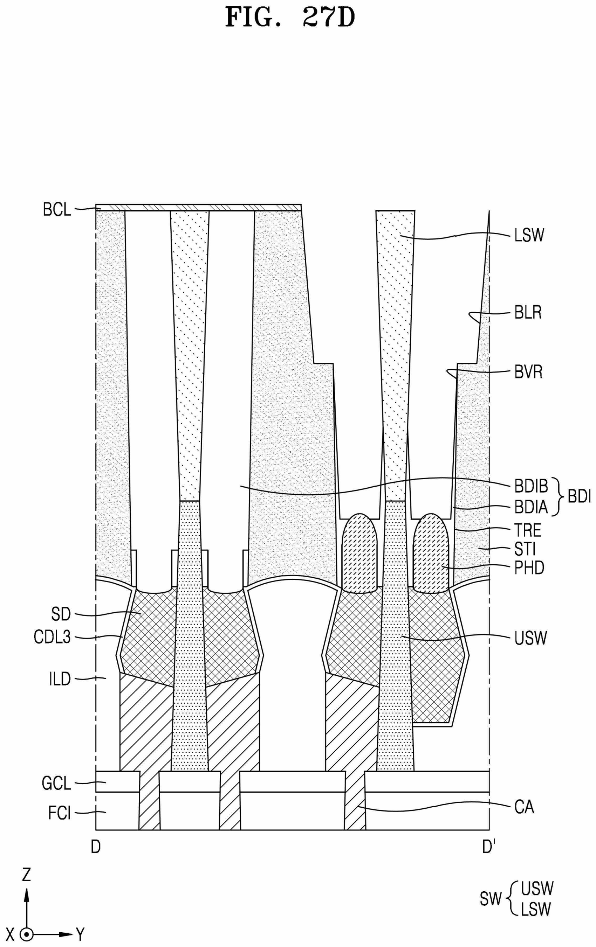

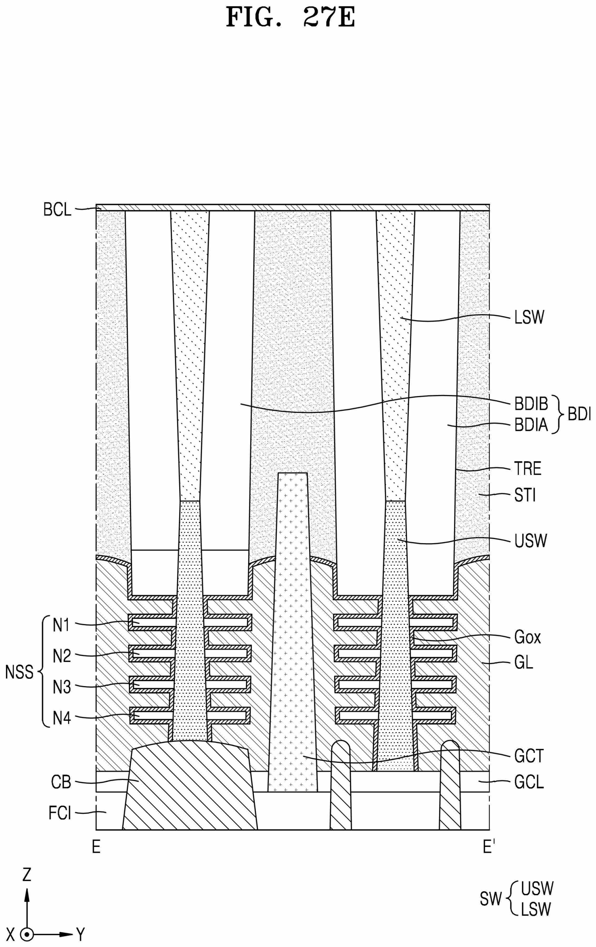

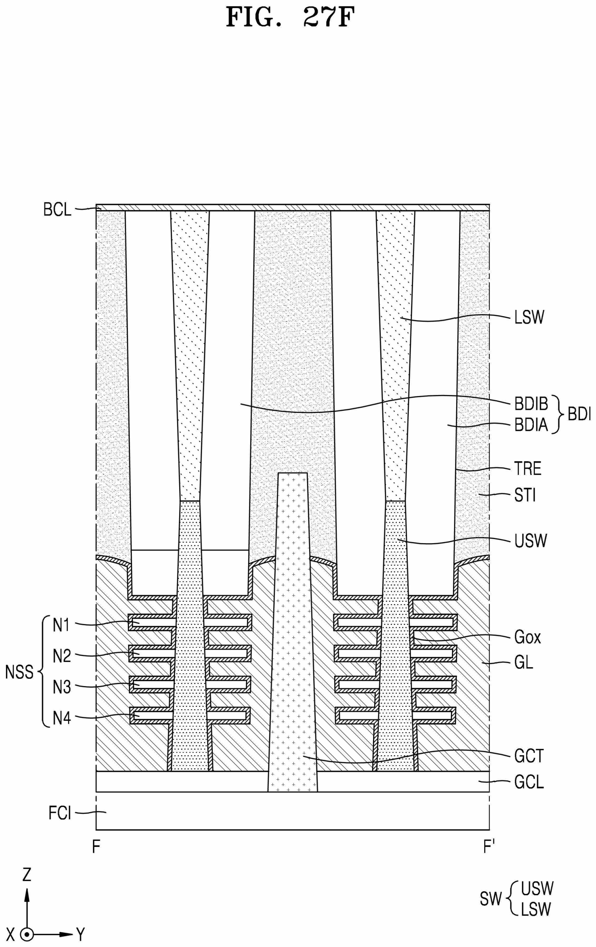

In FIGS. 27A, 27B, 27C, 27D, 27E, and 27F, after the openings of the backside mask pattern BCL expand by removing a part of the backside mask pattern BCL, the remaining place holder structures PHD are exposed by removing parts of the plurality of device separation layers STI and parts of the backside insulating layer BDI by using the backside mask pattern BCL as an etching mask. Parts of the plurality of device separation layers STI and parts of the backside insulating layer BDI surrounding the backside recess spaces BRS shown in FIGS. 26A and 26D may be removed so that backside line recesses BLR in which the backside recess spaces BRS expand in the horizontal direction may be formed, and parts of the backside insulating layer BDI located below the backside recess spaces BRS may be removed so that backside via recesses BVR communicating with the backside recess spaces BRS and exposing the place holder structures PHD may be formed.

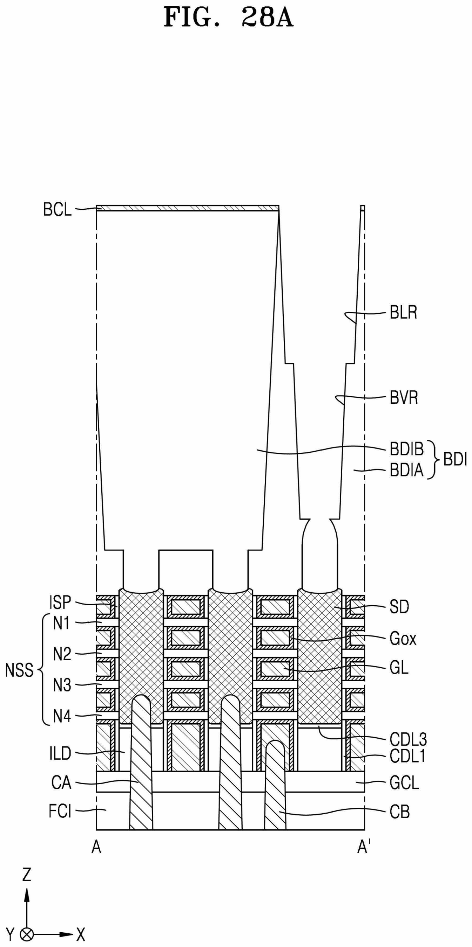

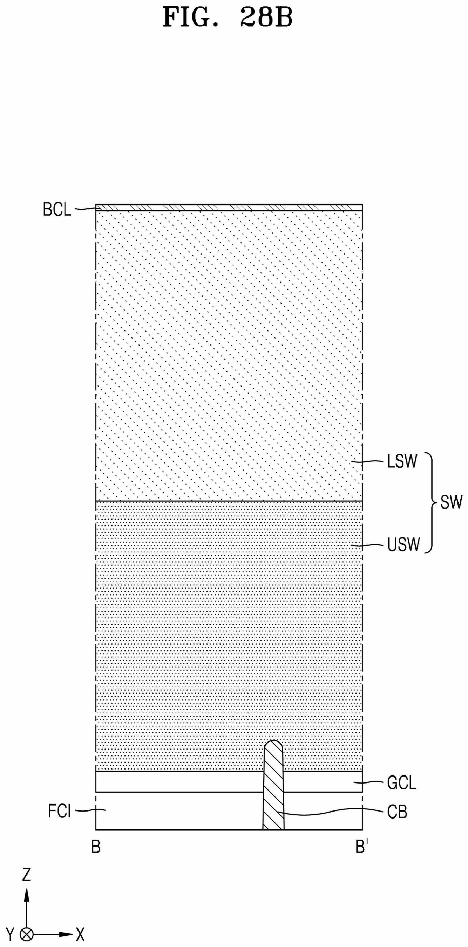

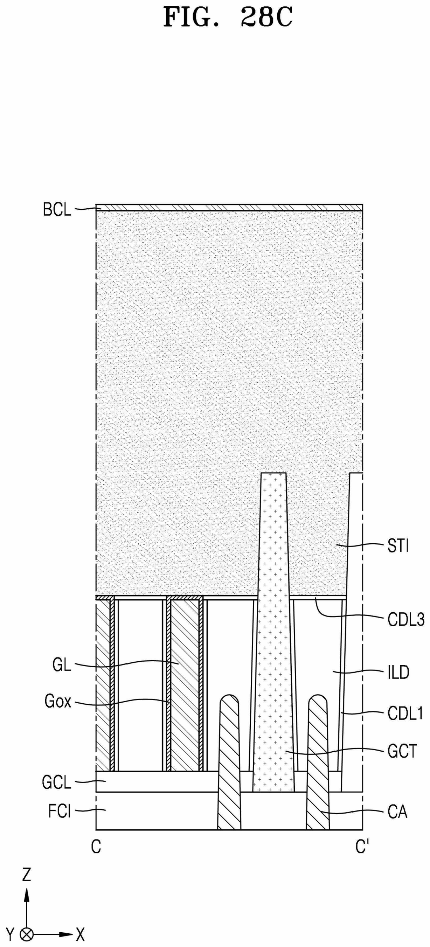

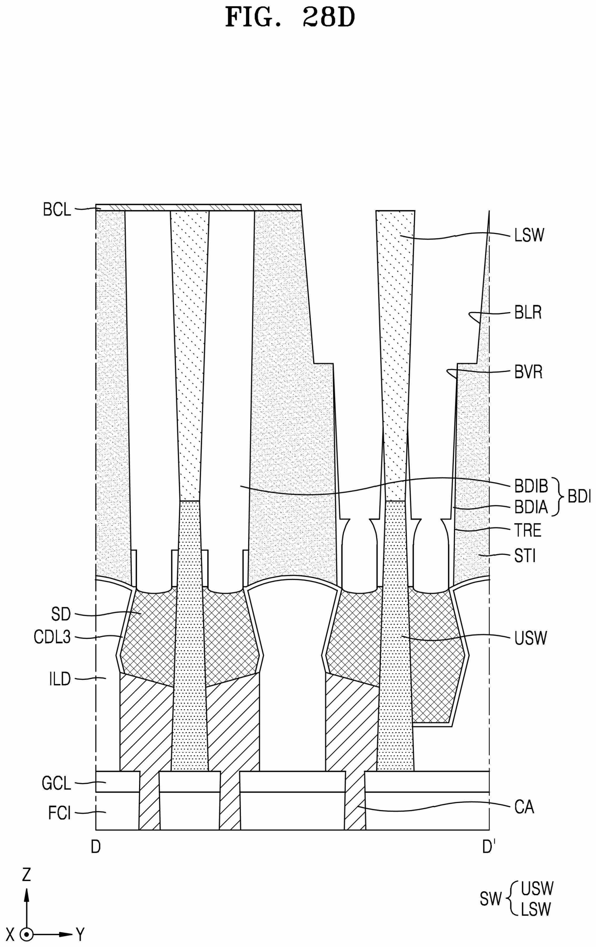

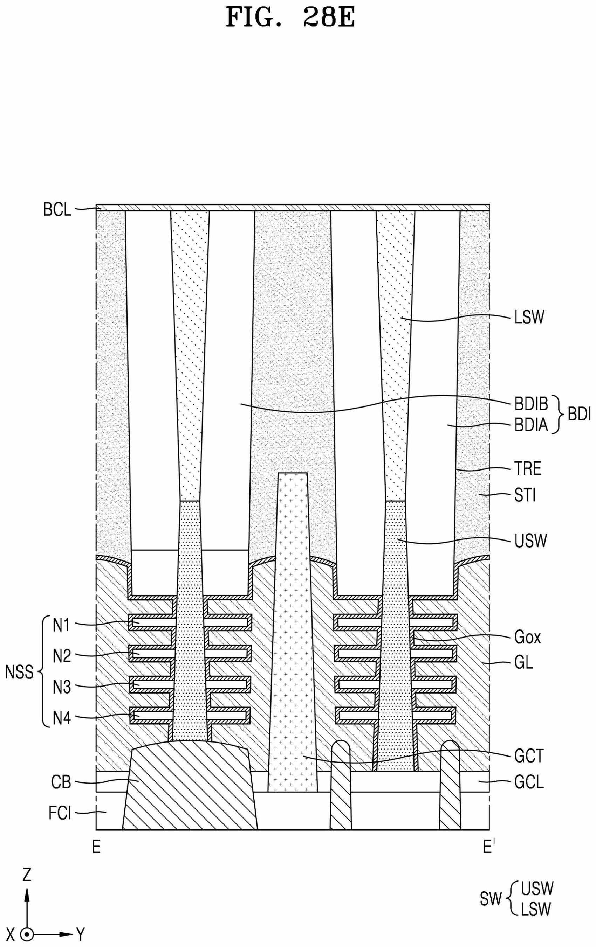

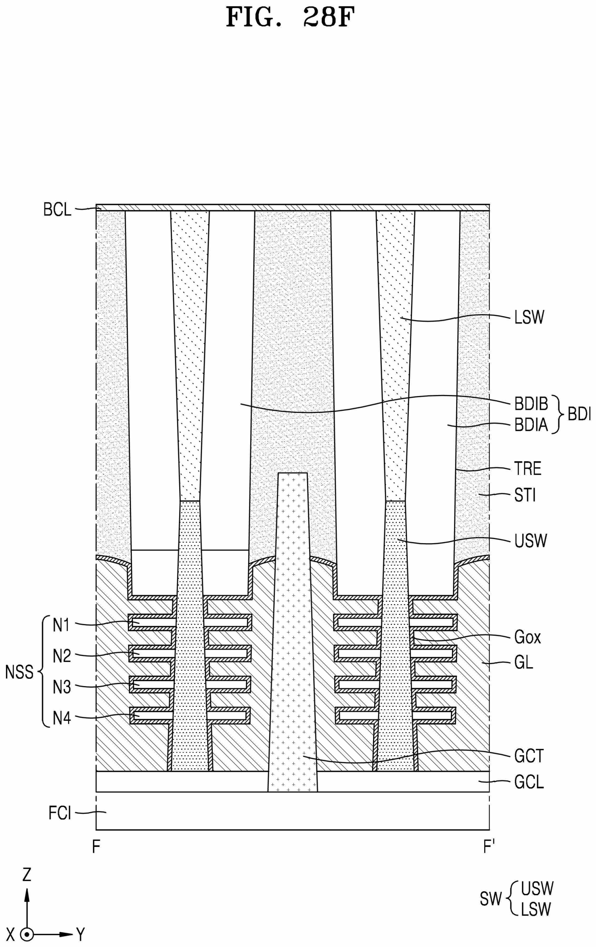

In FIGS. 27A, 27B, 27C, 27D, 27E, 27F, 28A, 28B, 28C, 28D, 28E, and 28F, the backside via recesses BVR may be formed to extend to at least some of the plurality of source/drain regions SD by removing the place holder structures PHD through the backside line recesses BLR and the backside via recesses BVR. At least some of the plurality of source/drain regions SD may be exposed on bottom surfaces of the extended backside via recesses BVR.

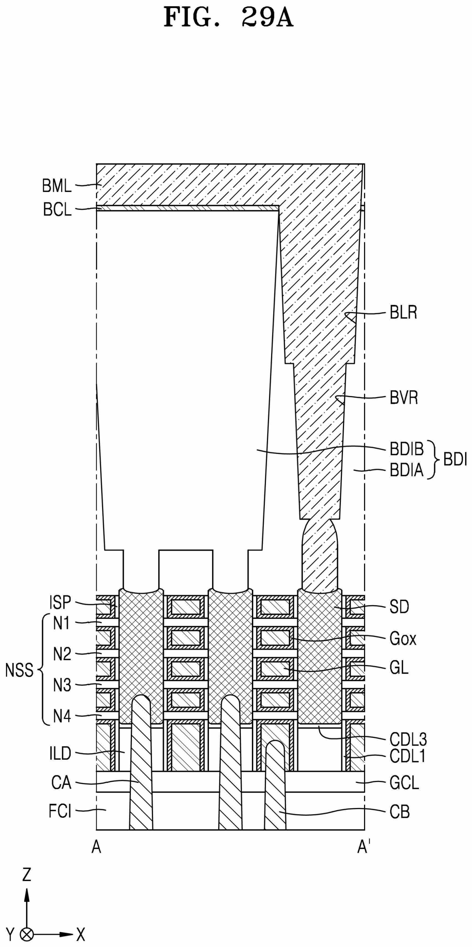

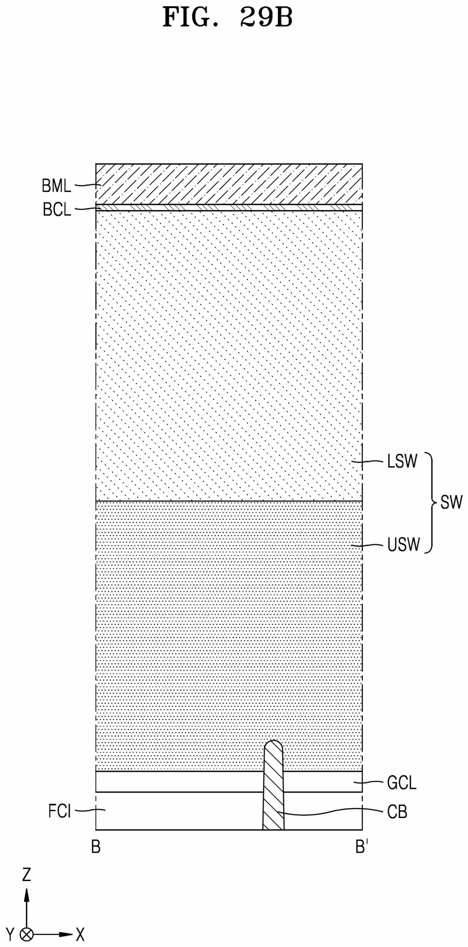

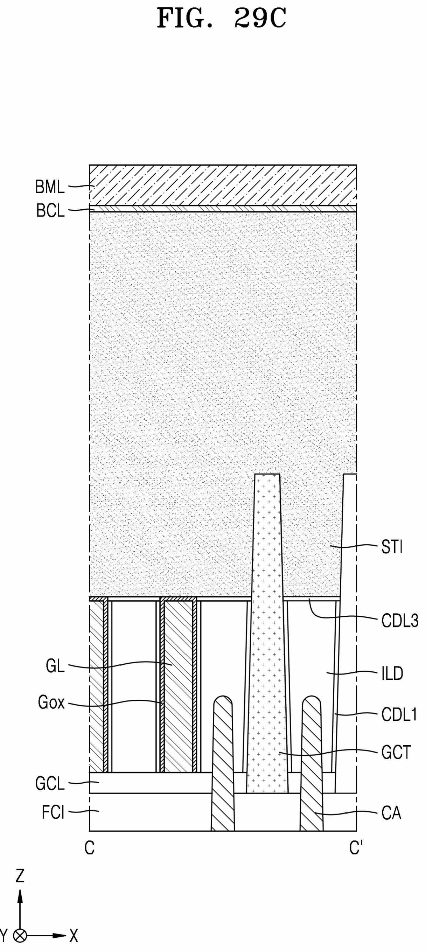

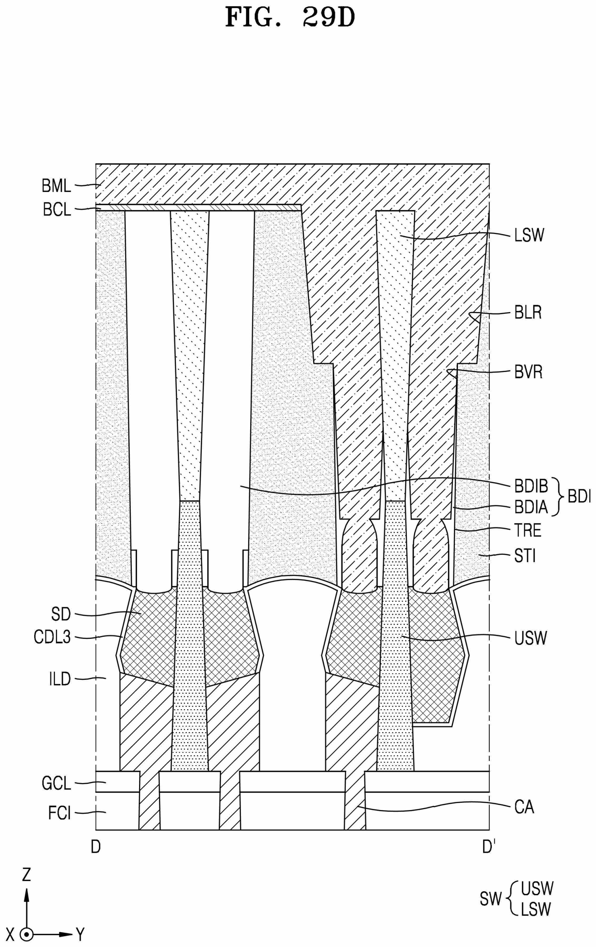

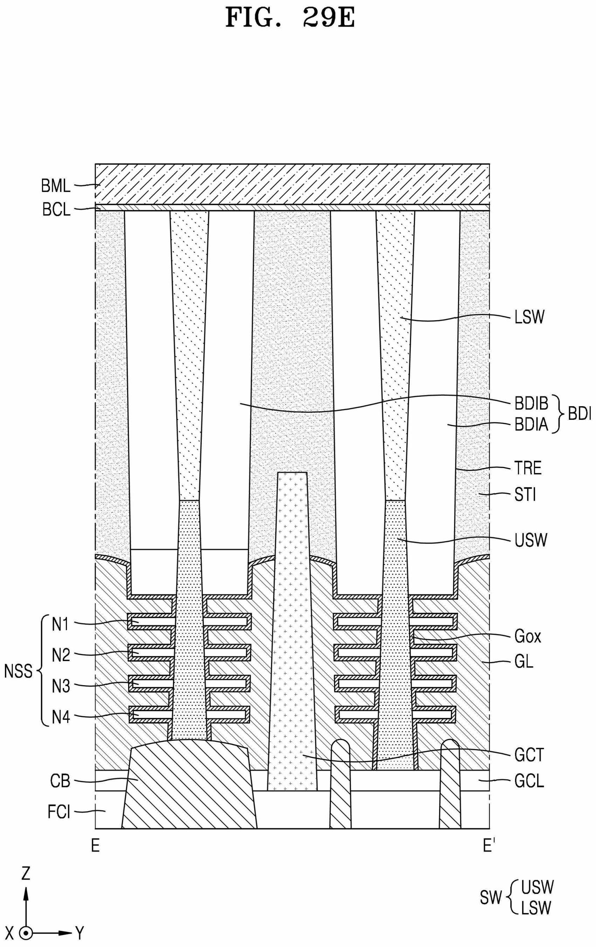

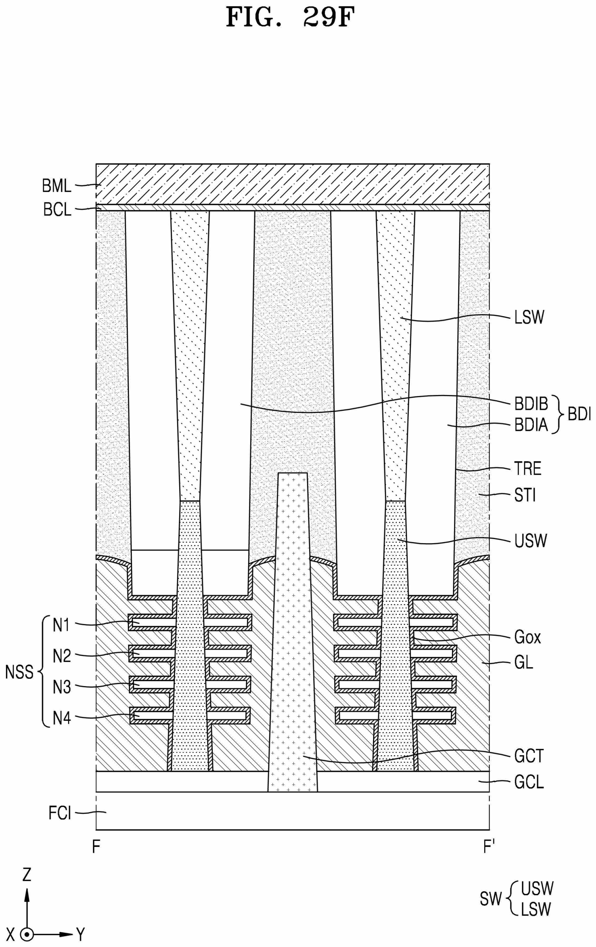

In FIGS. 29A, 29B, 29C, 29D, 29E, and 29F, a backside conductive material layer BML filling the backside line recesses BLR and the backside via recesses BVR and covering the backside mask pattern BCL is formed. The backside conductive material layer BML may include metal, conductive metal nitride, or a combination thereof. For example, the backside conductive material layer BML may include a metal material, such as W, Al, Cu, Ti, Ta, Ru, Mn, or Co, metal nitride, such as TiN, TaN, CoN, or WN, or an alloy, such as CoWP, CoWB, and CoWBP. In some implementations, a metal silicide layer may be disposed between each of the backside conductive material layer BML and at least some of the plurality of source/drain regions SD. For example, the metal silicide layer may include tungsten silicide (WSi), titanium silicide (TiSi), cobalt silicide (CoSi), or nickel silicide (NiSi).

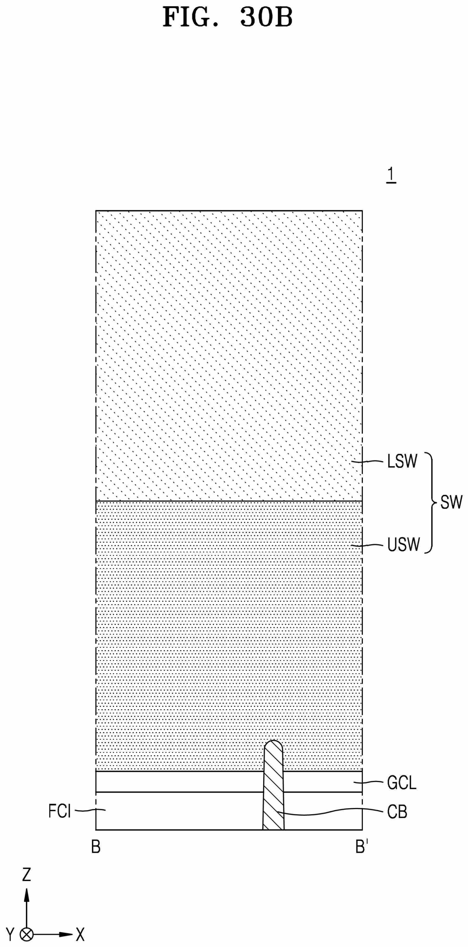

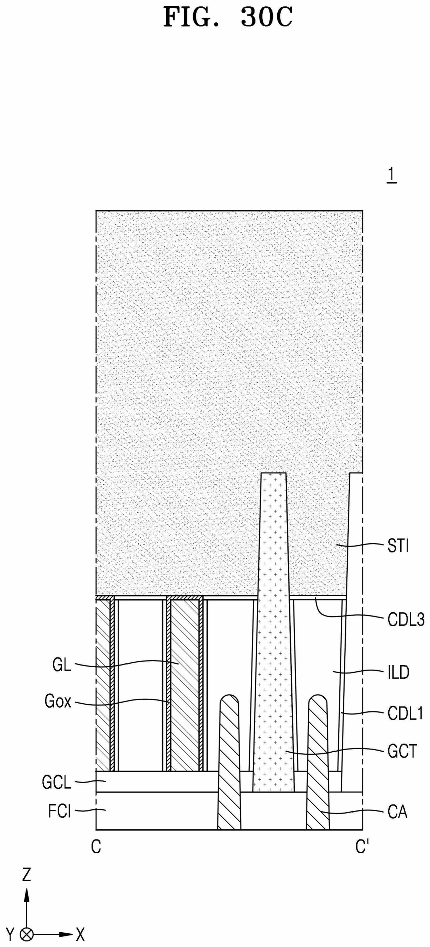

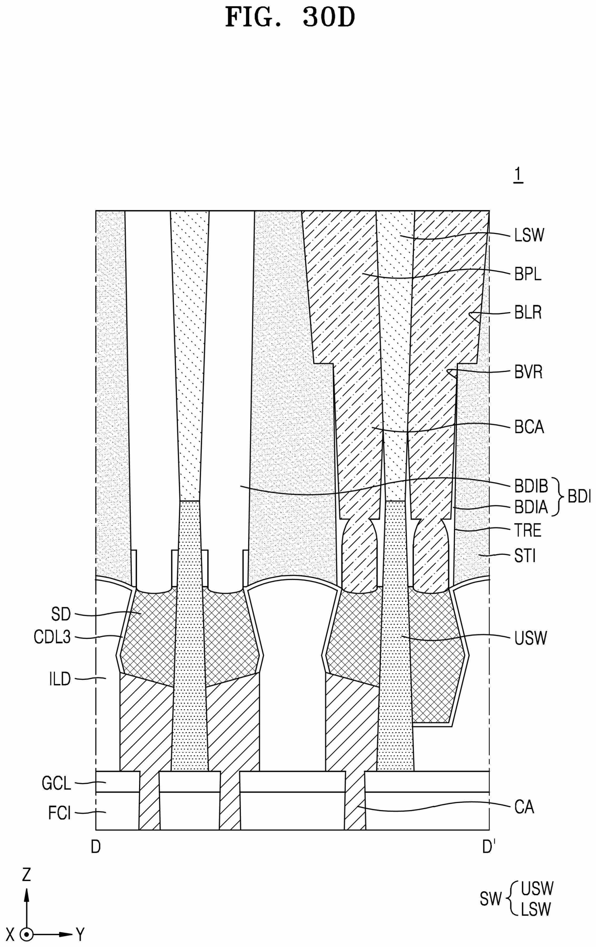

FIGS. 30A, 30B, 30C, 30D, 30E, and 30F are vertical cross-sectional views of an example of an integrated circuit device 1 according to some implementations. In FIGS. 29A, 29B, 29C, 29D, 29E, 29F, 30A, 30B, 30C, 30D, 30E, and 30F, the integrated circuit device 1 is formed by removing a part of the backside conductive material layer BML and the backside mask pattern BCL and forming backside wiring lines BPL filling the backside line recesses BLR and backside via contacts BCA filling the backside via recesses BVR. The backside wiring lines BPL and the backside via contacts BCA connected to each other may be integrally formed. The backside via contacts BCA may be connected to at least some of the plurality of source/drain regions SD. In some implementations, a part of the backside conductive material layer BML and the backside mask pattern BCL may be removed by performing a CMP process.

FIGS. 30A, 30B, 30C, 30D, 30E, and 30F illustrate that the backside via contacts BCA and the plurality of lower sheet separation walls LSW included in the integrated circuit device 1 are located at an upper side, and the plurality of first contacts CA, the plurality of second contacts CB, and the plurality of upper sheet separation walls USW are located at a lower side, but by inverting the integrated circuit device 1 shown in FIGS. 30A, 30B, 30C, 30D, 30E, and 30F, the plurality of first contacts CA, the plurality of second contacts CB, and the plurality of upper sheet separation walls USW may be located at the upper side, and the backside via contacts BCA and the plurality of lower sheet separation walls LSW may be located at the lower side.

In FIGS. 1, 30A, 30B, 30C, 30D, 30E, and 30F, the integrated circuit device 1 includes the plurality of nanosheet stack structures NSS each including the first nanosheet N1, the second nanosheet N2, the third nanosheet N3, and the fourth nanosheet N4, the plurality of upper sheet separation walls USW extending in the first horizontal direction (X direction) between a pair of nanosheet stack structures NSS adjacent to each other in the second horizontal direction (Y direction), the plurality of gate electrodes GL extending in the second horizontal direction (Y direction) on the plurality of nanosheet stack structures NSS, the at least one gate cut structure GCT cutting at least some of the plurality of gate electrodes GL, the plurality of gate insulating layers Gox disposed between the plurality of gate electrodes GL and the plurality of nanosheet stack structures NSS including the first nanosheet N1, the second nanosheet N2, the third nanosheet N3, and the fourth nanosheet N4, the plurality of source/drain regions SD connected to the first nanosheet N1, the second nanosheet N2, the third nanosheet N3, and the fourth nanosheet N4 included in each of the plurality of nanosheet stack structures NSS, the plurality of first contacts CA penetrating the front insulating layer FCI, the gate capping layer GCL, and the interlayer insulating layer ILD and connected to upper parts of at least some of the plurality of source/drain regions SD, the plurality of second contacts CB penetrating the front insulating layer FCI and the gate capping layer GCL and connected to the plurality of gate electrodes GL, the plurality of backside via contacts BCA penetrating the plurality of device separation layers STI and the backside insulating layer BDI and connected to lower parts of at least some of the plurality of source/drain regions SD, the backside wiring lines BPL connected to the backside via contacts BCA, and the plurality of lower sheet separation walls LSW extending in the first horizontal direction (X direction) between a pair of backside via contacts BCA and a pair of backside wiring lines BPL adjacent to each other in the second horizontal direction (Y direction) among the backside via contacts BCA and the backside wiring lines BPL.

The plurality of nanosheet stack structures NSS may be disposed in rows and columns in the first horizontal direction (X direction) and the second horizontal direction (Y direction). The plurality of nanosheet stack structures NSS may be adjacent to the plurality of upper sheet separation walls USW and disposed in columns in the first horizontal direction (X direction). Among the plurality of nanosheet stack structures NSS, a pair of nanosheet stack structures NSS corresponding to each other may have the upper sheet separation wall USW disposed therebetween and be disposed to be spaced apart from each other in the second horizontal direction (Y direction).

Each of the first nanosheet N1, the second nanosheet N2, the third nanosheet N3, and the fourth nanosheet N4 included in each of the plurality of nanosheet stack structures NSS may extend parallel to the upper surface of the base substrate layer BSUB. The first nanosheet N1, the second nanosheet N2, the third nanosheet N3, and the fourth nanosheet N4 may be stacked on the base substrate layer BSUB to be spaced apart from each other in the vertical direction (Z direction). Ends of the first nanosheet N1, the second nanosheet N2, the third nanosheet N3, and the fourth nanosheet N4 included in each of the plurality of nanosheet stack structures NSS in the second horizontal direction (Y direction) may face the plurality of upper sheet separation walls USW. The plurality of nanosheet stack structures NSS each including the first nanosheet N1, the second nanosheet N2, the third nanosheet N3, and the fourth nanosheet N4, the plurality of gate electrodes GL, and the plurality of source/drain regions SD may constitute a plurality of multi-gate MOSFETs. Both ends of the first nanosheet N1, the second nanosheet N2, the third nanosheet N3, and the fourth nanosheet N4 included in each of the plurality of nanosheet stack structures NSS in the first horizontal direction (X direction) may be connected to the plurality of source/drain regions SD.

The plurality of gate electrodes GL may be disposed above the uppermost fourth nanosheet N4, below the lowermost first nanosheet N1, and between each of the first nanosheet N1, the second nanosheet N2, the third nanosheet N3, and the fourth nanosheet N4). Among the plurality of gate electrodes GL, a portion disposed above the uppermost fourth nanosheet N4, a portion disposed below the lowermost first nanosheet N1, and portions disposed between each of the first nanosheet N1, the second nanosheet N2, the third nanosheet N3, and the fourth nanosheet N4 may be connected to each other. The gate electrodes GL separated into two by the gate cut structure GCT may have the gate cut structure GCT disposed therebetween and be spaced apart from each other in the second horizontal direction (Y direction). The gate cut structure GCT may extend in the vertical direction (Z direction) between the gate electrodes GL adjacent to each other in the second horizontal direction (Y direction), and extend into the device separation layer STI.

The first insulating layer CDL1 may be disposed between the gate insulating layer Gox covering the gate electrode GL and the interlayer insulating layer ILD. The first insulating layer CDL1 may be referred to as a gate spacer. The third insulating layer CDL3 may cover a part of the surface of the source/drain region SD. The third insulating layer CDL3 may be referred to as a source/drain cover layer. The gate capping layer GCL and the front insulating layer FCI may cover above the plurality of gate electrodes GL, and the backside insulating layer BDI and the device separation layer STI may cover below the plurality of gate electrodes GL. The backside insulating layer BDI may cover below the plurality of nanosheet stack structures NSS and below the plurality of source/drain regions SD. The backside insulating layer BDI may surround the plurality of lower sheet separation walls LSW. The device separation layer STI may surround the backside insulating layer BDI below the interlayer insulating layer ILD and the plurality of gate electrodes GL. The plurality of gate insulating layers Gox may be disposed between the backside insulating layer BDI and the device separation layer STI, and the plurality of gate electrodes GL.

The plurality of upper sheet separation walls USW may extend in the first horizontal direction (X direction) and the vertical direction (Z direction) respectively between a pair of nanosheet stack structures NSS adjacent to each other in the second horizontal direction (Y direction) among the plurality of nanosheet stack structures NSS. The plurality of upper sheet separation walls USW may extend in the vertical direction (Z direction) into the backside insulating layer BDI between a pair of nanosheet stack structures NSS adjacent to each other in the second horizontal direction (Y direction) among the plurality of nanosheet stack structures NSS. The plurality of lower sheet separation walls LSW may extend in the first horizontal direction (X direction) and the vertical direction (Z direction) respectively between a pair of backside via contacts BCA and a pair of backside wiring lines BPL adjacent to each other in the second horizontal direction (Y direction) among the backside via contacts BCA and the backside wiring lines BPL. The plurality of lower sheet separation walls LSW may extend in the vertical direction (Z direction) into the backside insulating layer BDI between a pair of backside via contacts BCA and a pair of backside wiring lines BPL adjacent to each other in the second horizontal direction (Y direction) among the backside via contacts BCA and the backside wiring lines BPL.

The plurality of lower sheet separation walls LSW and the plurality of upper sheet separation walls USW corresponding to each other may constitute the plurality of sheet separation walls SW. The plurality of sheet separation walls SW may extend in the first horizontal direction (X direction) and may be spaced apart from each other in the second horizontal direction (Y direction). The plurality of lower sheet separation walls LSW and the plurality of upper sheet separation walls USW corresponding to each other overlap each other in the vertical direction (Z direction) and may contact each other. The plurality of lower sheet separation walls LSW and the plurality of upper sheet separation walls USW corresponding to each other may contact each other with their ends facing each other in the backside insulating layer BDI.

The upper sheet separation wall USW may extend in each of the first horizontal direction (X direction) and the vertical direction (Z direction) over a part between a pair of nanosheet stack structures NSS adjacent to each other in the second horizontal direction (Y direction), between a pair of source/drain regions SD adjacent to each other in the second horizontal direction (Y direction), and between a pair of backside via contacts BCA adjacent to each other in the second horizontal direction (Y direction). The lower sheet separation wall LSW may extend in the first horizontal direction (X direction) and the vertical direction (Z direction) over a part between a pair of backside wiring lines BPL adjacent to each other in the second horizontal direction (Y direction) and a pair of backside via contacts BCA adjacent to each other in the second horizontal direction (Y direction). A part of the upper sheet separation wall USW and a part of the lower sheet separation wall LSW may be disposed between a pair of backside via contacts BCA adjacent to each other in the second horizontal direction (Y direction). For example, the lower sheet separation wall LSW and the upper sheet separation wall USW corresponding to each other may contact a pair of backside via contacts BCA adjacent to each other in the second horizontal direction (Y direction).

Each of the plurality of lower sheet separation walls LSW may extend toward each of the plurality of upper sheet separation walls USW corresponding thereto, and have a tapered shape with a horizontal width narrowing in the second horizontal direction (Y direction), and each of the plurality of upper sheet separation walls USW may extend toward each of the plurality of corresponding lower sheet separation walls LSW corresponding thereto, and have a tapered shape with a horizontal width narrowing in the second horizontal direction (Y direction). That is, the plurality of lower sheet separation walls LSW and the plurality of upper sheet separation walls USW corresponding to each other may have a tapered shape with a horizontal width narrowing in the second horizontal direction (Y direction) and extending toward each other.

The other ends of the plurality of upper sheet separation walls USW opposite to the plurality of lower sheet separation walls LSW may be located at the same vertical level as upper ends of the plurality of gate electrodes GL. The plurality of gate electrodes GL may have ends facing the plurality of lower sheet separation walls LSW and the other ends opposite to the plurality of lower sheet separation walls LSW. The upper ends of the plurality of gate electrodes GL may be the other ends of the plurality of gate electrodes GL. For example, the uppermost end of the plurality of upper sheet separation walls USW and the uppermost end of the plurality of gate electrodes GL may be located at the same vertical level. The uppermost end of the plurality of upper sheet separation walls USW, the uppermost end of the plurality of gate electrodes GL, and the upper surface of the interlayer insulating layer ILD may be located at the same vertical level to be coplanar. The other ends of the plurality of lower sheet separation walls LSW opposite to the plurality of upper sheet separation walls USW may be located at the same vertical level as lower ends of the backside wiring lines BPL. The backside wiring lines BPL and the backside via contacts BCA may have ends facing the plurality of upper sheet separation walls USW and the other ends opposite to the plurality of upper sheet separation walls USW. Lower ends of the backside wiring lines BPL may be the other ends of the backside wiring lines BPL. Ends of the backside wiring lines BPL and the other ends of the backside via contacts BCA corresponding to each other may contact each other.

For example, the lowermost end of the plurality of lower sheet separation walls LSW and the lowermost end of the plurality of backside wiring lines BPL may be located at the same vertical level. The lowermost end of the plurality of lower sheet separation walls LSW, the lowermost end of the plurality of backside wiring lines BPL, the lower surfaces of the plurality of device separation layers STI, and the lower surface of the backside insulating layer BDI may be located at the same vertical level to be coplanar.

The integrated circuit device 1 according to the inventive concept includes the lower sheet separation wall LSW disposed between a pair of backside via contacts BCA and a pair of backside wiring lines BPL adjacent to each other in the second horizontal direction (Y direction) among the backside via contacts BCA and the backside wiring lines BPL, thereby preventing a short circuit from occurring between the adjacent backside via contacts BCA and/or between the adjacent backside wiring lines BPL. Therefore, the operational reliability of the integrated circuit device 1 may be improved.

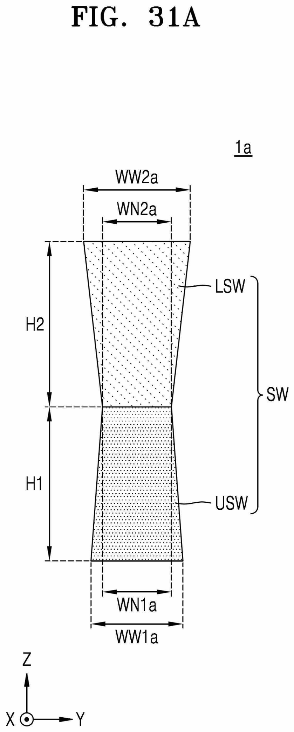

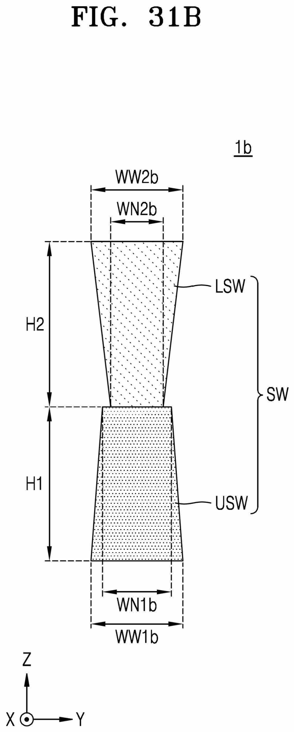

FIGS. 31A and 31B are vertical cross-sectional views illustrating an example of a sheet separation wall SW included in integrated circuit devices 1a and 1b respectively according to some implementations.

In FIG. 31A, the integrated circuit device 1a includes the sheet separation wall SW including the lower sheet separation wall LSW and the upper sheet separation wall USW corresponding to each other. The lower sheet separation wall LSW and the upper sheet separation wall USW included in the sheet separation wall SW may contact each other with their ends facing each other. The lower sheet separation wall LSW and the upper sheet separation wall USW included in the sheet separation wall SW may have a tapered shape with a horizontal width narrowing in the second horizontal direction (Y direction) and extending in the vertical direction (Z direction) toward each other from the other ends opposite to each other to ends facing each other.

In the second horizontal direction (Y direction), one end of the upper sheet separation wall USW may have a first upper horizontal width WN1a, and the other end of the upper sheet separation wall USW may have a second upper horizontal width WW1a. In the second horizontal direction (Y direction), one end of the lower sheet separation wall LSW may have a first lower horizontal width WN2a, and the other end of the lower sheet separation wall LSW may have a second lower horizontal width WW2a. In the vertical direction (Z direction), the upper sheet separation wall USW may have a first height H1, the lower sheet separation wall LSW may have a second height H2, and the second height H2 may have a greater value than that of the first height H1.

The second upper horizontal width WW1a may have a greater value than that of the first upper horizontal width WN1a. The first upper horizontal width WN1a may be the minimum horizontal width of the upper sheet separation wall USW in the second horizontal direction (Y direction), and the second upper horizontal width WW1a may be the maximum horizontal width of the upper sheet separation wall USW in the second horizontal direction (Y direction). The second lower horizontal width WW2a may have a greater value than that of the first lower horizontal width WN2a. The first lower horizontal width WN2a may be the minimum horizontal width of the lower sheet separation wall LSW in the second horizontal direction (Y direction), and the second lower horizontal width WW2a may be the maximum horizontal width of the lower sheet separation wall LSW in the second horizontal direction (Y direction).

In some implementations, the first upper horizontal width WN1a and the first lower horizontal width WN2a may have substantially the same value, and the second lower horizontal width WW2a may have a greater value than that of the second upper horizontal width WW1a.

In FIG. 31B, the integrated circuit device 1b includes the sheet separation wall SW including the lower sheet separation wall LSW and the upper sheet separation wall USW corresponding to each other. The lower sheet separation wall LSW and the upper sheet separation wall USW included in the sheet separation wall SW may contact each other with their ends facing each other. The lower sheet separation wall LSW and the upper sheet separation wall USW included in the sheet separation wall SW may have a tapered shape with a horizontal width narrowing in the second horizontal direction (Y direction) and extending in the vertical direction (Z direction) toward each other from the other ends opposite to each other to ends facing each other.

In the second horizontal direction (Y direction), one end of the upper sheet separation wall USW may have a first upper horizontal width WN1b, and the other end of the upper sheet separation wall USW may have a second upper horizontal width WW1b. In the second horizontal direction (Y direction), one end of the lower sheet separation wall LSW may have a first lower horizontal width WN2b, and the other end of the lower sheet separation wall LSW may have a second lower horizontal width WW2b. In the vertical direction (Z direction), the upper sheet separation wall USW may have the first height H1, the lower sheet separation wall LSW may have the second height H2, and the second height H2 may have a greater value than that of the first height H1.

The second upper horizontal width WW1b may have a greater value than that of the first upper horizontal width WN1b. The first upper horizontal width WN1b may be the minimum horizontal width of the upper sheet separation wall USW in the second horizontal direction (Y direction), and the second upper horizontal width WW1b may be the maximum horizontal width of the upper sheet separation wall USW in the second horizontal direction (Y direction). The second lower horizontal width WW2b may have a greater value than that of the first lower horizontal width WN2b. The first lower horizontal width WN2b may be the minimum horizontal width of the lower sheet separation wall LSW in the second horizontal direction (Y direction), and the second lower horizontal width WW2b may be the maximum horizontal width of the lower sheet separation wall LSW in the second horizontal direction (Y direction).

In some implementations, the second lower horizontal width WW2b and the second upper horizontal width WW1b may have substantially the same value, and the first upper horizontal width WN1b may have a greater value than that of the first lower horizontal width WN2b.

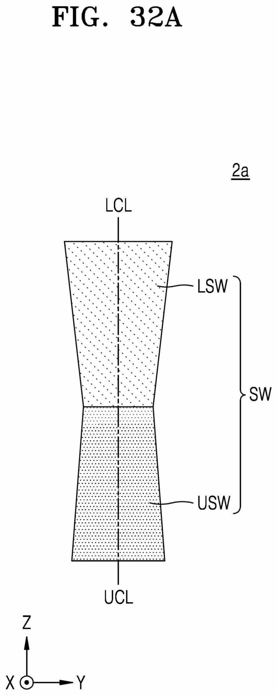

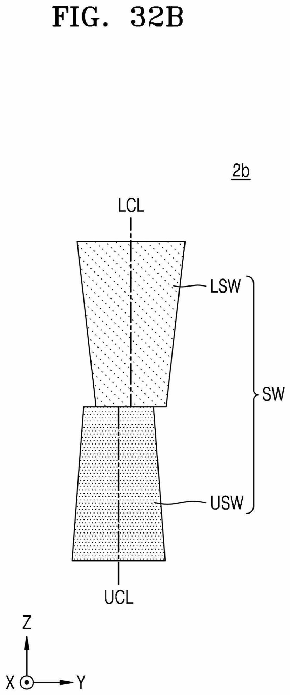

FIGS. 32A and 32B are vertical cross-sectional views illustrating an example of a sheet separation wall SW included in integrated circuit devices 2a and 2b respectively according to some implementations.

In FIG. 32A, the integrated circuit device 2a includes the sheet separation wall SW including the lower sheet separation wall LSW and the upper sheet separation wall USW corresponding to each other. The sheet separation wall SW is substantially the same as the sheet separation wall SW shown in FIG. 31A, and thus a redundant description thereof will be omitted. A center line LCL of the lower sheet separation wall LSW and a center line UCL of the upper sheet separation wall USW may coincide with each other in the second horizontal direction (Y direction). The lower sheet separation wall LSW and the upper sheet separation wall USW included in the sheet separation wall SW may cover ends facing each other.

In FIG. 32B, the integrated circuit device 2b includes the sheet separation wall SW including the lower sheet separation wall LSW and the upper sheet separation wall USW corresponding to each other. The sheet separation wall SW is substantially the same as the sheet separation wall SW shown in FIG. 31A, and thus a redundant description thereof will be omitted. The center line LCL of the lower sheet separation wall LSW and the center line UCL of the upper sheet separation wall USW may be shifted in the second horizontal direction (Y direction). The lower sheet separation wall LSW and the upper sheet separation wall USW included in the sheet separation wall SW may partially cover ends facing each other.

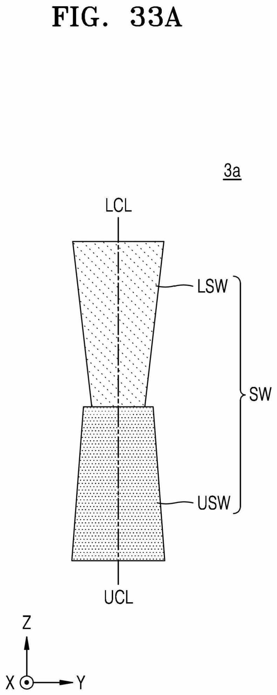

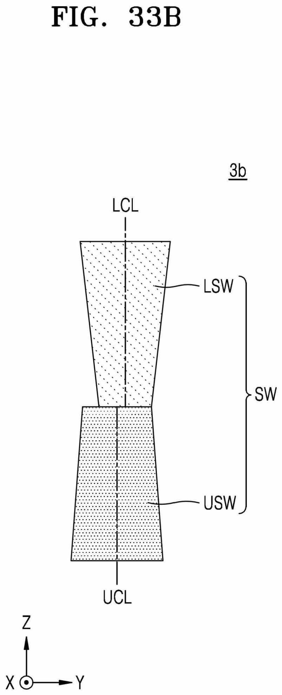

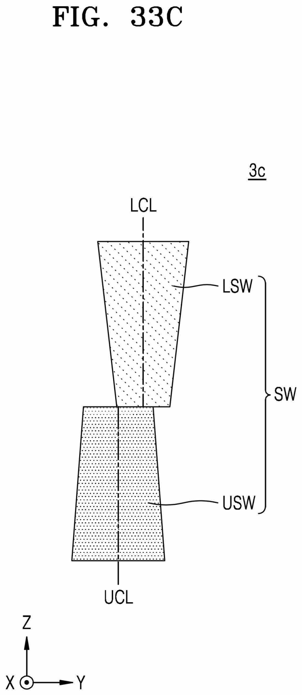

FIGS. 33A, 33B, and 33C are vertical cross-sectional views illustrating an example of a sheet separation wall SW included in integrated circuit devices 3a, 3b, and 3c according to some implementations.

In FIG. 33A, the integrated circuit device 3a includes the sheet separation wall SW including the lower sheet separation wall LSW and the upper sheet separation wall USW corresponding to each other. The sheet separation wall SW is substantially the same as the sheet separation wall SW shown in FIG. 31B, and thus a redundant description thereof will be omitted. The center line LCL of the lower sheet separation wall LSW and the center line UCL of the upper sheet separation wall USW may coincide with each other in the second horizontal direction (Y direction). One end of the lower sheet separation wall LSW may cover a part of one end of the upper sheet separation wall USW, and one end of the upper sheet separation wall USW may cover completely one end of the lower sheet separation wall LSW.

In FIG. 33B, the integrated circuit device 3b includes the sheet separation wall SW including the lower sheet separation wall LSW and the upper sheet separation wall USW corresponding to each other. The sheet separation wall SW is substantially the same as the sheet separation wall SW shown in FIG. 31B, and thus a redundant description thereof will be omitted. The center line LCL of the lower sheet separation wall LSW and the center line UCL of the upper sheet separation wall USW may be shifted in the second horizontal direction (Y direction). One end of the lower sheet separation wall LSW may cover a part of one end of the upper sheet separation wall USW, and one end of the upper sheet separation wall USW may cover completely one end of the lower sheet separation wall LSW.

In FIG. 33C, the integrated circuit device 3c includes the sheet separation wall SW including the lower sheet separation wall LSW and the upper sheet separation wall USW corresponding to each other. The sheet separation wall SW is substantially the same as the sheet separation wall SW shown in FIG. 31B, and thus a redundant description thereof will be omitted. The center line LCL of the lower sheet separation wall LSW and the center line UCL of the upper sheet separation wall USW may be shifted in the second horizontal direction (Y direction). The lower sheet separation wall LSW and the upper sheet separation wall USW included in the sheet separation wall SW may partially cover ends facing each other.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. An integrated circuit device (100) comprising:
an upper sheet separation wall (USW) extending in a first horizontal direction (X) and a vertical direction (Z);
a pair of nanosheet stack structures (NSS) having the upper sheet separation wall (USW) therebetween, wherein a first nanosheet stack structure of the pair of nanosheet stack structures (NSS) is spaced apart from a second nanosheet stack structure of the pair of nanosheet stack structures (NSS) in a second horizontal direction (Y) that is different from the first horizontal direction (Y), and each of the first nanosheet stack structure and the second nanosheet stack structure comprises a plurality of nanosheets (N1, N2, N3, N4);
a pair of gate electrodes (GL) extending in the second horizontal direction (Y) on the pair of nanosheet stack structures (NSS);
a plurality of source/drain regions (SD) connected to ends of the plurality of nanosheets (N1, N2, N3, N4) included in the pair of nanosheet stack structures (NSS);
a pair of backside via contacts (BCA) adjacent to each other in the second horizontal direction (Y) and connected to a pair of source/drain regions (SD) of the plurality of source/drain regions (SD);
a pair of backside wiring lines (BPL) connected to ends of the pair of backside via contacts (BCA); and
a lower sheet separation wall (LSW) between the pair of backside via contacts (BCA) adjacent to the pair of backside wiring lines (BPL), the lower sheet separation wall (LSW) extending in each of the first horizontal direction (X) and the vertical direction (Z), and contacting the upper sheet separation wall (USW).

2. The integrated circuit device (100) of claim 1,
wherein the upper sheet separation wall (USW) and the lower sheet separation wall (LSW) overlap in the vertical direction (Z), and
wherein the upper sheet separation wall (USW) and the lower sheet separation wall (LSW) contact each other.

3. The integrated circuit device (100) of claim 1 or claim 2,
wherein the upper sheet separation wall (USW) has a tapered shape with a horizontal width that narrows in the second horizontal direction (Y) from a first end of the upper sheet separation wall (USW) to a second end of the upper sheet separation wall (USW),
wherein the lower sheet separation wall (LSW) has a tapered shaped with a horizontal width that increases in the second horizontal direction (Y) from a first end of the lower sheet separation wall (LSW) to a second end of the lower sheet separation wall (LSW), and
wherein the second end of the upper sheet separation wall (USW) faces the first end of the lower sheet separation wall (LSW).

4. The integrated circuit device (100) of claim 3,
wherein, in the second horizontal direction (Y), the horizontal width of the second end of the upper sheet separation wall (USW) and the horizontal width of the first end of the lower sheet separation wall (LSW) are the same, and
wherein, in the second horizontal direction (Y), the horizontal width of the second end of the lower sheet separation wall (LSW) is greater than a horizontal width of the second end of the upper sheet separation wall (USW).

5. The integrated circuit device (100) of claim 3,
wherein, in the second horizontal direction (Y), the horizontal width of the first end of the upper sheet separation wall (USW) is greater than the horizontal width of the first end of the lower sheet separation wall (LSW), and
wherein, in the second horizontal direction (Y), the horizontal width of the first end of the upper sheet separation wall (USW) is the same as the horizontal width of the second end of the lower sheet separation wall (LSW).

6. The integrated circuit device (100) of any of claims 3-5, wherein the second end of the lower sheet separation wall (LSW) is at a same vertical level as a first end of the pair of backside wiring lines (BPL).

7. The integrated circuit device (100) of any preceding claim, wherein a first end of the upper sheet separation wall (USW) is at a same vertical level as a first end of the pair of gate electrodes (GL).

8. The integrated circuit device (100) of any preceding claim,
wherein the upper sheet separation wall (USW) extends in the first horizontal direction (X) and in the vertical direction (Z) between the pair of nanosheet stack structures (NSS) adjacent to each other in the second horizontal direction (Y),
wherein the upper sheet separation wall (USW) extends between the pair of source/drain regions (SD) adjacent to each other in the second horizontal direction (Y), and
wherein the upper sheet separation wall (USW) extends between the pair of backside via contacts (BCA) adjacent to each other in the second horizontal direction (Y).

9. The integrated circuit device (100) of any preceding claim, wherein a portion of the upper sheet separation wall (USW) and a portion of the lower sheet separation wall (LSW) are disposed between and contact the pair of backside via contacts (BCA) adjacent to each other in the second horizontal direction (Y).

10. The integrated circuit device (100) of any preceding claim, wherein a height (H2) of the lower sheet separation wall (LSW) is greater than a height (H1) of the upper sheet separation wall (USW) in the vertical direction (Z).

11. The integrated circuit device (100) of any preceding claim, comprising:
a plurality of the nanosheet stack structures (NSS) disposed in rows in the first horizontal direction (X) and in columns in the second horizontal direction (Y) that is different from the first horizontal direction (X), wherein each nanosheet stack structure (NSS) of the plurality of nanosheet stack structures comprises a respective plurality of the nanosheets (N1, N2, N3, N4);
a plurality of source/drain regions (SD) connected to ends of the plurality of nanosheets included in each nanosheet stack structure (NSS) of the plurality of nanosheet stack structures (NSS);
a plurality of the gate electrodes (GL) on the plurality of nanosheet stack structures (NSS), wherein the plurality of gate electrodes (GL) extend in the second horizontal direction (Y) and spaced apart from each other in the first horizontal direction (X);
a plurality of upper sheet separation walls (USW), each upper sheet separation wall (USW) of the plurality of upper sheet separation walls (USW) extending in the first horizontal direction (X) and the vertical direction (Z) between adjacent nanosheet stack structures (NSS) and between adjacent source/drain regions (SD), wherein the plurality of upper sheet separation walls (USW) are spaced apart from each other in the second horizontal direction (Y);
a plurality of the backside via contacts (BCA), each backside via contact (BCA) of the plurality of backside via contacts (BCA) being connected to two or more source/drain regions (SD) of the plurality of source/drain regions (SD);
a plurality of the backside wiring lines (BPL), each backside wiring line (BPL) of the plurality of backside wiring lines (BPL) being connected to ends of respective backside via contacts (BCA) of the plurality of backside via contacts (BCA); and
a plurality of lower sheet separation walls (LSW), each lower sheet separation wall (LSW) of the plurality of lower sheet separation walls (LSW) extending in the first horizontal direction (X) and the vertical direction (Z) between a pair of adjacent backside via contacts (BCA) of the plurality of backside via contacts (BCA) and between a pair of adjacent backside wiring lines (BPL) of the plurality of backside wiring lines (BPL), wherein the plurality of lower sheet separation walls (LSW) overlap the plurality of upper sheet separation walls (USW) in the vertical direction (Z), and contact the plurality of upper sheet separation walls (USW).

12. The integrated circuit device (100) of claim 11,
wherein the plurality of upper sheet separation walls (USW) have a tapered shape with a horizontal width that narrows in the second horizontal direction (Y) from first ends of the plurality of upper sheet separation walls (USW) to second ends of the plurality of upper sheet separation walls (USW), and
wherein the plurality of lower sheet separation walls (LSW) have a tapered shape with a horizontal width that increases in the second horizontal direction (Y) from first ends of the plurality of lower sheet separation walls (LSW) to second ends of the plurality of lower sheet separation walls (LSW).

13. The integrated circuit device (100) of claim 12, wherein the first ends of the plurality of upper sheet separation walls (USW) are at the same vertical levels as ends of the plurality of gate electrodes (GL).

14. The integrated circuit device (100) of any of claims 11-13, wherein the plurality of lower sheet separation walls (LSW) have a tapered shape with a horizontal width that narrows in the second horizontal direction (Y) from first ends of the plurality of lower sheet separation walls (LSW) to second ends of the plurality of lower sheet separation walls (LSW).

15. The integrated circuit device (100) of any of claims 11-14, wherein heights of the plurality of lower sheet separation walls (LSW) are greater than heights of the plurality of upper sheet separation walls (USW) in the vertical direction (Z).
